# EUROPEAN PATENT APPLICATION

(11) **EP 4 697 687 A1**
(43) Date of publication of application: **18.02.2026**
(21) Application number: 24914887.5
(22) Date of filing: 12.09.2024
(51) Int. Cl.: H04M 1/02, G09F 9/30, F16C 11/04

(54) **ELECTRONIC DEVICE**

(30) Priority: 03.01.2024 CN 202410025001
(71) Applicant: Huawei Technologies Co., Ltd., Shenzhen, Guangdong 518129 (CN)
(72) Inventor: ZHONG, Ding, Shenzhen, Guangdong 518129 (CN); LIU, Yong, Shenzhen, Guangdong 518129 (CN); FAN, Wen, Shenzhen, Guangdong 518129 (CN); HUANG, Bo, Shenzhen, Guangdong 518129 (CN); ZHAN, Qiang, Shenzhen, Guangdong 518129 (CN); WU, Weifeng, Shenzhen, Guangdong 518129 (CN)
(74) Representative: Huawei European IPR
(86) International application number: PCT/CN2024/118634
(87) International publication number: WO 2025/145665

(57) **Abstract**

An electronic device is disclosed. The electronic device includes a first housing (3), a second housing (4), a third housing (5), a first hinge mechanism (1), and a second hinge mechanism (2). The first housing (3) is rotatably connected to the second housing (4) through the first hinge mechanism (1), and the second housing (4) is rotatably connected to the third housing (5) through the second hinge mechanism (2). When the electronic device is used, the first housing (3) and the second housing (4) are rotatable toward or away from each other under action of the first hinge mechanism (1), and the second housing (4) and the third housing (5) are rotatable toward or away from each other under action of the second hinge mechanism (2), so that the electronic device can be folded and unfolded based on different usage scenarios. In addition, in a folding process of the electronic device, the first hinge mechanism (1) may limit movement distances of the first housing (3) and the second housing (4) relative to a main shaft (102), and the second hinge mechanism (2) may form display accommodation space that meets bending requirements of a flexible display (6). This helps reduce pulling or squeezing on the flexible display (6), thereby enhancing structural reliability of the electronic device.

## Description

### CROSS-REFERENCE TO RELATED APPLICATIONS

This application claims priority to Chinese Patent Application No. 202410025001.5, field with the China National Intellectual Property Administration on January 3, 2024 and entitled "ELECTRONIC DEVICE", which is incorporated herein by reference in its entirety.

### TECHNICAL FIELD

This application relates to the field of foldable electronic device technologies, and in particular, to an electronic device.

### BACKGROUND

With gradual maturation of flexible display technologies, the ways in which electronic devices display information have changed greatly. Foldable mobile phones with flexible displays, foldable tablet computers with flexible displays, foldable wearable electronic devices with flexible displays, and the like are an important direction in the evolution of future intelligent electronic devices. To meet users' requirements for large display screens and portability in foldable electronic devices, foldable devices in a trifold form are gradually being used in people's daily life.

As a key component enabling foldable electronic devices to fold and unfold, a hinge mechanism may drive a flexible display of the electronic device to unfold or bend in processes of unfolding and folding the electronic device. A trifold electronic device typically includes three housings disposed side by side, with adjacent housings rotatably connected to each other through a hinge mechanism that allows the device to switch among different folding forms. In addition, a flexible display of the trifold electronic device continuously covers the three housings. In processes of unfolding and folding the trifold electronic device, the hinge mechanism may drive the flexible display to unfold or bend. Because the flexible display of the trifold electronic device has a greater size and more folding positions, the trifold electronic device has a higher requirement for reliability.

In view of this, there is an urgent need for a solution about how to design a hinge mechanism in the trifold electronic device to ensure structural reliability of the flexible display in the folding process for persons skilled in the art.

### SUMMARY

This application provides an electronic device, to reduce risks of damage to a flexible display and improve structural reliability of the electronic device.

This application provides an electronic device. The electronic device includes a first housing, a second housing, a third housing, a first hinge mechanism, and a second hinge mechanism. The first housing is rotatably connected to the second housing through the first hinge mechanism, and the second housing is rotatably connected to the third housing through the second hinge mechanism. The first hinge mechanism is disposed opposite to a bendable part of a flexible display of the electronic device. When the first hinge mechanism is specifically disposed, the first hinge mechanism may include a first housing fastening bracket, a second housing fastening bracket, a main shaft, and a first rotating module. The first housing fastening bracket and the second housing fastening bracket are respectively disposed on two opposite sides of the main shaft. The first housing fastening bracket is fastened to the first housing, and the second housing fastening bracket is fastened to the second housing. The first rotating module includes a first rotating assembly and a second rotating assembly. The first rotating assembly is located between the first housing fastening bracket and the second housing fastening bracket, and the second rotating assembly is located between the first housing fastening bracket and the second housing fastening bracket. The first rotating assembly may include a first swing arm, a first support arm, and a first connector, the first swing arm is rotatably connected to the main shaft, the first swing arm is slidably connected to the first housing fastening bracket, the first support arm is rotatably connected to the second housing fastening bracket, the first connector is located between the first swing arm and the first support arm, the first connector is rotatably connected to the first swing arm, and the first connector is rotatably connected to the first support arm. In addition, the main shaft is provided with a first track slot, and the first connector is movable along the first track slot to limit a movement track of the first connector, so that a track along which the first swing arm pulls, through the first connector, the first support arm to move may be limited. The second rotating assembly may include a second swing arm, a second support arm, and a second connector, the second swing arm is rotatably connected to the main shaft, the second swing arm is slidably connected to the second housing fastening bracket, the second support arm is rotatably connected to the first housing fastening bracket, the second connector is located between the second swing arm and the second support arm, the second connector is rotatably connected to the second swing arm, and the second connector is rotatably connected to the second support arm. In addition, the main shaft is further provided with a second track slot, and the second connector is moveable along the second track slot to limit a movement track of the second connector, so that a track along which the second swing arm pulls, through the second connector, the second support arm to move may be limited.

Based on the foregoing hinge mechanism in this application, in a process in which the electronic device rotates from an unfolded state to a folded state, the first housing fastening bracket and the second housing fastening bracket move toward each other. When the first housing fastening bracket drives the first swing arm to rotate around the main shaft clockwise, the first swing arm may drive the first connector to move toward the first swing arm in the first track slot of the main shaft, to drive the first support arm to rotate around the main shaft counterclockwise. When the second housing fastening bracket drives the second swing arm to rotate around the main shaft counterclockwise, the second swing arm may drive the second connector to move toward the second swing arm in the second track slot of the main shaft, to drive the second support arm to rotate around the main shaft clockwise. In a process in which the electronic device rotates from the folded state to the unfolded state, the first housing fastening bracket and the second housing fastening bracket move away from each other. When the first housing fastening bracket drives the first swing arm to rotate around the main shaft counterclockwise, the first swing arm may drive the first connector to move toward the first support arm in the first track slot of the main shaft, to drive the first support arm to rotate around the main shaft clockwise. When the second housing fastening bracket drives the second swing arm to rotate around the main shaft clockwise, the second swing arm may drive the second connector to move toward the second support arm in the second track slot of the main shaft, to drive the second support arm to rotate around the main shaft counterclockwise. In this way, folding and unfolding functions of the hinge mechanism may be implemented.

For some existing hinge mechanisms, to ensure stability of the mechanisms, a thickness of a rotating assembly connected to the main shaft needs to be increased. In this way, both the main shaft and the hinge mechanism are very heavy. Forced thinning is likely to diminish strength of the rotating assembly, thereby greatly affecting reliability of the hinge mechanisms and shortening a service life of the electronic device. The foregoing first hinge mechanism in this application has a simplified structure. Based on the foregoing structural relationship, the first connector and the second connector slide in the main shaft to link the first swing arm, the second swing arm, the first support arm, and the second support arm on the left and right sides. Therefore, the first connector and the second connector do not need to be made with very thick cross sections to travel back and forth in the first track slot and the second track slot of the main shaft. In addition, because the first connector and the second connector respectively have connection relationships with the first swing arm (the second swing arm) and the first support arm (the second support arm), the first connector (the second connector) has a sufficient length extension in a direction perpendicular to an axial direction to have sufficient strength. This can ensure reliability of the hinge mechanism. In this way, not only can a thickness of the main shaft and a thickness of the entire electronic device be reduced, but also reliability of the hinge mechanism can be maintained, so that the entire hinge mechanism is light, thin, and reliable.

In addition, because the first connector is movable in the first track slot based on a specified track, and the second connector is movable in the second track slot based on a specified track, uncontrolled movement of the first connector and the second connector in an entire folding and unfolding process can be avoided, and random movement of the first housing fastening bracket and the second housing fastening bracket can also be avoided, to ensure structural stability and movement stability of the entire hinge mechanism. In some cases, the first track slot and the second track slot are properly designed, so that an outer tangent line of the hinge mechanism can keep a constant length in the entire folding and unfolding process, and the flexible display covering a surface of the hinge mechanism can also basically keep a length unchanged. In this way, squeezing or pulling on the flexible display can be effectively avoided, to improve structural reliability of the flexible display and further improve structural reliability of the electronic device.

In a possible implementation of this application, the main shaft includes a first base and a first cover plate, the first cover plate covers the first base, the first base is provided with a first arc-shaped groove, and the first cover plate includes a first protrusion facing the first arc-shaped groove. In this case, a gap between a surface of the first protrusion and a groove surface of the first arc-shaped groove may be used as the first track slot. In addition, the first connector may include a first arc-shaped surface and a second arc-shaped surface, and when the first housing and the second housing are in an unfolded state and a folded state, the first arc-shaped surface abuts against the surface of the first protrusion, and the second arc-shaped surface abuts against the groove surface of the first arc-shaped groove. In this way, the surface of the first protrusion and the groove surface of the first arc-shaped groove limit the first connector to the first track slot, so that when the first hinge mechanism is in the unfolded state and the folded state, a position of the first connector is stable, and no virtual position shake is generated, to improve reliability of the first hinge mechanism in the foregoing two states.

In addition, the first base may further be provided with a third arc-shaped groove, and the first cover plate further includes a third protrusion facing the third arc-shaped groove. A gap between a surface of the third protrusion and a groove surface of the third arc-shaped groove serves as the second track slot, the second connector includes a third arc-shaped surface and a fourth arc-shaped surface, and when the first housing and the second housing are in the unfolded state and the folded state, the third arc-shaped surface abuts against the surface of the third protrusion, and the fourth arc-shaped surface abuts against the groove surface of the third arc-shaped groove. In this way, the surface of the third protrusion and the groove surface of the third arc-shaped groove limit the second connector in the second track slot, so that when the first hinge mechanism is in the unfolded state and the folded state, a position of the second connector is stable, and no virtual position shake is generated, to improve reliability of the first hinge mechanism in the foregoing two states.

In a possible implementation of this application, during transition of the first housing and the second housing from the unfolded state to the folded state, the first arc-shaped surface abuts against the surface of the first protrusion, and there is a gap between the second arc-shaped surface and the groove surface of the first arc-shaped groove. However, during transition of the first housing and the second housing from the folded state to the unfolded state, the second arc-shaped surface abuts against the groove surface of the first arc-shaped groove, and there is a gap between the first arc-shaped surface and the surface of the first protrusion. Therefore, a movement track of the first connector in the first track slot during the transition of the first housing and the second housing from the unfolded state to the folded state is different from a movement track of the first connector in the first track slot during the transition of the first housing and the second housing from the folded state to the unfolded state. This helps improve flexibility of a design of the first hinge mechanism.

In addition, during the transition of the first housing and the second housing from the unfolded state to the folded state, the third arc-shaped surface abuts against the surface of the third protrusion, and there is a gap between the fourth arc-shaped surface and the groove surface of the third arc-shaped groove. However, during the transition of the first housing and the second housing from the folded state to the unfolded state, the fourth arc-shaped surface abuts against the groove surface of the third arc-shaped groove, and there is a gap between the third arc-shaped surface and the surface of the third protrusion. Therefore, a movement track of the second connector in the second track slot during the transition of the first housing and the second housing from the unfolded state to the folded state is different from a movement track of the second connector in the second track slot during the transition of the first housing and the second housing from the folded state to the unfolded state. This helps improve flexibility of a design of the first hinge mechanism.

In this application, the movement track of the first connector in the first track slot during the transition of the first housing and the second housing from the unfolded state to the folded state may alternatively be the same as the movement track of the first connector in the first track slot during the transition of the first housing and the second housing from the folded state to the unfolded state. Specifically, the surface of the first protrusion is equidistant from the groove surface of the first arc-shaped groove. In this case, the first track slot is an equal-width slot. During the transition of the first housing and the second housing from the unfolded state to the folded state and during the transition of the first housing and the second housing from the folded state to the unfolded state, the first arc-shaped surface abuts against the surface of the first protrusion, and the second arc-shaped surface abuts against the groove surface of the first arc-shaped groove. This can help improve movement stability of the first connector in the first track slot. Similarly, the surface of the third protrusion may be alternatively equidistant from the groove surface of the third arc-shaped groove, so that the second track slot is an equal-width slot. In addition, during the transition of the first housing and the second housing from the unfolded state to the folded state and during the transition of the first housing and the second housing from the folded state to the unfolded state, the third arc-shaped surface abuts against the surface of the third protrusion, and the fourth arc-shaped surface abuts against the groove surface of the third arc-shaped groove. In this way, a movement track of the second connector in the second track slot during the transition of the first housing and the second housing from the unfolded state to the folded state is the same as a movement track of the second connector in the second track slot during the transition of the first housing and the second housing from the folded state to the unfolded state. Therefore, movement stability of the second connector in the second track slot is improved.

In a possible implementation of this application, the first arc-shaped surface of the first connector may be a circular arc-shaped surface, and the second arc-shaped surface may also be a circular arc-shaped surface. In this case, a sum of a radius of the first arc-shaped surface and a radius of the second arc-shaped surface may be equal to a spacing between the surface of the first protrusion and the groove surface of the first arc-shaped groove, to improve movement smoothness of the first connector in the first track slot.

Similarly, the third arc-shaped surface of the second connector may be a circular arc-shaped surface, and the fourth arc-shaped surface may also be a circular arc-shaped surface. In this case, a sum of a radius of the third arc-shaped surface and a radius of the fourth arc-shaped surface may be equal to a spacing between the surface of the third protrusion and the groove surface of the third arc-shaped groove, to improve movement smoothness of the second connector in the second track slot.

In this application, the first swing arm is rotatably connected to the main shaft. The first base is provided with a second arc-shaped groove, the first swing arm includes a first arc-shaped rotating block, the first arc-shaped rotating block is accommodated in the second arc-shaped groove, and the first arc-shaped rotating block is slidable along a groove surface of the second arc-shaped groove, to implement a rotational connection between the first swing arm and the main shaft. Therefore, the first swing arm is rotatably connected to the main shaft through a virtual shaft. This helps reduce space occupied by the first swing arm on the main shaft, to help implement a miniaturized design of the first hinge mechanism.

In addition, the second swing arm is also rotatably connected to the main shaft, the first base is further provided with a fourth arc-shaped groove, the second swing arm includes a second arc-shaped rotating block, the second arc-shaped rotating block is accommodated in the fourth arc-shaped groove, and the second arc-shaped rotating block is slidable along the groove surface of the fourth arc-shaped groove to implement a rotational connection between the second swing arm and the main shaft. Therefore, the second swing arm is rotatably connected to the main shaft through a virtual shaft. This helps reduce space occupied by the second swing arm on the main shaft, to help implement a miniaturized design of the first hinge mechanism.

It may be understood that, in this application, the first housing is connected to the second housing in an outward-foldable manner. When the first swing arm is rotatably connected to the main shaft through a virtual shaft or a solid shaft, an axis center of rotation of the first swing arm around the main shaft is located on a side that is of the main shaft and that is away from the flexible display. In addition, when the second swing arm is rotatably connected to the main shaft through a virtual shaft or a solid shaft, an axis center of rotation of the second swing arm around the main shaft is located on the side that is of the main shaft and that is away from the flexible display.

To improve reliability of the connection between the first swing arm and the main shaft, in this application, the first cover plate further includes a second protrusion facing the second arc-shaped groove, and at least a part of the first arc-shaped rotating block is located between the second protrusion and the second arc-shaped groove, so that the first swing arm is limited to the main shaft through the second protrusion and the second arc-shaped groove. This can avoid detachment of the first swing arm from the second arc-shaped groove.

In addition, the first cover plate further includes a fourth protrusion facing the fourth arc-shaped groove, and at least a part of the second arc-shaped rotating block is located between the fourth protrusion and the fourth arc-shaped groove, so that the second swing arm is limited to the main shaft through the fourth protrusion and the fourth arc-shaped groove. This can avoid detachment of the second swing arm from the fourth arc-shaped groove.

In a possible implementation of this application, the first connector includes a first rotating shaft and a second rotating shaft, the first connector is rotatably connected to the first swing arm through the first rotating shaft, the first connector is rotatably connected to the first support arm through the second rotating shaft, and an axis of the first rotating shaft is parallel to and does not coincide with an axis of the second rotating shaft, so that the first swing arm and the first support arm can be mutually pulled to move through the first connector.

The second connector includes a third rotating shaft and a fourth rotating shaft, the second connector is rotatably connected to the second swing arm through the third rotating shaft, the second connector is rotatably connected to the second support arm through the fourth rotating shaft, and an axis of the third rotating shaft is parallel to and does not coincide with an axis of the fourth rotating shaft, so that the second swing arm and the second support arm can be mutually pulled to move through the second connector.

Specifically, when the first swing arm is rotatably connected to the first connector through the first rotating shaft, the first arc-shaped rotating block may be provided with a first mounting slot, and a slot opening of the first mounting slot is provided facing the second arc-shaped groove. The first rotating shaft is mounted in the first mounting slot, a part of a surface of the first rotating shaft is in contact with a slot surface of the first mounting slot, and a part of the surface of the first rotating shaft is in contact with the groove surface of the second arc-shaped groove. The first rotating shaft is mounted in the open first mounting slot of the first arc-shaped rotating block to be in contact with the groove surface of the second arc-shaped groove, so that a size of the first arc-shaped rotating block can be effectively reduced, and a thickness of the first mounting slot does not need to be increased due to a size of the first rotating shaft. This helps implement a miniaturized design of the first hinge mechanism.

In addition, the slot surface of the first mounting slot includes a first circular arc-shaped surface, the surface that is of the first rotating shaft and that is in contact with the slot surface of the first mounting slot is a second circular arc-shaped surface, and a circle center of the first circular arc-shaped surface coincides with a circle center of the second circular arc-shaped surface. In this way, the first rotating shaft rotates relative to the first arc-shaped rotating block in a process in which the first arc-shaped rotating block slides along the groove surface of the second arc-shaped groove, to implement a rotational connection between the first swing arm and the first rotating shaft.

The groove surface of the second arc-shaped groove is a third circular arc-shaped surface, the surface that is of the first rotating shaft and that is in contact with the groove surface of the second arc-shaped groove is a fourth circular arc-shaped surface, and a circle center of the third circular arc-shaped surface coincides with a circle center of the fourth circular arc-shaped surface. In this way, when the first rotating shaft slides along the groove surface of the second arc-shaped groove with the first arc-shaped rotating block, the first rotating shaft may further rotate relative to the first arc-shaped rotating block and the second arc-shaped groove, to help implement movement of the first connector relative to the main shaft.

Similarly, the second arc-shaped rotating block is provided with a second mounting slot, a slot opening of the second mounting slot is provided facing the fourth arc-shaped groove, the third rotating shaft is mounted in the open second mounting slot to be in contact with the groove surface of the fourth arc-shaped groove, a part of a surface of the third rotating shaft is in contact with a slot surface of the second mounting slot, and a part of the surface of the third rotating shaft is in contact with the groove surface of the fourth arc-shaped groove. The third rotating shaft is mounted in the second mounting slot of the second arc-shaped rotating block, so that a size of the second arc-shaped rotating block can be effectively reduced, and a thickness of the second mounting slot does not need to be increased due to a size of the third rotating shaft. This helps implement a miniaturized design of the first hinge mechanism.

The second mounting slot may include a fifth circular arc-shaped surface, the surface that is of the third rotating shaft and that is in contact with the slot surface of the second mounting slot is a sixth circular arc-shaped surface, and a circle center of the fifth circular arc-shaped surface coincides with a circle center of the sixth circular arc-shaped surface. In addition, the groove surface of the fourth arc-shaped groove is a seventh circular arc-shaped surface, and the surface that is of the third rotating shaft and that is in contact with the groove surface of the fourth arc-shaped groove may be an eighth circular arc-shaped surface. In this case, a circle center of the seventh circular arc-shaped surface coincides with a circle center of the eighth circular arc-shaped surface. In this way, when the third rotating shaft slides along the groove surface of the fourth arc-shaped groove with the second arc-shaped rotating block, the third rotating shaft may further rotate relative to the second arc-shaped rotating block and the fourth arc-shaped groove, to help implement movement of the second connector relative to the main shaft.

In a possible implementation of this application, the first connector may include a plurality of first sub-connectors that are sequentially rotatably connected to each other. In addition, the plurality of first sub-connectors may be located between the first swing arm and the first support arm, the first swing arm may be rotatably connected to an adjacent first sub-connector, and the first support arm may be rotatably connected to an adjacent first sub-connector. The first swing arm and the first support arm are connected to each other through the plurality of first sub-connectors. This can effectively improve speed uniformity in a process in which the first swing arm and the first support arm rotate around the main shaft, to improve smoothness of mutual pulling movement of the first swing arm and the first support arm.

In addition, the second connector may include a plurality of second sub-connectors that are sequentially rotatably connected to each other. The plurality of second sub-connectors may be located between the second swing arm and the second support arm, the second swing arm may be rotatably connected to an adjacent second sub-connector, and the second support arm may be rotatably connected to an adjacent second sub-connector. The second swing arm and the second support arm are connected to each other through the plurality of second sub-connectors. This can effectively improve speed uniformity in a process in which the second swing arm and the second support arm rotate around the main shaft, to improve smoothness of mutual pulling movement of the second swing arm and the second support arm.

In a possible implementation of this application, the first hinge mechanism further includes a first synchronization assembly, the first synchronization assembly includes a first gear connecting rod and a second gear connecting rod, the first gear connecting rod includes a first gear and a first connecting rod, the first gear is rotatably connected to the main shaft, and the first connecting rod is slidably connected to the first housing fastening bracket. The second gear connecting rod includes a second gear and a second connecting rod, the second gear is rotatably connected to the main shaft, the second connecting rod is slidably connected to the second housing fastening bracket, and the first gear is in a transmission connection to the second gear. In this way, during the transition of the first housing and the second housing from the unfolded state to the folded state or from the folded state to the unfolded state, the first housing fastening bracket and the second housing fastening bracket can synchronously move in opposite directions. This helps improve movement stability of the first hinge mechanism, and can effectively reduce a risk of instantaneous squeezing or pulling stress on the flexible display of the electronic device, to improve structural reliability of the flexible display.

In this application, the first gear may be rotatably connected to the main shaft through the fifth rotating shaft, and the second gear may be rotatably connected to the main shaft through the sixth rotating shaft, to improve stability of rotation of the first gear connecting rod and the second gear connecting rod around the main shaft.

In addition, to implement a slidable connection between the first connecting rod and the first housing fastening bracket, the first housing fastening bracket may be further provided with a third sliding slot, and the first connecting rod may be mounted in the third sliding slot, and may slide in the third sliding slot relative to the first housing fastening bracket in a direction toward or away from the base.

When the second connecting rod is slidably connected to the second housing fastening bracket, the second housing fastening bracket is further provided with a fourth sliding slot, and the second connecting rod is mounted in the fourth sliding slot, and may slide in the fourth sliding slot relative to the second housing fastening bracket in the direction toward or away from the base.

In a possible implementation of this application, the second hinge mechanism includes a second base and a second rotating module, the second rotating module may include a third rotating assembly and a fourth rotating assembly, and the third rotating assembly and the fourth rotating assembly are located on two opposite sides of the second base. The third rotating assembly includes a third support arm, a third swing arm, and a third housing fastening bracket. The fourth rotating assembly includes a fourth support arm, a fourth swing arm, and a fourth housing fastening bracket. The third support arm and the fourth support arm are respectively rotatably connected to the second base, and the third swing arm and the fourth swing arm are respectively rotatably connected to the base. A rotation axis of the third support arm is parallel to and does not coincide with a rotation axis of the third swing arm, and a rotation axis of the fourth support arm is parallel to and does not coincide with a rotation axis of the fourth swing arm. In addition, the third housing fastening bracket is fastened to the second housing. The third housing fastening bracket is provided with a fifth sliding slot extending in a first direction and a sixth sliding slot extending in a second direction. In this way, the third support arm may slide in the fifth sliding slot in the first direction, and the third swing arm may slide in the sixth sliding slot. In addition, a projection of the first direction in a first cross section is not parallel to a projection of the second direction in the first cross section. The first cross section is a reference plane perpendicular to the rotation axis of the third support arm and the rotation axis of the third swing arm. Similarly, the fourth housing fastening bracket is provided with a seventh sliding slot extending in a third direction and an eighth sliding slot extending in a fourth direction. In this way, the fourth support arm may slide in the seventh sliding slot, and the fourth swing arm may slide in the eighth sliding slot. In addition, a projection of the third direction in a second cross section is not parallel to a projection of the fourth direction in the second cross section. The second cross section is a reference plane perpendicular to the rotation axis of the fourth support arm and the rotation axis of the fourth swing arm.

In the second hinge mechanism provided in this application, the rotation axis of the third support arm does not coincide with the rotation axis of the third swing arm, and the rotation axis of the fourth support arm does not coincide with the rotation axis of the fourth swing arm, so that an axis center phase difference between a support arm and a swing arm that are disposed on a same side can be implemented in a rotation process of the second hinge mechanism, to implement telescopic motion of the two rotating assemblies. In this way, the second hinge mechanism can stably support the flexible display of the electronic device in the unfolded state, and water-drop-like display accommodation space can be formed to meet a bending requirement of the flexible display when the second hinge mechanism is in the folded state. In addition, in this application, providing directions of the fifth sliding slot and the sixth sliding slot of the third housing fastening bracket and providing directions of the seventh sliding slot and the eighth sliding slot of the fourth housing fastening bracket are properly designed, to reduce rotation angles of the third swing arm and the fourth swing arm relative to the second base. In this way, wall thickness designs of partial structures of the third swing arm and the fourth swing arm can meet strength requirements, so that structural reliability of the third swing arm and the fourth swing arm is improved. When the second hinge mechanism is used in the electronic device, a thinned design of a component in the electronic device can be effectively avoided, to avoid rotation of the third swing arm and the fourth swing arm. This can improve reliability of an overall structure of the electronic device, and can reduce a risk of squeezing the flexible display of the electronic device caused by rotation of the third swing arm and the fourth swing arm, reduce a risk of damaging the flexible display, and prolong a service life of the flexible display.

It can be learned from the foregoing description of a rotation principle of the second hinge mechanism provided in this application that, in this application, the providing directions of the fifth sliding slot and the sixth sliding slot of the third housing fastening bracket are properly designed, so that rotation angles of the third support arm and the third swing arm relative to the second base can be adjusted. For example, the rotation angles of the third support arm and the third swing arm relative to the second base may be not greater than 90°. Similarly, the providing directions of the seventh sliding slot and the eighth sliding slot of the second housing fastening bracket are properly designed, so that rotation angles of the fourth support arm and the fourth swing arm relative to the second base can be adjusted. For example, the rotation angles of the fourth support arm and the fourth swing arm relative to the second base may be not greater than 90°. In this way, enabling the rotation angles of the third swing arm and the fourth swing arm relative to the second base to be small can avoid a case in which another structure of the second hinge mechanism avoids rotation of the third swing arm and the fourth swing arm. This helps increase wall thicknesses of partial structures of the third swing arm and the fourth swing arm, so that structural reliability of the third swing arm and the fourth swing arm is improved.

In this application, the third swing arm and the fourth swing arm are rotatably connected to the second base in a plurality of manners. For example, a fifth arc-shaped groove and a sixth arc-shaped groove may be provided on the second base, and a third arc-shaped rotating block is disposed at an end that is of the third swing arm and that is configured to rotatably connect to the second base. The third arc-shaped rotating block may be accommodated in the fifth arc-shaped groove and may rotate along an arc-shaped surface of the fifth arc-shaped groove. In addition, a fourth arc-shaped block is disposed at an end that is of the fourth swing arm and that is configured to rotatably connect to the second base. The fourth arc-shaped rotating block may be accommodated in the sixth arc-shaped groove, and may rotate along an arc-shaped surface of the sixth arc-shaped groove. In this way, the arc-shaped rotating block may be accommodated in the corresponding arc-shaped groove, and the arc-shaped rotating block rotates along the arc-shaped surface of the arc-shaped groove, to rotatably connect the third swing arm and the fourth swing arm to the second base. Therefore, rotatably connecting the third swing arm and the fourth swing arm to the second base through a virtual shaft can effectively reduce space occupied by the third swing arm and the fourth swing arm on the second base. This helps implement a miniaturized design of the second hinge mechanism.

In a possible implementation of this application, a second sliding rail is disposed on the sixth sliding slot, a second sliding block is disposed on the third swing arm, the second sliding block is clamped in the second sliding rail, and the second sliding block is slidable along the second sliding rail. This can avoid detachment of the third swing arm from the third housing fastening bracket, and can guide sliding of the third swing arm through the second sliding rail, to improve reliability of sliding of the third swing arm along the third housing fastening bracket.

In addition, a fourth sliding rail is disposed on the eighth sliding slot, a fourth sliding block is disposed on the fourth swing arm, the fourth sliding block is clamped in the fourth sliding rail, and the fourth sliding block is slidable along the fourth sliding rail. This can avoid detachment of the fourth swing arm from the fourth housing fastening bracket, and can guide sliding of the fourth swing arm through the fourth sliding rail, to improve reliability of sliding of the fourth swing arm along the fourth housing fastening bracket.

In a possible implementation of this application, the third housing fastening bracket includes a first surface, and the first surface is a surface of a side that is of the third housing fastening bracket and that faces the flexible display of the electronic device. The second sliding block may be a straight-line sliding block. In this case, the second sliding rail may be adaptively disposed as a straight-line sliding rail. The straight-line sliding rail has an opening located on the first surface. In this case, when the second housing and the third housing are in the unfolded state, the straight-line sliding rail may extend from the opening in a direction toward the second base. This can improve smoothness of sliding of the second sliding block along the second sliding rail, and effectively reduce interference of another structure of the second hinge mechanism on movement of the third swing arm, thereby helping increase a wall thickness of the third swing arm. In another possible implementation of this application, the straight-line sliding rail may alternatively extend from the opening in a direction away from the second base. Alternatively, when the third housing fastening bracket further includes a second surface disposed opposite to the first surface, the straight-line sliding rail may alternatively extend from the opening in a direction perpendicular to the second surface. In this way, the second sliding rail is disposed flexibly.

In addition, the fourth housing fastening bracket includes a third surface, and the third surface is a surface of a side that is of the fourth housing fastening bracket and that faces the flexible display. The fourth sliding block may be a straight-line sliding block. In this case, the fourth sliding rail may be adaptively disposed as a straight-line sliding rail. The straight-line sliding rail has an opening located on the third surface. In this case, when the second housing and the third housing are in the unfolded state, the straight-line sliding rail may extend from the opening in the direction toward the second base. This can help improve smoothness of sliding of the fourth sliding block along the fourth sliding rail, and effectively reduce interference of another structure of the second hinge mechanism on movement of the fourth swing arm, thereby helping increase a wall thickness of the fourth swing arm. In another possible implementation of this application, the straight-line sliding rail may alternatively extend from the opening in the direction away from the second base. Alternatively, when the fourth housing fastening bracket further includes a fourth surface disposed opposite to the third surface, the straight-line sliding rail may alternatively extend from the opening in a direction perpendicular to the fourth surface. In this way, the fourth sliding rail is disposed flexibly.

In some possible implementations, the second sliding block may alternatively be disposed as an arc-shaped sliding block, and the second sliding rail is adaptively disposed as an arc-shaped sliding rail. This can reduce a risk of detaching the second sliding block from the second sliding rail, thereby helping improve reliability of cooperation between the second sliding block and the second sliding rail. In addition, the fourth sliding block may alternatively be disposed as an arc-shaped sliding block, and the fourth sliding rail is adaptively disposed as an arc-shaped sliding rail. This can reduce a risk of detaching the fourth sliding block from the fourth sliding rail, thereby helping improve reliability of cooperation between the fourth sliding block and the fourth sliding rail. It may be understood that the second sliding block herein may alternatively be in another shape that adapts to the arc-shaped sliding rail, for example, may be a sliding block in an overall arc-shaped form with a hollow and spacing design in a middle part, or may be a specially-shaped sliding block, as long as the sliding block can fit the arc-shaped sliding rail in shape for sliding.

In addition, when the second housing and the third housing are in the unfolded state, an axis center of the arc-shaped sliding rail may be located on a side that is of the arc-shaped sliding rail and that is away from the second base. This can help improve smoothness of sliding the second sliding block along the second sliding rail and improve smoothness of sliding the fourth sliding block along the fourth sliding rail, and effectively reduce interference of another structure of the second hinge mechanism on movement of the third swing arm and the fourth swing arm, thereby helping increase wall thicknesses of the third swing arm and the fourth swing arm. In another possible implementation of this application, alternatively, when the second housing and the third housing are in the unfolded state, an axis center of the arc-shaped sliding rail may be located on a side that is of the arc-shaped sliding rail and that faces the second base, so that the second sliding rail and the fourth sliding rail are more flexibly disposed.

In this application, the second rotating module may further include a first drive connecting rod and a second drive connecting rod. The first drive connecting rod is disposed between the third support arm and the third swing arm. The first drive connecting rod includes a first connecting part and a second connecting part, the first connecting part is rotatably connected to the third support arm through a third connecting rod, and the second connecting part is rotatably connected to the third swing arm through a fourth connecting rod. An axis of the third connecting rod does not coincide with an axis of the fourth connecting rod. In addition, the second drive connecting rod includes a third connecting part and a fourth connecting part, the third connecting part is rotatably connected to the fourth support arm through a fifth connecting rod, and the fourth connecting part is rotatably connected to the fourth swing arm through a sixth connecting rod. An axis of the fifth connecting rod does not coincide with an axis of the sixth connecting rod.

This can effectively improve a degree of combining the third support arm and the third swing arm with corresponding sliding slots, and a degree of combining the fourth support arm and the fourth swing arm with corresponding sliding slots, to improve movement consistency between the third support arm and the third swing arm, and movement consistency between the fourth support arm and the fourth swing arm, and move the third support arm and the third swing arm, and the fourth support arm and the fourth swing arm more smoothly. In addition, when the electronic device in which the second hinge mechanism is used falls off in the folded state, the third support arm and the third swing arm may jointly support a corresponding housing in the electronic device, and the fourth support arm and the fourth swing arm may jointly support a corresponding housing in the electronic device. This can avoid movement of the two housings relative to the second hinge mechanism, to improve reliability of the overall structure of the electronic device.

In addition to the foregoing manner in which the first drive connecting rod and the second drive connecting rod are disposed, in another possible implementation, the first drive connecting rod is located between the third support arm and the third swing arm, the first drive connecting rod includes a first connecting part and a second connecting part, the first connecting part is slidably connected to the third swing arm through a third connecting rod, and the second connecting part is fastened to the third support arm. In addition, the second drive connecting rod is located between the fourth support arm and the fourth swing arm, the second drive connecting rod includes a third connecting part and a fourth connecting part, the third connecting part is slidably connected to the fourth swing arm through a fifth connecting rod, and the fourth connecting part is fastened to the fourth support arm.

To implement a slidable connection between the third connecting rod and the third swing arm, a first guide slot may be provided on an end part that is of the third swing arm and that faces the third support arm, so that the third connecting rod may be inserted into the first guide slot and is slidable along a slot surface of the first guide slot. In addition, the first drive connecting rod and the third support arm may be of an integrally formed structure, to simplify a structure of the second rotating module. Similarly, to implement a slidable connection between the fifth connecting rod and the fourth swing arm, a second guide slot may be provided on an end part that is of the fourth swing arm and that faces the fourth support arm, so that the fifth connecting rod may be inserted into the second guide slot and is slidable along a slot surface of the second guide slot. In addition, the second drive connecting rod and the second support arm may be of an integrally formed structure, to simplify a structure of the second rotating module.

The first drive connecting rod and the second drive connecting rod are disposed in the manner provided in this implementation. The first guide slot and the second guide slot may be properly designed, to improve the degree of combining the third support arm and the third swing arm with corresponding sliding slots, and the degree of combining the fourth support arm and the fourth swing arm with corresponding sliding slots, so that the movement consistency between the third support arm and the third swing arm, and the movement consistency between the fourth support arm and the fourth swing arm are improved, and the third support arm and the third swing arm, and the fourth support arm and the fourth swing arm are moved more smoothly. In addition, when the electronic device in which the second hinge mechanism is used falls off in the folded state, the third support arm, the third swing arm, and the first drive connecting rod may jointly support a corresponding housing in the electronic device, and the fourth support arm, the fourth swing arm, and the second drive connecting rod may jointly support a corresponding housing in the electronic device. This can avoid large instantaneous displacements of the two housings relative to the second hinge mechanism, to improve reliability of the overall structure of the electronic device.

In a possible implementation of this application, the second hinge mechanism may further include a first support plate and a second support plate. The first support plate and the second support plate are respectively disposed on the two sides of the second base. The first support plate is rotatably connected to the third housing fastening bracket, and the first support plate is slidably connected to the third support arm and/or the third swing arm. The second support plate is rotatably connected to the fourth housing fastening bracket, and the second support plate is slidably connected to the fourth support arm and/or the fourth swing arm. In addition, when the third housing fastening bracket and the fourth housing fastening bracket rotate toward each other, an end that is of the first support plate and that is close to the second base moves in a direction away from the second base, and an end that is of the second support plate and that is close to the second base moves in the direction away from the second base, so that triangular display accommodation space can be formed among the two support plates and the second base. In this way, when the second hinge mechanism is used in the electronic device, and the electronic device is in the folded state, a bent part of the flexible display may be accommodated in the display accommodation space and present as a type of water drop form. This can avoid pulling or squeezing the flexible display, thereby reducing the risk of damaging the flexible display.

To implement rotation of a first support plate around the third housing fastening bracket, a first rotating slot may be provided on the third housing fastening bracket, and a first rotating part is disposed on the first support plate. In this way, the first rotating part may be mounted in the first rotating slot, and the first rotating part is rotatable along a slot surface of the first rotating slot. Similarly, to implement rotation of the second support plate around the fourth housing fastening bracket, a second rotating slot may be provided on the fourth housing fastening bracket, and a second rotating part may be disposed on the second support plate. In this way, the second rotating part may be mounted in the second rotating slot, and the second rotating part is rotatable along a slot surface of the second rotating slot.

It can be learned from the foregoing description of the second hinge mechanism that, when the two housing fastening brackets rotate toward each other, the two support plates rotate around the corresponding housing fastening brackets, so that the display accommodation space can be formed. To form, between the two support plates, the display accommodation space that meets bending requirements of the flexible display, movement tracks of the support plates may be properly designed. In a possible implementation of this application, a first guide part may be disposed on the first support plate, and a third track slot is provided on the first guide part. In addition, a first guide structure may be disposed on the third swing arm, and the first guide structure may be inserted into the third track slot and is slidable along the third track slot. In addition/Alternatively, the first guide structure is disposed on the third support arm, and the first guide structure is inserted into the third track slot and is slidable along the third track slot. Therefore, in a process in which the third swing arm and/or the third support arm rotate/rotates around the second base, the first support plate may be driven to rotate around the third housing fastening bracket, and the movement track of the first support plate is adjusted by sliding the first guide structure in the third track slot.

Similarly, a second guide part may be disposed on the second support plate, and a fourth track slot is provided on the second guide part. In addition, a second guide structure may be disposed on the fourth swing arm, and the second guide structure may be inserted into the fourth track slot and is slidable along the fourth track slot. In addition! Alternatively, the second guide structure is disposed on the fourth support arm, and the second guide structure is inserted into the fourth track slot and is slidable along the fourth track slot. Therefore, in a process in which the fourth swing arm and/or the fourth support arm rotate/rotates around the second base, the second support plate may be driven to rotate around the fourth housing fastening bracket, and the movement track of the second support plate is adjusted by sliding the second guide structure in the fourth track slot. Further, display accommodation space that meets a display accommodation requirement can be formed between the two support plates.

In a possible implementation of this application, the electronic device further includes the flexible display, the flexible display continuously covers the first housing, the first hinge mechanism, the second housing, the second hinge mechanism, and the third housing, and the flexible display is fastened to the first housing, the second housing, and the third housing. When the electronic device provided in this application is in the unfolded state, the first housing, the first hinge mechanism, the second housing, the second hinge mechanism, and the third housing may jointly support the flexible display flatly, so that integrity of a form of the electronic device in the unfolded state can be ensured, and light and shadow of the flexible display can be improved. In the process in which the electronic device rotates from the unfolded state to the folded state, the first housing and the second housing rotate toward each other to drive a part of the flexible display to rotate, and the second housing and the third housing rotate toward each other to drive another part of the flexible display to rotate. In addition, a misalignment trend of a stacking layer of the flexible display under action of the first housing and the second housing is consistent with a misalignment trend of the stacking layer of the flexible display under action of the second housing and the third housing. This helps balance an amount of misalignment of the stacking layer of the flexible display, thereby reducing a risk of failure of the flexible display due to misalignment of the stacking layer, prolonging a service life of the flexible display, and improving structural reliability of the entire electronic device.

### BRIEF DESCRIPTION OF DRAWINGS

FIG. 1 is a diagram of a structure of an electronic device in an unfolded state according to an embodiment of this application;
FIG. 2 is a simplified diagram of a cross-sectional view of the electronic device shown in FIG. 1 at A-A;
FIG. 3 is a diagram of a structure of the electronic device shown in FIG. 1 in a folded state;
FIG. 4 is a diagram of a structure of an electronic device in an intermediate state according to an embodiment of this application;
FIG. 5 is another diagram of a structure of an electronic device in an intermediate state according to an embodiment of this application;
FIG. 6 is another diagram of a structure of an electronic device in an intermediate state according to an embodiment of this application;
FIG. 7 is another diagram of a structure of an electronic device in an intermediate state according to an embodiment of this application;
FIG. 8 is a diagram of a connection relationship among a first housing, a second housing, and a first hinge mechanism according to an embodiment of this application;
FIG. 9 is a diagram of a partial structure of a first hinge mechanism according to an embodiment of this application;
FIG. 10 is an exploded view of the first hinge mechanism shown in FIG. 9;
FIG. 11 is a cross-sectional view of a first hinge mechanism at a first connector, presented when an electronic device is in an unfolded state according to an embodiment of this application;
FIG. 12 is a diagram of a structure of a main shaft according to an embodiment of this application;
FIG. 13 is a diagram of a structure of a first base of the main shaft shown in FIG. 12;
FIG. 14 is a diagram of a structure of a first cover plate of the main shaft shown in FIG. 12;
FIG. 15 is a cross-sectional view of a first hinge mechanism at a first connector, presented when an electronic device is in a folded state according to an embodiment of this application;
FIG. 16 is a diagram of a structure of a first connector according to an embodiment of this application;
FIG. 17 is a diagram of an assembled structure of a first connector and a main shaft according to an embodiment of this application;
FIG. 18 is a cross-sectional view of the structure shown in FIG. 9 at B-B;
FIG. 19 is a cross-sectional view of a first hinge mechanism at a first swing arm, presented when a first housing and a second housing are in a folded state according to an embodiment of this application;
FIG. 20 is a diagram of a structure of a first rotating assembly according to an embodiment of this application;
FIG. 21 is a diagram of a structure of a first swing arm according to an embodiment of this application;
FIG. 22 is a diagram of a principle of a movement mechanism of a first hinge mechanism according to an embodiment of this application;
FIG. 23 is a diagram of a partial structure of a first hinge mechanism according to an embodiment of this application;
FIG. 24 is a cross-sectional view of a first hinge mechanism at a synchronization assembly, presented when a first housing and a second housing are in an unfolded state according to an embodiment of this application;
FIG. 25 is a cross-sectional view of a first hinge mechanism at a synchronization assembly, presented when a first housing and a second housing are in a folded state according to an embodiment of this application;
FIG. 26 is a simplified diagram of another connection relationship among a first housing, a second housing, and a first hinge mechanism according to an embodiment of this application;
FIG. 27 is a diagram of a structure of the structure shown in FIG. 26 in a folded state;
FIG. 28 is a diagram of an exploded structure of a second hinge mechanism according to an embodiment of this application;
FIG. 29 is an exploded view of a partial structure of a second hinge mechanism according to an embodiment of this application;
FIG. 30 is a diagram of a partial structure of a second hinge mechanism according to an embodiment of this application;
FIG. 31 is a diagram of a structure of a third swing arm according to an embodiment of this application;
FIG. 32 is a diagram of a partial structure of a second hinge mechanism according to an embodiment of this application;
FIG. 33 is a diagram of a structure of a third housing fastening bracket according to an embodiment of this application;
FIG. 34a is a diagram of a structure of a second hinge mechanism in an unfolded state according to an embodiment of this application;
FIG. 34b is a diagram of a first cross section according to an embodiment of this application;
FIG. 34c is a diagram of a structure of a second housing and a third housing in an intermediate state according to an embodiment of this application;
FIG. 34d is a diagram of a structure of a second housing and a third housing in a folded state according to an embodiment of this application;
FIG. 35 is a diagram of a principle of a mechanism in which a third support arm and a third swing arm slide relative to a third housing fastening bracket according to an embodiment of this application;
FIG. 36 is a diagram of another structure of a third swing arm according to an embodiment of this application;
FIG. 37a is a diagram of a structure of a second housing and a third housing in an unfolded state according to an embodiment of this application;
FIG. 37b is another diagram of a first cross section according to an embodiment of this application;
FIG. 37c is another diagram of a first cross section according to an embodiment of this application;
FIG. 37d is another diagram of a first cross section according to an embodiment of this application;
FIG. 38 is a diagram of a structure of a second housing and a third housing in an intermediate state according to an embodiment of this application;
FIG. 39 is a diagram of a structure of a second housing and a third housing in a folded state according to an embodiment of this application;
FIG. 40a is a diagram of a connection structure of a third support arm and a third swing arm according to an embodiment of this application;
FIG. 40b is a diagram of a structure of a first drive connecting rod according to an embodiment of this application;
FIG. 40c is a diagram of a structure of a third support arm according to an embodiment of this application;
FIG. 41 is a cross-sectional view of the structure shown in FIG. 40a at C-C;
FIG. 42 is a cross-sectional view of the structure shown in FIG. 40a at D-D;
FIG. 43 is a diagram of another structure of a third swing arm according to an embodiment of this application;
FIG. 44a is a diagram of another connection structure of a third support arm and a third swing arm according to an embodiment of this application;
FIG. 44b is a diagram of another structure of a third swing arm according to an embodiment of this application;
FIG. 44c is a diagram of a structure in which a first drive connecting rod is connected to a third support arm according to an embodiment of this application;
FIG. 45 is a diagram of a structure of a first support plate according to an embodiment of this application;
FIG. 46 is a diagram of a structure in which a first support plate supports a flexible display according to an embodiment of this application;
FIG. 47 is a cross-sectional view of a second hinge mechanism according to an embodiment of this application;
FIG. 48 is a cross-sectional view of a second housing and a third housing in a folded state according to an embodiment of this application;
FIG. 49 is a diagram of another partial structure of a second hinge mechanism according to an embodiment of this application;
FIG. 50 is a cross-sectional view of the second hinge mechanism 2 shown in FIG. 49 at E-E;
FIG. 51 is a simplified diagram of a structure of an electronic device, presented when a second housing and a third housing are in an unfolded state according to an embodiment of this application;
FIG. 52 is a diagram of a structure of the structure shown in FIG. 51 in a folded state;
FIG. 53 is a simplified diagram of another connection relationship among a second housing, a third housing, and a second hinge mechanism according to an embodiment of this application;
FIG. 54 is a diagram of a structure of the structure shown in FIG. 53 in a folded state;
FIG. 55a is a simplified diagram of another cross-sectional view of the electronic device shown in FIG. 1 at A-A;
FIG. 55b is a diagram of a stacking layer structure of a flexible display of the electronic device shown in FIG. 55a;
FIG. 56a is a cross-sectional view of the electronic device shown in FIG. 3 at F-F;
FIG. 56b is a diagram of a stacking layer structure of a flexible display of the electronic device shown in FIG. 56a;
FIG. 57a is a cross-sectional view of the electronic device shown in FIG. 4 at G-G;
FIG. 57b is a diagram of a stacking layer structure of a flexible display of the electronic device shown in FIG. 57a;
FIG. 58a is a cross-sectional view of the electronic device shown in FIG. 5 at I-I;
FIG. 58b is a diagram of a stacking layer structure of a flexible display of the electronic device shown in FIG. 58a;
FIG. 59a is a cross-sectional view of the electronic device shown in FIG. 6 at J-J;
FIG. 59b is a diagram of a stacking layer structure of a flexible display of the electronic device shown in FIG. 59a;
FIG. 60a is a diagram of a stacking layer structure of a flexible display of an existing electronic device in a folded state; and
FIG. 60b is a diagram of another stacking layer structure of a flexible display of an existing electronic device in a folded state.

### Reference numerals:

1: first hinge mechanism; 1a: support surface of the first hinge mechanism; 101: first rotating module; 1011: first rotating assembly;
10111: first swing arm; 101111: first arc-shaped rotating block; 1011111: first recess; 1011112: first mounting slot;
10111121: first circular arc-shaped surface; 10112: first support arm; 10113: first connector; 101131: first rotating shaft;
1011311: second circular arc-shaped surface; 1011312: fourth circular arc-shaped surface; 101132: second rotating shaft; 101133: first arc-shaped surface;
101134: second arc-shaped surface;
1012: second rotating assembly; 10121: second swing arm; 101211: second arc-shaped rotating block; 1012111: second recess;
1012112: second mounting slot; 10121121: fifth circular arc-shaped surface; 10122: second support arm; 10123: second connector;
101231: third rotating shaft; 1012311: sixth circular arc-shaped surface; 1012312: eighth circular arc-shaped surface; 101232: fourth rotating shaft;
101233: third arc-shaped surface; 101234: fourth arc-shaped surface;
1013: first housing fastening bracket; 10131: first sliding slot; 10132: first mounting part; 10133: third sliding slot;
1014: second housing fastening bracket; 10141: second sliding slot; 10142: second mounting part; 10143: fourth sliding slot;
102: main shaft; 1021: first base; 10211: first arc-shaped groove; 102111: groove surface of the first arc-shaped groove;
10212: second arc-shaped groove; 102121: third circular arc-shaped surface; 10213: third arc-shaped groove; 102131: groove surface of the third arc-shaped groove;
10214: fourth arc-shaped groove; 102141: seventh circular arc-shaped surface;
1022: first cover plate; 10221: first protrusion; 102211: surface of the first protrusion; 10222: second protrusion;
102221: surface of the second protrusion; 10223: first insertion part; 10224: third protrusion; 102241: surface of the third protrusion;
10225: fourth protrusion; 102251: surface of the fourth protrusion;
1023: first track slot; 1024: second track slot;
103: first synchronization assembly; 1031: first gear connecting rod; 10311: first gear; 10312: first connecting rod;
10313: fifth rotating shaft; 1032: second gear connecting rod; 10321: second gear; 10322: second connecting rod;
10323: sixth rotating shaft; 104: first under-display support; 105: second under-display support;
2: second hinge mechanism; 2a: support surface of the second hinge mechanism; 201: second rotating module; 201a: third rotating assembly;
201b: fourth rotating assembly; 2012: third support arm;
20121: first sliding block; 20122: first mounting hole; 2013: third swing arm; 20131: third arc-shaped rotating block;
20132: second sliding block; 20133: first guide structure; 20134: first guide slot; 20135: second mounting hole;
2014: second cover plate; 20141: first arc-shaped protrusion; 20142: second arc-shaped protrusion;
2015: third housing fastening bracket; 2015a: first surface; 2015b: second surface; 20151: fifth sliding slot;
201511: first sliding rail; 20152: sixth sliding slot; 201521: second sliding rail; 20153: first rotating slot;
2016a: first drive connecting rod; 20161: first connecting part; 20162: second connecting part; 20163: third connecting rod;
20164: fourth connecting rod; 2016b: second drive connecting rod;
2017: second synchronization assembly; 20171a: first drive gear; 20171b: second drive gear; 20172: driven gear;
20173: middle shaft;
2018: damping assembly; 20181: elastic member; 20182: conjoined cam; 20183: stopper;
20184: snap ring; 2019: fourth housing fastening bracket; 2019a: third surface; 2019b: fourth surface; 20191: seventh sliding slot;
201911: third sliding rail; 20192: eighth sliding slot; 201921: fourth sliding rail; 20193: second rotating slot;
2020: fourth support arm; 202001: third sliding block; 2021: fourth swing arm; 202101: fourth arc-shaped rotating block;
202102: fourth sliding block; 202103: second guide structure;
202: first support plate; 202a: first plate surface; 202b: second plate surface; 20201: first rotating part;
20202: first guide part; 202021: third track slot;
203: second support plate; 2031: second rotating part; 2032: second guide part; 20321: fourth track slot;
204: display accommodation space; 205: end cover; 206: second base;
2061: pin shaft; 2062: damping bracket;
2063: fifth arc-shaped groove; 2064: sixth arc-shaped groove;
3: first housing; 3a: support surface of the first housing;
4: second housing; 4a: support surface of the second housing;
5: third housing; 5a: support surface of the third housing;
6: flexible display; 601: first part; 602: second part; and 7: camera module.

### DESCRIPTION OF EMBODIMENTS

To make the objectives, technical solutions, and advantages of this application clearer, the following further describes embodiments of this application in detail with reference to the accompanying drawings. However, example implementations may be implemented in a plurality of forms, and should not be construed as being limited to implementations described herein. Same reference numerals in the accompanying drawings denote same or similar structures. Therefore, repeated descriptions thereof are omitted. Expressions of positions and directions in embodiments of this application are described by using the accompanying drawings as an example. However, changes may also be made as required, and all the changes fall within the protection scope of this application. The accompanying drawings in embodiments of this application are merely used to illustrate a relative position relationship and do not represent an actual scale.

It should be noted that specific details are set forth in the following description to facilitate understanding of this application. However, embodiments of this application can be implemented in a plurality of manners different from those described herein, and a person skilled in the art can perform similar promotion without departing from the connotation of embodiments of this application. Therefore, this application is not limited to the specific implementations disclosed in the following.

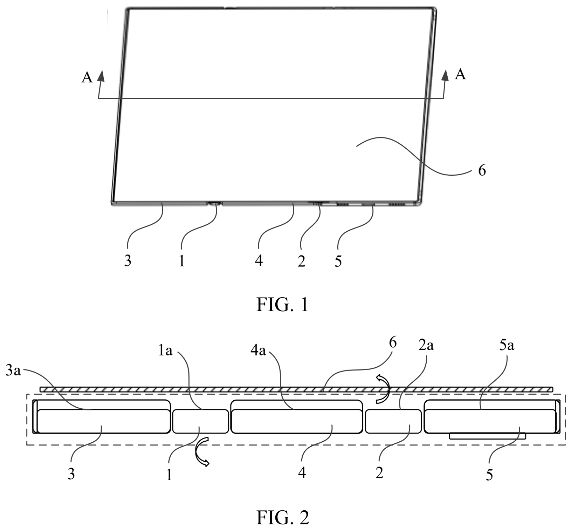

An electronic device provided in embodiments of this application includes a mobile phone, a palmtop computer (personal digital assistant, PDA), a tablet computer, or another device having a foldable function. For ease of understanding of the electronic device provided in embodiments of this application, first refer to FIG. 1. FIG. 1 is a diagram of a structure of an electronic device in an unfolded state according to an embodiment of this application. In the embodiment shown in FIG. 1, an example in which the electronic device is a trifold smartphone is used for description. However, in another embodiment of this application, the electronic device may alternatively be disposed in a quad-fold form, a five-fold form, or a more-fold form. A specific disposing manner of the electronic device is similar to that of the electronic device in the trifold form.

Still refer to FIG. 1. The electronic device may include three housings, two hinge mechanisms, and a flexible display 6. For ease of description, the two hinge mechanisms are respectively named a first hinge mechanism 1 and a second hinge mechanism 2. The three housings are respectively named a first housing 3, a second housing 4, and a third housing 5. The first hinge mechanism 1 is located between the first housing 3 and the second housing 4, and the first housing 3 is rotatably connected to the second housing 4 through the first hinge mechanism 1. The second hinge mechanism 2 is located between the second housing 4 and the third housing 5, and the second housing 4 is rotatably connected to the third housing 5 through the second hinge mechanism 2. When the electronic device is used, the first housing 3 and the second housing 4 may rotate toward or away from each other under action of the first hinge mechanism 1, and the second housing 4 and the third housing 5 may rotate toward or away from each other under action of the second hinge mechanism 2, so that the electronic device can be folded and unfolded based on different usage scenarios.

As shown in FIG. 1, when the electronic device is in the unfolded state, the first housing 3, the first hinge mechanism 1, the second housing 4, the second hinge mechanism 2, and the third housing 5 are sequentially disposed side by side.

FIG. 2 is a simplified diagram of a cross-sectional view of the electronic device shown in FIG. 1 at A-A. In the electronic device, the first housing 3, the second housing 4, the third housing 5, the first hinge mechanism 1, and the second hinge mechanism 2 each have a support surface disposed facing the flexible display 6. The flexible display 6 may continuously cover a support surface 3a of the first housing, a support surface 1a of the first hinge mechanism, a support surface 4a of the second housing, a support surface 2a of the second hinge mechanism, and a support surface 5a of the third housing. The first hinge mechanism 1 and the second hinge mechanism 2 are separately disposed corresponding to a bendable part of the flexible display 6, and the flexible display 6 is fastened to the support surface 3a of the first housing, the support surface 4a of the second housing, and the support surface 5a of the third housing. The connection manner includes but is not limited to bonding. When the electronic device is in the unfolded state, the support surface 3a of the first housing, the support surface 1a of the first hinge mechanism, the support surface 4a of the second housing, the support surface 2a of the second hinge mechanism, and the support surface 5a of the third housing may be connected to each other to form a flat support surface, so as to support the flexible display 6 flatly.

It may be understood that, when the electronic device is in the unfolded state, the flexible display 6 is completely exposed outside the electronic device, and because the entire flexible display 6 is in a flat state at this time, the electronic device can meet a user's need for large-screen displaying in the unfolded state.

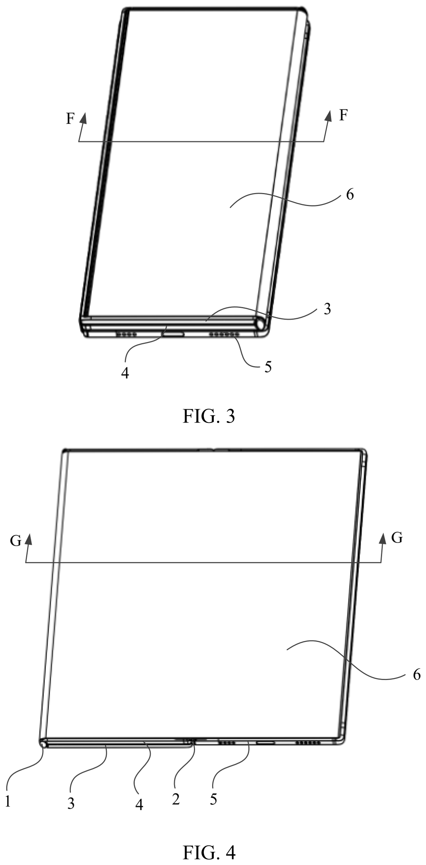

FIG. 3 is a diagram of a structure of the electronic device shown in FIG. 1 in a folded state. In this embodiment of this application, when the electronic device is in the folded state, the first housing 3 and the third housing 5 may be respectively folded on two sides of the second housing 4. This folding manner may be considered as "Z"-shaped folding or "S"-shaped folding. In this case, a part that is of the flexible display 6 and that is disposed corresponding to the first housing 3 may be exposed on a folding outer side of the electronic device, and a part that is of the flexible display 6 and that is disposed corresponding to the second housing 4 and the third housing 5 is hidden on a folding inner side of the electronic device. In other words, the part that is of the flexible display 6 and that is disposed corresponding to the first housing 3 may be used as an appearance surface of the electronic device in the folded state.

In the electronic device provided in this embodiment of this application, sizes of the first housing 3, the second housing 4, and the third housing 5 may be adjusted, so that when the electronic device is in the folded state, an area of the flexible display 6 exposed outside the electronic device may still be large. Therefore, the electronic device can still perform operations for a plurality of functions in the folded state. This can effectively reduce an unnecessary folding operation of the electronic device, and help prolong service lives of the flexible display 6 and the hinge mechanisms.

FIG. 4 is a diagram of a structure of the electronic device shown in FIG. 1 in an intermediate state. In the state shown in FIG. 4, the flexible display 6 is completely exposed outside the electronic device, but a part that is of the flexible display 6 and that is disposed corresponding to the first housing 3 is opposite to a part that is of the flexible display 6 and that is disposed corresponding to the second housing 4 and the third housing 5. In this case, a single-sided display function or a double-sided display function of the electronic device may be implemented based on a user requirement.

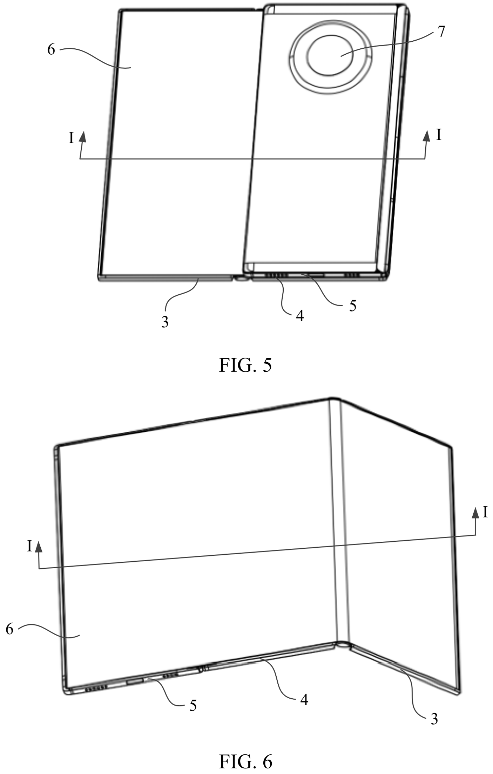

In addition, FIG. 5 is another diagram of a structure of the electronic device shown in FIG. 1 in the intermediate state. Different from FIG. 4, in the electronic device shown in FIG. 5, the first housing 3 and the second housing 4 are in the unfolded state, and the third housing 5 is in the folded state relative to the second housing 4. In this state, the part that is of the flexible display 6 and that is disposed corresponding to the first housing 3 is exposed outside the electronic device, and the part that is of the flexible display 6 and that is disposed corresponding to the second housing 4 and the third housing 5 is hidden on a folding inner side of the electronic device. In other words, the part that is of the flexible display 6 and that is disposed corresponding to the first housing 3 and a side that is of the third housing 5 and that is away from the flexible display 6 face a same side of the electronic device.

The electronic device provided in this embodiment of this application further includes a camera module 7. The camera module 7 may be disposed in the third housing 5, and a main camera of the camera module 7 is exposed on the side that is of the third housing 5 and that is away from the flexible display 6. In view of this, when the electronic device is in the state shown in FIG. 5, a user may turn on the camera through the part that is of the flexible display 6 and that is disposed corresponding to the first housing 3, and use the main camera to take a selfie. This can improve convenience of taking a selfie by the user through the main camera, thereby improving user experience.

FIG. 6 is another diagram of a structure of the electronic device shown in FIG. 1 in the intermediate state. In the state shown in FIG. 6, the first housing 3 and the second housing 4 are in the unfolded state, and the third housing 5 is in the intermediate state relative to the second housing 4. In addition, in this case, an included angle between the support surface 300a of the third housing 5 and the support surface of the second housing 4 is greater than or equal to 90°. In this state, the flexible display 6 is completely exposed on a folding outer side of the electronic device, and because the three housings of the electronic device may form a triangular support structure, the three housings may be in a bracket form to provide stable support force for the entire electronic device.

It may be understood that when the electronic device is in the state shown in FIG. 6, same content may be simultaneously displayed on a part that is of the flexible display 6 and that is disposed corresponding to the first housing 3 and the second housing 4 and a part that is of the flexible display 6 and that is disposed corresponding to the third housing 5, so that the electronic device can synchronously perform displaying for different users at face-to-face positions. This helps improve user experience.

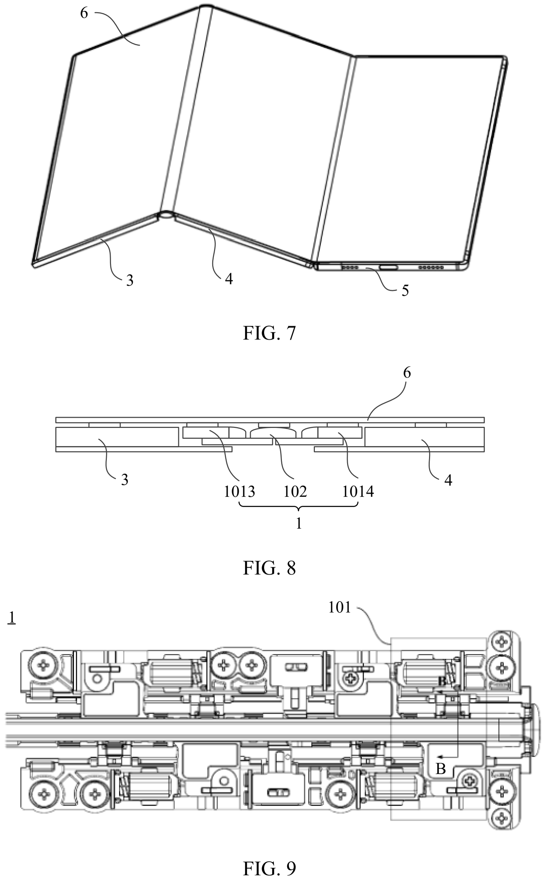

FIG. 7 is another diagram of a structure of the electronic device in the intermediate state according to an embodiment of this application. In this state, an included angle between the support surface of the first housing 3 and the support surface of the second housing 4 is greater than or equal to 90°, and an included angle between the support surface of the third housing 5 and the support surface of the second housing 4 is greater than 90°. In this case, the flexible display 6 is completely exposed outside the electronic device, and a triangular support structure may be formed between the second housing 4 and the third housing 5, to provide stable support force for the entire electronic device.

When the electronic device is in the state shown in FIG. 7, same content may be simultaneously displayed on a part that is of the flexible display 6 and that is disposed corresponding to the first housing 3 and a part that is of the flexible display 6 and that is disposed corresponding to the second housing 4, so that the electronic device can synchronously perform displaying for different users at face-to-face positions. A part that is of the flexible display 6 and that is disposed corresponding to the third housing 5 may be used as a keyboard area, so that a user located on a side of the electronic device can perform an input operation through a keyboard. This helps improve user experience.

It can be understood from the foregoing descriptions of applications of the electronic device provided in this application in different scenarios that the electronic device can meet application requirements of the user in a plurality of scenarios. This helps improve user experience and further improve market competitiveness of the electronic device.

It may be understood that whether the electronic device can meet folding requirements in different application scenarios largely depends on structural designs of the first hinge mechanism 1 and the second hinge mechanism 2. How the first hinge mechanism 1 and the second hinge mechanism 2 are specifically designed are not limited in this application. The first housing 3 and the second housing 4 can move toward or away from each other through the first hinge mechanism 1, the second housing 4 and the third housing 5 can move toward or away from each other through the second hinge mechanism 2, and uniform force on the flexible display 6 can be ensured. The foregoing is within the scope of embodiments of this application.

Then, an example design manner of the first hinge mechanism 1 of the electronic device provided in embodiments of this application is specifically described.

FIG. 8 is a simplified diagram of a connection relationship among the first housing 3, the second housing 4, and the first hinge mechanism 1 of the electronic device in an unfolded state according to an embodiment of this application. The first hinge mechanism 1 includes a first housing fastening bracket 1013, a second housing fastening bracket 1014, and a main shaft 102. The first housing fastening bracket 1013 and the second housing fastening bracket 1014 are respectively disposed on two opposite sides of the main shaft 102. The first housing fastening bracket 1013 is rotatably connected to the main shaft 102, and the second housing fastening bracket 1014 is rotatably connected to the main shaft 102. The first housing fastening bracket 1013 is fastened to the first housing 3, and the second housing fastening bracket 1014 is fastened to the second housing 4. In this way, the first housing 3 is rotatably connected to the first hinge mechanism 1, and the second housing 4 is rotatably connected to the first hinge mechanism 1.

To implement the rotational connection between the first housing fastening bracket 1013 and the main shaft 102 and the rotational connection between the second housing fastening bracket 1014 and the main shaft 102, the first hinge mechanism 1 further includes a first rotating module 101. During specific implementation, refer to FIG. 9. FIG. 9 is a diagram of a partial structure of the first hinge mechanism 1 according to an embodiment of this application. In this application, the first hinge mechanism 1 may include the first rotating module 101. A quantity of first rotating modules 101 in the first hinge mechanism 1 is not limited in this application. The first hinge mechanism 1 may include only one first rotating module 101, or may include a plurality of first rotating modules 101. When the first hinge mechanism 1 includes a plurality of first rotating modules 101, the plurality of first rotating modules 101 may be arranged and spaced from each other in a length direction of the first hinge mechanism 1. In this application, the length direction of the first hinge mechanism 1 is an extension direction of an axis of rotation of the first housing 3 and the second housing 4 around the first hinge mechanism 1. It may be understood that the first housing 3 is rotatably connected to the second housing 4 through the plurality of first rotating modules 101, so that stability of rotation of the first housing 3 and the second housing 4 of the electronic device relative to the first hinge mechanism 1 can be effectively improved.

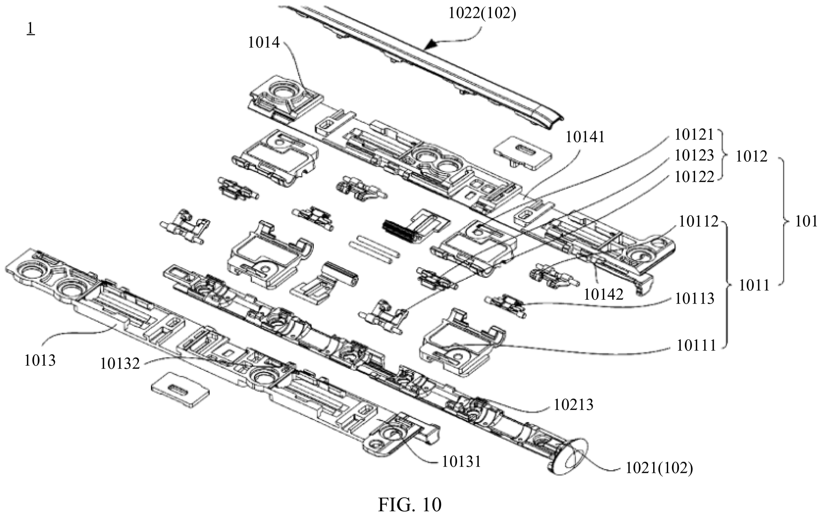

To facilitate understanding of a structure of the first rotating module 101, refer to FIG. 10. FIG. 10 is an exploded view of the first hinge mechanism 1 shown in FIG. 9. The first rotating module 101 may include a first rotating assembly 1011 and a second rotating assembly 1012. In addition, in this application, the main shaft may be used as a bearing component of the first rotating assembly 1011 and the second rotating assembly 1012.

It should be noted that, in this embodiment of this application, when there are a plurality of first rotating modules 101, first rotating assemblies 1011 and second rotating assemblies 1012 of the plurality of first rotating modules 101 may all use the same main shaft as the bearing component, to improve integration of the first hinge mechanism 1. In some other possible embodiments of this application, the first hinge mechanism 1 may be separately provided with one main shaft corresponding to each first rotating module 101, so that a first rotating assembly 1011 and a second rotating assembly 1012 of each first rotating module 101 use the corresponding main shaft as a bearing component.

Still refer to FIG. 10. The first rotating assembly 1011 may include a first swing arm 10111, a first support arm 10112, and a first connector 10113. The first connector 10113 is located between the first swing arm 10111 and the first support arm 10112, the first connector 10113 is rotatably connected to the first swing arm 10111, and the first connector 10113 is rotatably connected to the first support arm 10112, so that the first swing arm 10111 and the first support arm 10112 are mutually pulled to move through the first connector 10113. In view of this, it may be understood that a movement track of the first connector 10113 plays a key role in a movement track of the first rotating assembly 1011.

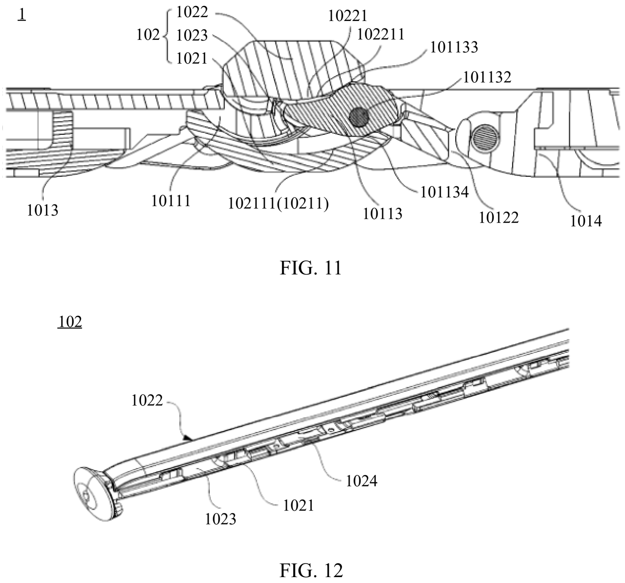

In this application, the first connector 10113 may move relative to the main shaft 102. During specific implementation, refer to FIG. 11. FIG. 11 is a cross-sectional view of the first hinge mechanism 1 at the first connector 10113 when the first housing and the second housing are in the unfolded state according to an embodiment of this application. The main shaft 102 may be provided with a first track slot 1023, and the first connector 10113 can move along the first track slot 1023, to limit a movement track of the first connector 10113.

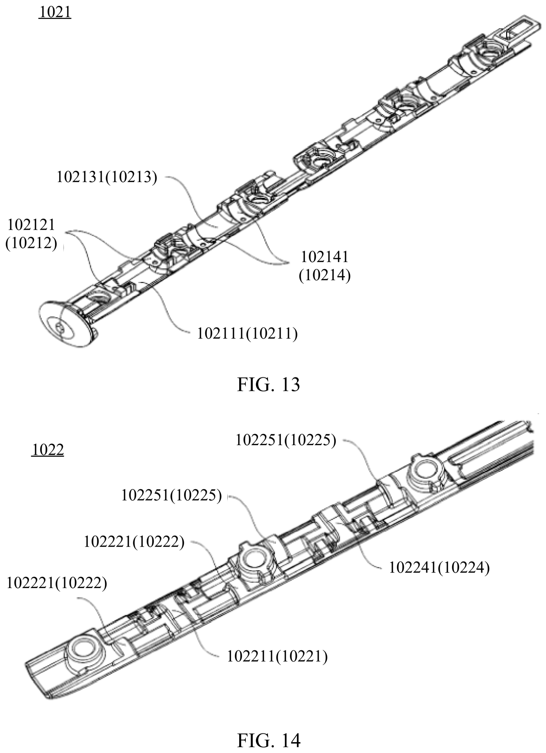

FIG. 12 is a diagram of a structure of the main shaft 102 according to an embodiment of this application. The main shaft may include a first base 1021 and a first cover plate 1022. The first cover plate 1022 covers the first base 1021. In this case, an outer surface of the first cover plate 1022 may be used as an appearance surface of the first hinge mechanism 1. FIG. 13 is a diagram of a structure of the first base 1021 of the main shaft 102 shown in FIG. 12. The first base 1021 may be provided with a first arc-shaped groove 10211. Refer to FIG. 11 and FIG. 13 together. The first connector 10113 is accommodated in the first arc-shaped groove 10211, and the first connector 10113 can slide along a groove surface 102111 of the first arc-shaped groove. In addition, FIG. 14 is a diagram of a structure of the first cover plate 1022 of the main shaft 102 shown in FIG. 12, and FIG. 14 is used to show a structure of a side that is of the first cover plate 1022 and that faces the first base 1021. The first cover plate 1022 includes a first protrusion 10221. As shown in FIG. 11, the first protrusion 10221 may be disposed facing the first arc-shaped groove 10211. There is a gap between a surface 102211 of the first protrusion and the groove surface 102111 of the first arc-shaped groove, and the gap serves as the first track slot 1023.

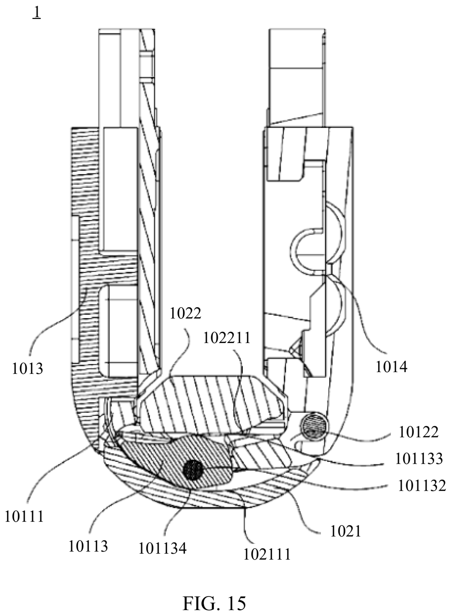

FIG. 15 is a cross-sectional view of the hinge mechanism at the first connector 10113 when the first housing and the second housing are in the folded state according to an embodiment of this application. Refer to FIG. 11 and FIG. 15 together. During transition of the first housing and the second housing from the unfolded state to the folded state, the first connector 10113 may move toward the first swing arm 10111 in the first track slot 1023. During transition of the first housing and the second housing from the folded state to the unfolded state, the first connector 10113 may move toward the first support arm 10112 in the first track slot 1023. In this way, the first connector 10113 can move relative to the main shaft 102 based on a specified track.

Refer to FIG. 11 and FIG. 15 together. It can be learned that during the transition of the first housing and the second housing from the unfolded state to the folded state or from the folded state to the unfolded state, the first swing arm 10111 and the first support arm 10112 may rotate around the main shaft 102. In addition, because the first swing arm 10111 and the first support arm 10112 are mutually pulled to move through the first connector 10113, the first connector 10113 can further rotate relative to the surface 102211 of the first protrusion and the groove surface 102111 of the first arc-shaped groove in a process in which the first connector 10113 moves in the first track slot 1023, to improve movement smoothness of the first rotating assembly 1011.

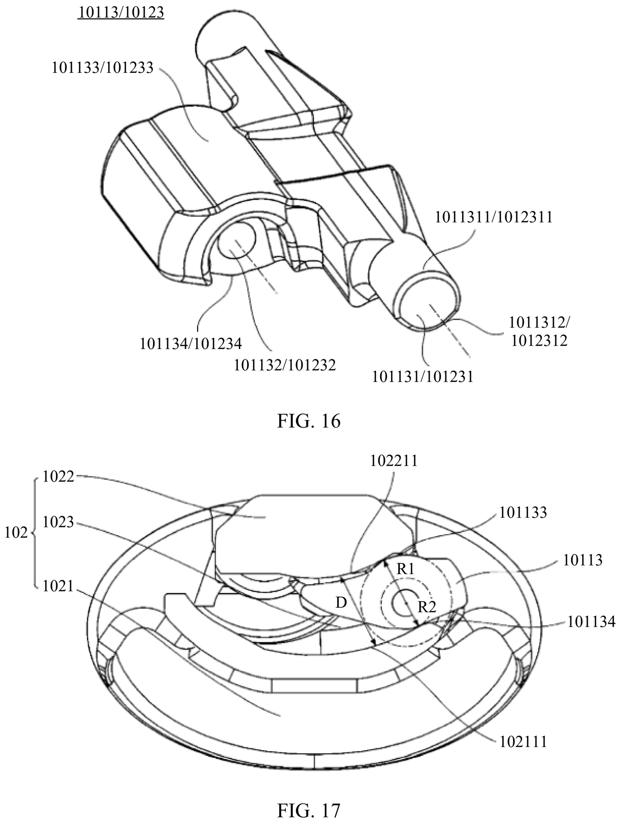

FIG. 16 is a diagram of a structure of the first connector 10113 according to an embodiment of this application. In this application, the first connector 10113 may include a first arc-shaped surface 101133 and a second arc-shaped surface 101134. To implement rotation of the first connector 10113 relative to the surface 102211 of the first protrusion and the groove surface 102111 of the first arc-shaped groove, the first arc-shaped surface 101133 and the second arc-shaped surface 101134 may be circular arc-shaped surfaces, and a circle center of the first arc-shaped surface 101133 coincides with a circle center of the second arc-shaped surface 101134. Radii of the first arc-shaped surface 101133 and the second arc-shaped surface 101134 may be equal or unequal, which is not limited in this application. In addition, in consideration of design tolerance, the first arc-shaped surface 101133 and the second arc-shaped surface 101134 may also be arc-shaped surfaces of other possible forms such as an elliptical arc-shaped surface, provided that the first connector 10113 can rotate relative to the surface 102211 of the first protrusion and the groove surface 102111 of the first arc-shaped groove.

Still refer to FIG. 11 and FIG. 15. When the first housing and the second housing are in the unfolded state shown in FIG. 11 and the folded state shown in FIG. 15, the first arc-shaped surface 101133 of the first connector 10113 may abut against the surface 102211 of the first protrusion, and the second arc-shaped surface 101134 abuts against the groove surface 102111 of the first arc-shaped groove. In this way, the surface 102211 of the first protrusion and the groove surface 102111 of the first arc-shaped groove limit the first connector 10113 to the first track slot 1023, so that when the hinge mechanism 1 is in the unfolded state and the folded state, a position of the first connector 10113 is stable, and no virtual position shake is generated, to improve reliability of the hinge mechanism 1 in the foregoing two states.

In this application, when the electronic device is in the unfolded state shown in FIG. 11, a spacing between a point at which the surface 102211 of the first protrusion abuts against the first arc-shaped surface 101133 and a point at which the groove surface 102111 of the first arc-shaped groove abuts against the second arc-shaped surface 101134 is denoted as d1. When the electronic device is in the folded state shown in FIG. 15, a spacing between a point at which the surface 102211 of the first protrusion abuts against the first arc-shaped surface 101133 and a point at which the groove surface 102111 of the first arc-shaped groove abuts against the second arc-shaped surface 101134 is denoted as d2. When the electronic device is in the unfolded state and the folded state, the first arc-shaped surface 101133 of the first connector 10113 may abut against the surface 102211 of the first protrusion, and the second arc-shaped surface 101134 abuts against the groove surface 102111 of the first arc-shaped groove. Therefore, when both the first arc-shaped surface 101133 and the second arc-shaped surface 101134 are circular arc-shaped surfaces, d1=d2 may be obtained.

In this application, specific disposing forms of the surface 102211 of the first protrusion and the groove surface 102111 of the first arc-shaped groove are not limited. For example, the surface 102211 of the first protrusion may be a circular arc-shaped surface, and the groove surface 102111 of the first arc-shaped groove may be a circular arc-shaped surface. In addition, a circle center of the surface 102211 of the first protrusion coincides with a circle center of the groove surface 102111 of the first arc-shaped groove. In some other possible embodiments of this application, both the surface 102211 of the first protrusion and the groove surface 102111 of the first arc-shaped groove may be configured as planes, so that the first track slot 1023 is a straight-line slot. Alternatively, both the surface 102211 of the first protrusion and the groove surface 102111 of the first arc-shaped groove may be curved surfaces in other forms, so that the first track slot 1023 is a curved slot in any form. It should be understood as the foregoing falls within the protection scope of this application.

Still refer to FIG. 11. In this application, the surface 102211 of the first protrusion is equidistant from the groove surface 102111 of the first arc-shaped groove. In this case, the first track slot 1023 is an equal-width slot. In this case, during transition of the first housing and the second housing from the unfolded state to the folded state, and during transition of the first housing and the second housing from the folded state to the unfolded state, the surface 102211 of the first protrusion is always in an abut-against state with the first arc-shaped surface 101133, and the groove surface 102111 of the first arc-shaped groove is always in an abut-against state with the second arc-shaped surface 101134. Therefore, during the transition of the first housing and the second housing from the unfolded state to the folded state, and during the transition of the first housing and the second housing from the folded state to the unfolded state, movement tracks of the first connector 10113 are the same. This helps improve movement stability of the first connector 10113, and improve movement stability of the first rotating assembly 1011.

FIG. 17 is a diagram of an assembled structure of the first connector 10113 and the main shaft 102 according to an embodiment of this application. In this application, when the first track slot 1023 is an equal-width slot, and the first arc-shaped surface 101133 and the second arc-shaped surface 101134 are circular arc-shaped surfaces, a sum of a radius R1 of the first arc-shaped surface 101133 and a radius R1 of the second arc-shaped surface 101134 is equal to a spacing D between the surface 102211 of the first protrusion and the groove surface 102111 of the first arc-shaped groove. In addition, in consideration of movement smoothness of the first connector 10113 in the first track slot 1023, a specific design gap may be reserved between the first arc-shaped surface 101133 and the surface 102211 of the first protrusion, and/or between the second arc-shaped surface 101134 and the groove surface 102111 of the first arc-shaped groove.

In some other possible embodiments of this application, a movement track of the first connector 10113 during transition of the first housing and the second housing from the unfolded state to the folded state may be different from a movement track of the first connector 10113 during transition of the first housing and the second housing from the folded state to the unfolded state. During specific implementation, during the transition of the first housing and the second housing from the unfolded state to the folded state, the first arc-shaped surface 101133 abuts against the surface 102211 of the first protrusion, and there is a gap between the second arc-shaped surface 101134 and the groove surface 102111 of the first arc-shaped groove. In addition, during the transition of the first housing and the second housing from the unfolded state to the folded state, the second arc-shaped surface 101134 abuts against the groove surface 102111 of the first arc-shaped groove, and there is a gap between the first arc-shaped surface 101133 and the surface 102211 of the first protrusion. In this embodiment, gaps at positions between the surface 102211 of the first protrusion and the groove surface 102111 of the first arc-shaped groove may be unequal. In this case, the first track slot 1023 may be a non-equal-width slot.

It can be learned from the foregoing description that, in this application, the first swing arm 10111 may be rotatably connected to the main shaft 102, and the first swing arm 10111 may be rotatably connected to the main shaft 102 through a virtual shaft. This can help reduce space occupied by the first swing arm 10111 on the main shaft 102, to help reduce a volume of the first rotating module 101, and implement a miniaturized design of the hinge mechanism 1. In addition, it may be understood that, in this embodiment of this application, when the first swing arm 10111 is rotatably connected to the main shaft 102 through the virtual shaft, an axis center of rotation of the first swing arm 10111 around the main shaft 102 is located on a side that is of the main shaft 102 and that is away from the flexible display.

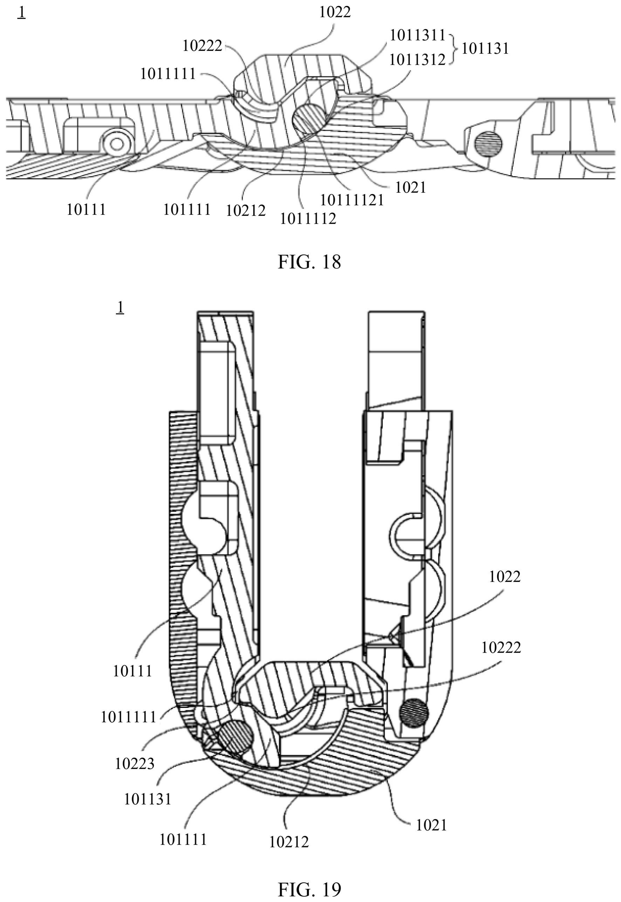

It should be noted that, in this application, the virtual shaft is an axis center of a circular arc-shaped structure. Two components that are rotatably connected to each other are rotatable relative to the virtual shaft, and a position of the virtual shaft is fixed as the two components that are rotatably connected to each other rotate relative to each other. For example, FIG. 18 is a cross-sectional view of the structure shown in FIG. 9 at B-B. A first arc-shaped rotating block 101111 may be disposed at an end that is of the first swing arm and that faces the first base 1021. In addition, as shown in FIG. 13, a second arc-shaped groove 10212 may be provided on the first base 1021. The first arc-shaped rotating block 101111 may be accommodated in the second arc-shaped groove 10212, and the first arc-shaped rotating block 101111 can slide along the groove surface of the second arc-shaped groove 10212. In this way, rotation of the first swing arm 10111 around the main shaft 102 is implemented by sliding the first arc-shaped rotating block 101111 along an arc-shaped surface of the second arc-shaped groove 10212. In addition, in this application, the first arc-shaped rotating block 101111 may be but is not limited to a circular arc-shaped rotating block, and the second arc-shaped groove 10212 may be but is not limited to a circular arc-shaped groove. It may be understood that, when the first arc-shaped rotating block 101111 is a circular arc-shaped rotating block, a surface that is of the first arc-shaped rotating block 101111 and that is in contact with the groove surface of the second arc-shaped groove 10212 may be a circular arc-shaped surface, the groove surface of the second arc-shaped groove 10212 is also a circular arc-shaped surface, and circle centers of the two circular arc-shaped surfaces coincide with each other.

Refer to FIG. 14 and FIG. 18 together. The first cover plate 1022 may include a second protrusion 10222 disposed facing the second arc-shaped groove 10212, at least a part of the first arc-shaped rotating block 101111 is located between the second protrusion 10222 and the second arc-shaped groove 10212, and the first arc-shaped rotating block 101111 may be in contact with a surface 102221 of the second protrusion. In this way, the first arc-shaped rotating block 101111 may be limited between the first cover plate 1022 and the first base 1021, and stability of rotation of the first arc-shaped rotating block 101111 relative to the first base 1021 can be effectively improved.

It should be noted that when the groove surface of the second arc-shaped groove 10212 is a circular arc-shaped surface, a part that is of the surface 102221 of the second protrusion and that is in contact with the first arc-shaped rotating block 101111 may also be a circular arc-shaped surface, and circle centers of the two circular arc-shaped surfaces coincide with each other. In addition, a surface that is of the first arc-shaped rotating block 101111 and that faces the second protrusion 10222 may be a plane or a circular arc-shaped surface, provided that the first arc-shaped rotating block 101111 can rotate relative to the second protrusion 10222.

FIG. 19 is a cross-sectional view of the first hinge mechanism 1 at the first swing arm 10111 when the first housing and the second housing are in the folded state according to an embodiment of this application. In this application, the first arc-shaped rotating block 101111 may further be provided with a first recess 1011111, and an opening of the first recess 1011111 is disposed facing the first cover plate 1022. In addition, a first insertion part 10223 may be disposed on an end part that is of the first cover plate 1022 and that faces the first swing arm 10111. In this case, in the folded state, the first insertion part 10223 may be inserted into the first recess 1011111, and a surface that is of the first insertion part 10223 and that faces the second arc-shaped groove 10212 abuts against at least a part of a surface of the first recess 1011111. This can limit a rotation part of the first arc-shaped rotating block 101111, and can avoid detachment of the first arc-shaped rotating block 101111 from the second arc-shaped groove 10212, to improve reliability of a connection between the first swing arm 10111 and the first base 1021, and improve structural reliability of the entire hinge mechanism 1.

It should be noted that, in this application, in addition to being rotatably connected to the main shaft 102 through a virtual shaft, the first swing arm 10111 may be rotatably connected to the main shaft 102 through a solid shaft, so that the first swing arm 10111 can be connected to the main shaft 102 reliably. It may be understood that, when the first swing arm 10111 is rotatably connected to the main shaft 102 through a solid shaft, an axis center of rotation of the first swing arm 10111 around the main shaft 102 is also located on a side that is of the main shaft 102 and that is away from the flexible display.

In this application, when the first swing arm 10111 is rotatably connected to the first connector 10113, still refer to FIG. 16. The first connector 10113 may include a first rotating shaft 101131 and a second rotating shaft 101132, and an axis of the first rotating shaft 101131 is parallel to and does not coincide with an axis of the second rotating shaft 101132.

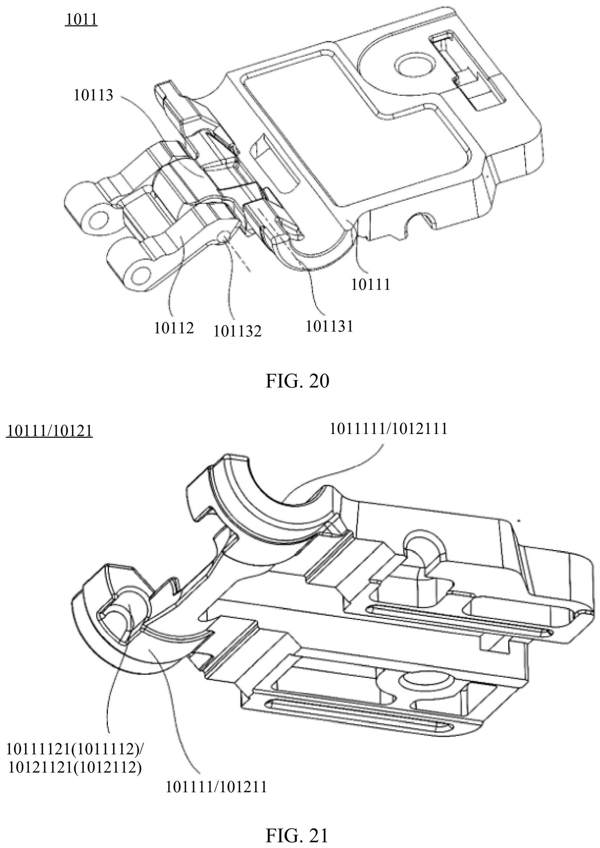

In addition, FIG. 20 is a diagram of a structure of the first rotating assembly 1011 according to an embodiment of this application. The first connector 10113 is rotatably connected to the first swing arm 10111 through the first rotating shaft 101131, and the first connector 10113 is rotatably connected to the first support arm 10112 through the second rotating shaft 101132. In this way, the first swing arm 10111 and the first support arm 10112 may be mutually pulled to move through the first connector 10113.

FIG. 21 is a diagram of a structure of the first swing arm 10111 according to an embodiment of this application. The first arc-shaped rotating block 101111 of the first swing arm 10111 is provided with a first mounting slot 1011112. Refer to FIG. 18 and FIG. 21 together. A slot opening of the first mounting slot 1011112 is provided facing the second arc-shaped groove 10212, and the first rotating shaft 101131 may be mounted in the first mounting slot 1011112. A part of a surface of the first rotating shaft 101131 may be in contact with a slot surface of the first mounting slot 1011112, and a part of the surface of the first rotating shaft 101131 is in contact with the groove surface of the second arc-shaped groove 10212, to limit the first rotating shaft 101131 in the first mounting slot 1011112.

Still refer to FIG. 18 and FIG. 21. The slot surface of the first mounting slot 1011112 may include a first circular arc-shaped surface 10111121, the surface that is of the first rotating shaft 101131 and that is in contact with the slot surface of the first mounting slot 1011112 is a second circular arc-shaped surface 1011311, and a circle center of the first circular arc-shaped surface 10111121 coincides with a circle center of the second circular arc-shaped surface 1011311. In addition, refer to FIG. 13. The groove surface of the second arc-shaped groove 10212 may be a third circular arc-shaped surface 102121. However, as shown in FIG. 18, the surface that is of the first rotating shaft 101131 and that is in contact with the groove surface of the second arc-shaped groove 10212 may be a fourth circular arc-shaped surface 1011312, and a circle center of the third circular arc-shaped surface 102121 coincides with a circle center of the fourth circular arc-shaped surface 1011312. In this way, refer to FIG. 18 and FIG. 19 together. When the first rotating shaft 101131 slides along the groove surface of the second arc-shaped groove 10212 with the first arc-shaped rotating block 101111, the first rotating shaft 101131 may further rotate relative to the first arc-shaped rotating block 101111, to facilitate movement of the first connector 10113 relative to the main shaft 102.

In this application, when the first connector is rotatably connected to the first support arm, as shown in FIG. 20, the second rotating shaft 101132 may penetrate both the first connector 10113 and the first support arm 10112. In this case, a connection manner of the first connector 10113 and the first support arm 10112 is simple, which helps simplify a structure of the first rotating assembly 1011, so that a structure of the hinge mechanism 1 can be simplified. It should be noted that, when both the first arc-shaped surface 101133 and the second arc-shaped surface 101134 of the first connector 10113 are circular arc-shaped surfaces, the circle center of the first arc-shaped surface 101133, the circle center of the second arc-shaped surface 101134, and an axis center of the second rotating shaft 101132 coincide with each other.

It may be understood that, in the first hinge mechanism 1 provided in embodiments of this application, the first connector 10113 may include a plurality of first sub-connectors that are sequentially rotatably connected to each other. In addition, the plurality of first sub-connectors may be located between the first swing arm 10111 and the first support arm 10112, the first swing arm 10111 may be rotatably connected to an adjacent first sub-connector, and the first support arm 10112 may be rotatably connected to an adjacent first sub-connector. For how the first swing arm 10111 is rotatably connected to the adjacent first sub-connector and how the first support arm 10112 is rotatably connected to the adjacent first sub-connector, refer to the foregoing descriptions of the rotational connections of the first swing arm 10111 and the first support arm 10112 to the first connector 10113. Details are not described herein again. In this application, the first connector 10113 is disposed as the plurality of first sub-connectors that are sequentially rotatably connected to each other, so that the first swing arm 10111 and the first support arm 10112 are connected to each other through the plurality of first sub-connectors. This can effectively improve speed uniformity in a process in which the first swing arm 10111 and the first support arm 10112 rotate around the main shaft 102, to improve smoothness of mutual pulling movement of the first swing arm 10111 and the first support arm 10112.

Still refer to FIG. 10. In this application, the first swing arm 10111 is slidably connected to the first housing fastening bracket 1013. During specific implementation, the first housing fastening bracket 1013 is provided with a first sliding slot 10131. The first sliding slot 10131 extends in a first direction, and the first swing arm 10111 may be mounted in the first sliding slot 10131, and may slide in the first sliding slot 10131 in the first direction. The first direction may be a direction in which the first housing fastening bracket 1013 moves in a direction toward or away from the first base 1021. In addition, a first sliding rail may be disposed on a slot wall of the first sliding slot 10131, and a first sliding block may be disposed on the first swing arm 10111, to avoid detachment of the first swing arm 10111 from the first sliding slot 10131. In this way, the first sliding block may be clamped on the first sliding rail, and the first sliding block can slide along the first sliding rail, to limit the first swing arm 10111 in the first sliding slot 10131. In addition, the first sliding rail is disposed on the slot wall of the first sliding slot 10131, to guide sliding of the first swing arm 10111 along the first sliding slot 10131, so as to improve movement stability of the first swing arm 10111.

In this application, the first support arm 10112 may be rotatably connected to the second housing fastening bracket 1014. During specific implementation, still refer to FIG. 10. The second housing fastening bracket 1014 is provided with a second mounting part 10142. An end part that is of the first support arm 10112 and that faces the second housing fastening bracket 1014 is mounted on the second mounting part 10142, and an end part that is of the first support arm 10112 and that faces the second housing fastening bracket 1014 is rotatably connected to the second mounting part 10142.

In embodiments of this application, a specific manner in which the end part that is of the first support arm 10112 and that faces the second housing fastening bracket 1014 is rotatably connected to the second mounting part 10142 is not limited. For example, still refer to FIG. 10. The second mounting part 10142 may be provided with a first mounting hole, and the end part that is of the first support arm 10112 and that faces the second housing fastening bracket 1014 is provided with a second mounting hole. In this case, an end part that is of the first support arm 10112 and that faces the first housing fastening bracket 1013 may be rotatably connected to the second mounting part 10142 through a rotating shaft that penetrates both the first mounting hole and the second mounting hole.

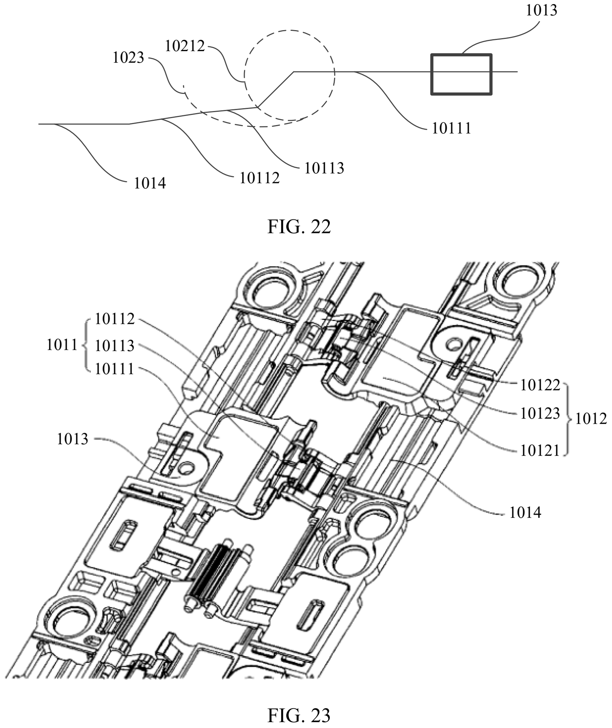

FIG. 22 is a diagram of a movement mechanism of the first hinge mechanism according to an embodiment of this application. Based on the first hinge mechanism 1 provided in the foregoing embodiments of this application, during the transition of the first housing and the second housing from the unfolded state to the folded state, the first housing fastening bracket 1013 and the second housing fastening bracket 1014 move toward each other. When the first housing fastening bracket 1013 drives the first swing arm 10111 to rotate around the main shaft 102 clockwise, the first swing arm 10111 can slide along the groove surface of the second arc-shaped groove 10212, so that the first connector 10113 may be driven to move toward the first swing arm 10111 in the first track slot 1023 of the main shaft 102. In addition, because the first connector 10113 is rotatably connected to the first support arm 10112, in a process in which the first connector 10113 moves toward the first swing arm 10111 in the first track slot 1023 of the main shaft 102, the first support arm 10112 may be driven to rotate around the main shaft 102 counterclockwise, so that the first support arm 10112 drives the second housing fastening bracket 1014 to rotate around the main shaft 102 counterclockwise. In the process in which the electronic device rotates from the folded state to the unfolded state, the first housing fastening bracket 1013 and the second housing fastening bracket 1014 move away from each other. When the first housing fastening bracket 1013 drives the first swing arm 10111 to rotate around the main shaft 102 counterclockwise, the first swing arm 10111 may drive the first connector 10113 to move toward the first support arm 10112 in the first track slot 1023 of the main shaft 102, and the first support arm 10112 may be driven to rotate around the main shaft 102 clockwise, so that the first support arm 10112 drives the second housing fastening bracket 1014 to rotate around the main shaft 102 clockwise. In this way, folding and unfolding functions of the hinge mechanism 1 are implemented.

For some existing hinge mechanisms, to ensure stability of the mechanisms, a thickness of a rotating assembly connected to the main shaft needs to be increased. In this way, both the main shaft and the hinge mechanism are very heavy. Forced thinning is likely to diminish strength of the rotating assembly, thereby greatly affecting reliability of the hinge mechanisms and shortening a service life of the electronic device. The first hinge mechanism 1 in this application has a simplified structure. Based on the foregoing structural relationship, the first connector 10113 may be made with a small cross section to travel back and forth in the first track slot 1023 of the main shaft 102. In addition, the first connector 10113 has a sufficient length extension in a direction perpendicular to an axial direction, and separately has a connection relationship with the first swing arm 10111 and the first support arm 10112, so that reliability of the hinge mechanism 1 can be ensured. In this way, not only can a thickness of the main shaft 102 and a thickness of the entire electronic device be reduced, but also reliability of the first hinge mechanism 1 can be maintained, so that the entire first hinge mechanism 1 is light, thin, and reliable.

In addition, because the first connector 10113 can move in the first track slot 1023 based on a specified track, uncontrolled movement of the first connector 10113 in an entire folding and unfolding process can be avoided, and random movement of the first housing fastening bracket 1013 and the second housing fastening bracket 1014 can also be avoided, to ensure structural stability and movement stability of the entire first hinge mechanism 1. In some cases, the first track slot 1023 may be properly designed, so that an outer tangent line of the first hinge mechanism 1 can keep a constant length in the entire folding and unfolding process, and a part that is of the flexible display and that covers a surface of the first hinge mechanism 1 can also basically keep a length unchanged. In this way, squeezing or pulling on the flexible display can be effectively avoided, to improve structural reliability of the flexible display and further improve structural reliability of the electronic device.

Still refer to FIG. 10. A structure of the second rotating assembly 1012 is similar to that of the first rotating assembly 1011. When the second rotating assembly 1012 is specifically disposed, the second rotating assembly 1012 is located between the first housing fastening bracket 1013 and the second housing fastening bracket 1014. In addition, the second rotating assembly 1012 may include a second swing arm 10121, a second support arm 10122, and a second connector 10123. The second connector 10123 is located between the second swing arm 10121 and the second support arm 10122, the second connector 10123 is rotatably connected to the second swing arm 10121, and the second connector 10123 is rotatably connected to the second support arm 10122. In this application, when the second connector 10123 is rotatably connected to the second swing arm 10121 and the first support arm 10112, the rotational connection manner may be set with reference to the manner in which the first connector 10113 is rotatably connected to the second swing arm 10121 and the second support arm 10122. For example, FIG. 16 may also be used to indicate a structure of the second connector 10123 according to this embodiment of this application. The second connector 10123 may include a third rotating shaft 101231 and a fourth rotating shaft 101232, and an axis of the third rotating shaft 101231 is parallel to and does not coincide with an axis of the fourth rotating shaft 101232. The second connector 10123 may be rotatably connected to the second swing arm 10121 through the third rotating shaft 101231, and the second connector 10123 may be rotatably connected to the second support arm 10122 through the fourth rotating shaft 101232, so that the second swing arm 10121 and the second support arm 10122 may be mutually pulled to move through the second connector 10123.

In addition, refer to FIG. 12. The main shaft 102 may be provided with a second track slot 1024, and the second connector 10123 can move along the second track slot, to limit a movement track of the second connector 10123. During specific implementation, refer to FIG. 13. The first base 1021 may be provided with a third arc-shaped groove 10213, the second connector 10123 is accommodated in the third arc-shaped groove 10213, and the second connector 10123 can slide along a groove surface of the third arc-shaped groove 10213. In addition, refer to FIG. 14. The first cover plate 1022 includes a third protrusion 10224. The third protrusion 10224 may be disposed facing the third arc-shaped groove 10213 of the first base 1021 in FIG. 13. There is a gap between a surface 102241 of the third protrusion and a groove surface 102131 of the third arc-shaped groove, and the gap serves as the second track slot 1024.

In this application, as shown in FIG. 16, the second connector 10123 may include a third arc-shaped surface 101233 and a fourth arc-shaped surface 101234. When the first housing and the second housing are in the unfolded state and the folded state, the third arc-shaped surface 101233 of the second connector 10123 may abut against the surface 102241 of the third protrusion, and the fourth arc-shaped surface 101234 abuts against the groove surface 102131 of the third arc-shaped groove. In this way, the surface 102241 of the third protrusion and the groove surface 102131 of the third arc-shaped groove limit the second connector 10123 to the second track slot 1024, so that when the hinge mechanism 1 is in the unfolded state and the folded state, a position of the second connector 10123 is stable, and no virtual position shake is generated, to improve structural reliability of the first hinge mechanism 1 in the foregoing two states.

In this embodiment of this application, the third arc-shaped surface 101233 of the second connector 10123 may be disposed with reference to the first arc-shaped surface 101133 of the first connector 10113, and the fourth arc-shaped surface 101234 may be disposed with reference to the second arc-shaped surface 101134 of the first connector 10113. Details are not described herein again. In addition, the second track slot 1024 may be specifically disposed with reference to the first track slot 1023. Simply speaking, the surface 102241 of the third protrusion is equidistant from the groove surface 102131 of the third arc-shaped groove, so that the second track slot 1024 is an equal-width slot. In this case, in the processes in which the electronic device rotates from the unfolded state to the folded state and from the folded state to the unfolded state, the surface 102241 of the third protrusion is always in an abut-against state with the third arc-shaped surface 101233, and the groove surface 102131 of the third arc-shaped groove is always in an abut-against state with the fourth arc-shaped surface 101234. Therefore, during transition of the first housing and the second housing from the unfolded state to the folded state and in a process in which first housing and the second housing rotate from the folded state to the unfolded state, movement tracks of the second connector 10123 in the second track slot 1024 are the same. Alternatively, in the process in which the first housing and the second housing of the electronic device rotate from the unfolded state to the folded state, the third arc-shaped surface 101233 abuts against the surface 102241 of the third protrusion, and there is a gap between the fourth arc-shaped surface 101234 and the groove surface 102131 of the third arc-shaped groove. In the process in which the first housing and the second housing of the electronic device rotate from the folded state to the unfolded state, the fourth arc-shaped surface 101234 abuts against the groove surface 102131 of the third arc-shaped groove, and there is a gap between the third arc-shaped surface 101233 and the surface 102241 of the third protrusion, so that a movement track of the second connector 10123 in the process in which the electronic device rotates from the unfolded state to the folded state is different from a movement track of the second connector 10123 in the process in which the electronic device rotates from the folded state to the unfolded state.

In this application, the second swing arm 10121 is rotatably connected to the main shaft 102. The second swing arm 10121 may be rotatably connected to the main shaft 102 through a virtual shaft. During specific implementation, as shown in FIG. 13, the first base 1021 may be provided with a fourth arc-shaped groove 10214. In addition, refer to FIG. 10 and FIG. 21 together. FIG. 21 may also show a structure of the second swing arm 10121. A second arc-shaped rotating block 101211 is disposed at an end that is of the second swing arm 10121 and that faces the first base 1021. The second arc-shaped rotating block 101211 may be but is not limited to a circular arc-shaped rotating block, and the fourth arc-shaped groove 10214 may be but is not limited to a circular arc-shaped groove. The second arc-shaped rotating block 101211 may be accommodated in the fourth arc-shaped groove 10214, and can slide along the groove surface of the fourth arc-shaped groove 10214. In this way, rotation of the second swing arm 10121 around the first base 1021 is implemented by sliding the second arc-shaped rotating block 101211 along the groove surface of the fourth arc-shaped groove 10214. This can help reduce space occupied by the second swing arm 10121 on the main shaft 102, to help reduce a volume of the first rotating module 101, and implement a miniaturized design of the hinge mechanism 1. It may be understood that, in this embodiment of this application, when the second swing arm 10121 is rotatably connected to the main shaft 102 through a virtual shaft, an axis center of rotation of the second swing arm 10121 around the main shaft 102 is located on a side that is of the first hinge mechanism 1 and that is away from the flexible display.

In addition, in this application, the second arc-shaped rotating block 101211 may be but is not limited to a circular arc-shaped rotating block, and the fourth arc-shaped groove 10214 may be but is not limited to a circular arc-shaped groove. It may be understood that, when the second arc-shaped rotating block 101211 is a circular arc-shaped rotating block, a surface that is of the second arc-shaped rotating block 101211 and that is in contact with the groove surface of the fourth arc-shaped groove 10214 may be a circular arc-shaped surface, the groove surface of the fourth arc-shaped groove 10214 is also a circular arc-shaped surface, and circle centers of the two circular arc-shaped surfaces coincide with each other.

In this application, to improve stability of rotation of the second swing arm 10121 around the main shaft 102, as shown in FIG. 14, the first cover plate 1022 further includes a fourth protrusion 10225 disposed facing the fourth arc-shaped groove 10214, at least a part of the second arc-shaped rotating block 101211 is located between the fourth protrusion 10225 and the fourth arc-shaped groove 10214, and a surface that is of the second arc-shaped rotating block 101211 and that faces the fourth protrusion 10225 may be in contact with a surface 102251 of the fourth protrusion. In this way, the second arc-shaped rotating block 101211 may be limited between the first cover plate 1022 and the first base 1021, and stability of rotation of the second arc-shaped rotating block 101211 relative to the first base 1021 can be effectively improved. In addition, when the groove surface of the fourth arc-shaped groove 10214 is a circular arc-shaped surface, a part that is of the surface 102251 of the fourth protrusion and that is in contact with the second arc-shaped rotating block 101211 may also be a circular arc-shaped surface, and circle centers of the two circular arc-shaped surfaces coincide with each other. In this application, a surface that is of the second arc-shaped rotating block 101211 and that faces the fourth protrusion 10225 may be a plane or a circular arc-shaped surface, provided that the second arc-shaped rotating block 101211 can rotate relative to the fourth protrusion 10225 in a process in which the second arc-shaped rotating block 101211 slides along the groove surface of the fourth arc-shaped groove 10214.

To improve reliability of a connection between the second swing arm 10121 and the first base 1021, the second arc-shaped rotating block 101211 may further be provided with a second recess 1012111, and an opening of the second recess 1012111 is disposed facing the first cover plate 1022. In addition, a second insertion part may be disposed on an end part that is of the first cover plate 1022 and that faces the second housing fastening bracket 1014. In this case, in the folded state, the second insertion part may be inserted into the second recess 1012111, and a surface that is of the second insertion part and that faces the fourth arc-shaped groove 10214 abuts against at least a part of a surface of the second recess 1012111. This can limit a rotation part of the second arc-shaped rotating block 101211, and avoid detachment of the second arc-shaped rotating block 101211 from the fourth arc-shaped groove 10214.

It should be noted that, in this application, in addition to being rotatably connected to the main shaft 102 through a virtual shaft, the second swing arm 10121 may be rotatably connected to the main shaft 102 through a solid shaft, so that the first swing arm 10111 can be connected to the main shaft 102 reliably. In this embodiment of this application, when the second swing arm 10121 is rotatably connected to the main shaft 102 through a solid shaft, an axis center of rotation of the second swing arm 10121 around the main shaft 102 is also located on a side that is of the first hinge mechanism 1 and that is away from the flexible display.

Specifically, when the second connector 10123 is rotatably connected to the second swing arm 10121 through the third rotating shaft 101231, still refer to FIG. 15. The second arc-shaped rotating block 101211 is provided with a second mounting slot 1012112, and a slot opening of the second mounting slot 1012112 is disposed facing the fourth arc-shaped groove 10214. In this case, the third rotating shaft 101231 may be mounted in the second mounting slot 1012112, a part of the surface of the third rotating shaft 101231 may be in contact with a slot surface of the second mounting slot 1012112, and a part of the surface of the third rotating shaft 101231 is in contact with the groove surface of the fourth arc-shaped groove 10214, to limit the third rotating shaft 101231 in the second mounting slot 1012112.

As shown in FIG. 21, in this application, the slot surface of the second mounting slot 1012112 may include a fifth circular arc-shaped surface 10121121. As shown in FIG. 16, the surface that is of the third rotating shaft 101231 and that is in contact with the slot surface of the second mounting slot 1012112 is a sixth circular arc-shaped surface 1012311, and a circle center of the fifth circular arc-shaped surface 10121121 coincides with a circle center of the sixth circular arc-shaped surface 1012311. In addition, the groove surface of the fourth arc-shaped groove 10214 is a seventh circular arc-shaped surface 102141, the surface that is of the third rotating shaft 101231 and that is in contact with the groove surface of the fourth arc-shaped groove 10214 may be an eighth circular arc-shaped surface 1012312, and a circle center of the seventh circular arc-shaped surface 102141 coincides with a circle center of the eighth circular arc-shaped surface 1012312. In this way, when the third rotating shaft 101231 slides along the groove surface of the fourth arc-shaped groove 10214 with the second arc-shaped rotating block 101211, the third rotating shaft 101231 may further rotate relative to the second arc-shaped rotating block 101211, to facilitate movement of the second connector 10123 relative to the main shaft 102.

In this embodiment of this application, specifically, when the second connector 10123 is rotatably connected to the second support arm 10122 through the fourth rotating shaft 101232, the fourth rotating shaft 101232 may penetrate both the second connector 10123 and the second support arm 10122. In this case, a connection manner of the second connector 10123 and the second support arm 10122 is simple. This helps simplify a structure of the second rotating assembly 1012, so that a structure of the hinge mechanism can be simplified.

It may be understood that, in the first hinge mechanism 1 provided in embodiments of this application, the second connector 10123 may include a plurality of second sub-connectors that are sequentially rotatably connected to each other. In addition, the plurality of second sub-connectors may be located between the second swing arm 10121 and the second support arm 10122. In this case, the second swing arm 10121 may be rotatably connected to an adjacent second sub-connector, and the second support arm 10122 may be rotatably connected to an adjacent second sub-connector. For how the second swing arm 10121 is rotatably connected to the adjacent second sub-connector and how the second support arm 10122 is rotatably connected to the adjacent second sub-connector, refer to the foregoing descriptions of the rotational connections of the second swing arm 10121 and the second support arm 10122 to the second connector 10123. Details are not described herein again. In this application, the second connector 10123 is disposed as the plurality of second sub-connectors that are sequentially rotatably connected to each other, so that the second swing arm 10121 is rotatably connected to the second support arm 10122 through the plurality of second sub-connectors. This can effectively improve speed uniformity in a process in which the second swing arm 10121 and the second support arm 10122 rotate around the main shaft 102, to improve smoothness of mutual pulling movement of the second swing arm 10121 and the second support arm 10122.

In this application, the second swing arm 10121 may be slidably connected to the second housing fastening bracket 1014. During specific implementation, the second housing fastening bracket 1014 is provided with a second sliding slot 10141. The second sliding slot 10141 and the second mounting part 10142 are spaced from each other in a length direction of the first hinge mechanism 1. The second sliding slot 10141 extends in a second direction, and the second swing arm 10121 may be mounted in the second sliding slot 10141, and may slide in the second sliding slot 10141 in the second direction. The second direction may be a direction in which the second housing fastening bracket 1014 moves in a direction toward or away from the first base 1021. In addition, a second sliding rail may be disposed on a slot wall of the second sliding slot 10141, and a second sliding block may be disposed on the second swing arm 10121, to avoid detachment of the second swing arm 10121 from the second sliding slot 10141. In this way, the second sliding block may be clamped on the second sliding rail, and the second sliding block can slide along the second sliding rail, to limit the second swing arm 10121 in the second sliding slot 10141. In addition, the second sliding rail is disposed on the slot wall of the second sliding slot 10141, to guide sliding of the second swing arm 10121 along the second sliding slot 10141, so as to improve movement stability of the second swing arm 10121.

In addition, the second support arm 10122 may be rotatably connected to the first housing fastening bracket 1013. During specific implementation, the first housing fastening bracket 1013 is provided with a first mounting part 10132. In the length direction of the first hinge mechanism 1, the first mounting part 10132 and the first sliding slot 10131 are spaced from each other. An end part that is of the second support arm 10122 and that faces the first housing fastening bracket 1013 is mounted on the first mounting part 10132, and an end part that is of the second support arm 10122 and that faces the first housing fastening bracket 1013 is rotatably connected to the first mounting part 10132.

In embodiments of this application, a specific manner in which the end part that is of the second support arm 10122 and that faces the first housing fastening bracket 1013 is rotatably connected to the first mounting part 10132 is not limited. For example, still refer to FIG. 10. The first mounting part 10132 may be provided with a third mounting hole, and an end part that is of the second support arm 10122 and that faces the first housing fastening bracket 1013 is provided with a fourth mounting hole. In this case, the end part that is of the second support arm 10122 and that faces the first housing fastening bracket 1013 may be rotatably connected to the first mounting part 10132 through a rotating shaft that penetrates both the third mounting hole and the fourth mounting hole.

Based on the first hinge mechanism 1 provided in the foregoing embodiments of this application, during the transition of the first housing and the second housing from the unfolded state to the folded state, the first housing fastening bracket 1013 and the second housing fastening bracket 1014 move toward each other. When the second housing fastening bracket 1014 drives the second swing arm 10121 to rotate around the main shaft 102 counterclockwise, the second swing arm 10121 may drive the second connector 10123 to move toward the second swing arm 10121 in the second track slot 1024 of the main shaft 102. In addition, because the second connector 10123 is rotatably connected to the second support arm 10122, in the process in which the second connector 10123 moves toward the second swing arm 10121 in the second track slot 1024 of the main shaft 102, the second support arm 10122 may be driven to rotate around the main shaft 102 clockwise, so that the second support arm 10122 drives the first housing fastening bracket 1013 to rotate around the main shaft 102 clockwise. During the transition of the first housing and the second housing from the folded state to the unfolded state, the first housing fastening bracket 1013 and the second housing fastening bracket 1014 move away from each other. When the second housing fastening bracket 1014 drives the second swing arm 10121 to rotate around the main shaft 102 clockwise, the second swing arm 10121 may drive the second connector 10123 to move toward the second support arm 10122 in the second track slot 1024 of the main shaft 102, and the second support arm 10122 may be driven to rotate around the main shaft 102 counterclockwise, so that the second support arm 10122 drives the first housing fastening bracket 1013 to rotate around the main shaft 102 counterclockwise. In this way, folding and unfolding functions of the first hinge mechanism 1 are implemented.

For some existing hinge mechanisms, to ensure stability of the mechanisms, a thickness of a rotating assembly connected to the main shaft needs to be increased. In this way, both the main shaft and the hinge mechanism are very heavy. Forced thinning is likely to diminish strength of the rotating assembly, thereby greatly affecting reliability of the hinge mechanisms and shortening a service life of the electronic device. The first hinge mechanism 1 in this application has a simplified structure. Based on the foregoing structural relationship, the second connector 10123 may be made with a small cross section to travel back and forth in the second track slot 1024 of the main shaft 102. In addition, the second connector 10123 has a sufficient length extension in a direction perpendicular to an axial direction, and separately has a connection relationship with the second swing arm 10121 and the second support arm 10122, so that reliability of the first hinge mechanism 1 can be ensured. In this way, not only can a thickness of the main shaft 102 and a thickness of the entire electronic device be reduced, but also reliability of the first hinge mechanism 1 can be maintained, so that the entire first hinge mechanism 1 is light, thin, and reliable.

Because the second connector 10123 can move based on a specified track, uncontrolled movement of the second connector 10123 in an entire folding and unfolding process can be avoided, and random movement of the first housing fastening bracket 1013 and the second housing fastening bracket 1014 can also be avoided, to ensure structural stability and movement stability of the entire first hinge mechanism 1. In some cases, the second track slot 1024 may be properly designed, so that an outer tangent line of the first hinge mechanism 1 can keep a constant length in the entire folding and unfolding process, and a part that is of the flexible display and that covers a surface of the first hinge mechanism 1 can also basically keep a length unchanged. In this way, squeezing or pulling on the flexible display can be effectively avoided, to improve structural reliability of the flexible display and further improve structural reliability of the electronic device.

FIG. 23 is a diagram of a partial structure of the first hinge mechanism 1 according to an embodiment of this application, and the main shaft 102 is omitted in FIG. 13, to describe a mutual pulling movement relationship between the first rotating assembly 1011 and the second rotating assembly 1012. In this application, the first swing arm 10111 is slidably connected to the first housing fastening bracket 1013, the first support arm 10112 is rotatably connected to the second housing fastening bracket 1014, and the first swing arm 10111 may pull, through the first connector 10113, the first support arm 10112 to move based on a specified track; and the second swing arm 10121 is slidably connected to the second housing fastening bracket 1014, the second support arm 10122 is rotatably connected to the first housing fastening bracket 1013, and the second swing arm 10121 may pull, through the second connector 10123, the second support arm 10122 to move based on a specified track. In this way, movement distances of the first housing fastening bracket 1013 and the second housing fastening bracket 1014 in a direction toward or away from the main shaft 102 can be limited, so that when the first housing and the second housing are in any folded state, the first housing fastening bracket 1013 and the second housing fastening bracket 1014 are equidistant from the main shaft 102. In addition, during transition of the first housing and the second housing from the unfolded state to the folded state, and during transition of the first housing and the second housing from the folded state to the unfolded state, movement distances of the first housing fastening bracket 1013 relative to the main shaft 102 may be equal, and movement distances of the second housing fastening bracket 1014 relative to the main shaft 102 may be equal. Therefore, when the first hinge mechanism 1 is used in an electronic device, an extension length of a support surface formed by the first housing 3, the second housing 4, and the first hinge mechanism 1 in the unfolded state can adapt to an unfolded length of a corresponding part of the flexible display, and folding requirements of a part that is of the flexible display and that is disposed corresponding to the first hinge mechanism can be met when the first housing and the second housing are in the folded state. This can avoid deformation of the flexible display, reduce squeezing or pulling stress on the flexible display, prolong a service life of the flexible display, and improve reliability of the electronic device.

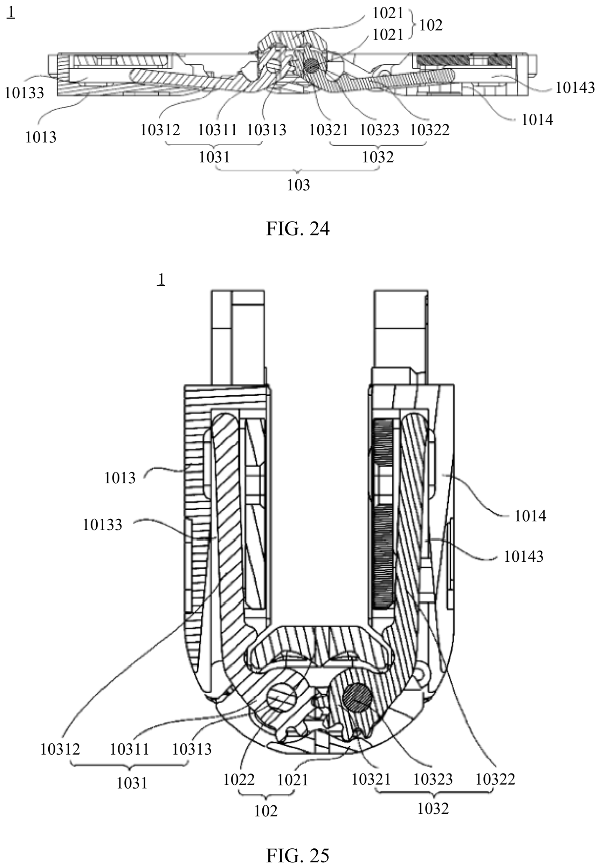

It may be understood that, during the unfolding and folding processes of the first housing and the second housing, the first housing 3 and the second housing 4 can be synchronously moved to effectively reduce a risk of instantaneous squeezing or pulling stress on the flexible display. In view of this, the first hinge mechanism 1 provided in this embodiment of this application may further include a first synchronization assembly 103. During specific implementation, refer to FIG. 24. FIG. 24 is a cross-sectional view of the first hinge mechanism 1 at the first synchronization assembly 103 when the first housing and the second housing are in an unfolded state according to an embodiment of this application. The first synchronization assembly 103 may include a first gear connecting rod 1031 and a second gear connecting rod 1032. The first gear connecting rod 1031 and the second gear connecting rod 1032 are rotatably connected to the main shaft 102. During specific implementation, the first gear connecting rod 1031 includes a first gear 10311 and a first connecting rod 10312, and the first gear 10311 may be rotatably connected to the main shaft 102 through a fifth rotating shaft 10313, to improve stability of rotation of the first gear connecting rod 1031 around the main shaft 102, where an extension direction of an axis of the fifth rotating shaft 10313 is the same as the length direction of the hinge mechanism 1. In addition, the first housing fastening bracket 1013 is further provided with a third sliding slot 10133, the third sliding slot 10133 and the first sliding slot 10131 are spaced from each other, and the first connecting rod 10312 is mounted in the third sliding slot 10133 and may slide in the third sliding slot 10133 relative to the first housing fastening bracket 1013 in a direction toward or away from the first base 1021, to implement a slidable connection between the first connecting rod 10312 and the first housing fastening bracket 1013.

Similarly, the second gear connecting rod 1032 may include a second gear 10321 and a second connecting rod 10322. The second gear 10321 may be rotatably connected to the main shaft 102 through a sixth rotating shaft 10323, to improve stability of rotation of the second gear connecting rod 1032 around the main shaft 102. An axis of the sixth rotating shaft 10323 is parallel to an axis of the fifth rotating shaft 10313. In addition, in this application, the second gear 10321 is in a transmission connection to the first gear 10311. In this application, the transmission connection between the second gear 10321 and the first gear 10311 may be implemented through engagement between the second gear 10321 and the first gear 10311. Alternatively, an intermediate gear may be disposed between the first gear 10311 and the second gear 10321, so that the first gear 10311 and the second gear 10321 are separately engaged with an adjacent intermediate gear to implement the transmission connection between the first gear 10311 and the second gear 10321.

In addition, the second housing fastening bracket 1014 is further provided with a fourth sliding slot 10143, the fourth sliding slot 10143 and the second sliding slot 10141 are spaced from each other, and the second connecting rod 10322 is mounted in the fourth sliding slot 10143 and may slide in the fourth sliding slot 10143 relative to the second housing fastening bracket 1014 in a direction toward or away from the first base 1021, to implement a slidable connection between the second connecting rod 10322 and the second housing fastening bracket 1014.

Based on the above description of the structure of the first synchronization assembly 103, refer to FIG. 24 and FIG. 25 together. FIG. 25 is a cross-sectional view of the first hinge mechanism 1 at the first synchronization assembly 103 when the first housing and the second housing are in a folded state according to an embodiment of this application. During transition of the first housing and the second housing from an unfolded state to the folded state, the first housing fastening bracket 1013 can rotate to drive the first gear connecting rod 1031 to rotate around the first base 1021. In addition, because the first gear 10311 of the first gear connecting rod 1031 is in a transmission connection to the second gear 10321 of the second gear connecting rod 1032, the first gear connecting rod 1031 may rotate to drive the second gear connecting rod 1032 to rotate toward the first gear connecting rod 1031, and the second gear connecting rod 1032 slides along the fourth sliding slot 10143 of the second housing fastening bracket 1014 to drive the second housing fastening bracket 1014 to rotate in the same direction. In this way, the first housing fastening bracket 1013 and the second housing fastening bracket 1014 synchronously rotate toward each other. In addition, during transition of the first housing and the second housing from the folded state to the unfolded state, movement directions of the structures are opposite to the movement directions in the process in which the first housing 3 and the second housing 4 rotate from the unfolded state to the folded state, so that the first housing fastening bracket 1013 and the second housing fastening bracket 1014 synchronously rotate away from each other. Details are not described herein again.

According to the first hinge mechanism 1 provided in this application, a rotation function of the first hinge mechanism 1 may be implemented through mutual pulling of the connecting rods. In addition, the two housing fastening brackets may synchronously rotate toward or away from each other by disposing the first synchronization assembly 103. In addition, because structures of mechanisms for implementing the rotation function and a synchronization function of the first hinge mechanism 1 are simple, and the structure of the entire first hinge mechanism 1 can be effectively simplified, to help implement a miniaturized design of the first hinge mechanism 1 and reduce costs of the first hinge mechanism 1. Moreover, because the mechanisms for implementing the rotation function and the synchronization function of the first hinge mechanism 1 are two independent mechanisms, a failure of either mechanism does not affect the implementation of the functions of the other mechanism, and the reliability of the first hinge mechanism 1 can be effectively improved.

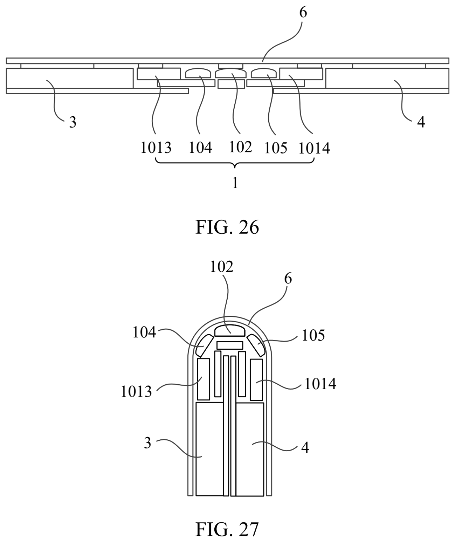

The foregoing describes in detail some possible design manners of the first hinge mechanism 1 of the electronic device provided in embodiments of this application. Based on the design principle of the first hinge mechanism 1, some adaptive deformations may be made to a specific structure of the first hinge mechanism 1 based on an actual application. For example, FIG. 26 is a diagram of another connection relationship among the first housing 3, the second housing 4, and the first hinge mechanism 1 of the electronic device in the unfolded state according to an embodiment of this application. In the electronic device shown in FIG. 26, the first hinge mechanism 1 further includes a first under-display support 104 and a second under-display support 105. The first under-display support 104 is located between the first housing fastening bracket 1013 and the main shaft 102, and the second under-display support 105 is located between the second housing fastening bracket 1014 and the main shaft 102. When the electronic device is in the unfolded state shown in FIG. 26, the first under-display support 104 and the second under-display support 105 are configured to support the flexible display 6 flatly.

In addition, FIG. 27 is a diagram of a structure of the structure shown in FIG. 26 in the folded state. Refer to FIG. 26 and FIG. 27 together. It may be understood that in a process in which the first housing 3 and the second housing 4 rotate from an unfolded state to the folded state, the first under-display support 104 and the second under-display support 105 rotate toward each other around the main shaft 102. When the first housing 3 and the second housing 4 are in the folded state shown in FIG. 27, the first under-display support 104 and the second under-display support 105 may be configured to support a bent part of the flexible display 6. This helps improve support reliability of the first hinge mechanism 1 for the flexible display 6.

It should be understood that, to implement the foregoing form of the electronic device, in this application, how the first hinge mechanism 1 is designed is not limited to that mentioned in the foregoing embodiment, provided that the first hinge mechanism 1 can implement the following states. Details are as follows.

When the first housing 3 and the second housing 4 are in the unfolded state, the support surface 1a of the first hinge mechanism, the support surface 3a of the first housing, and the support surface 4a of the second housing may jointly support the flexible display 6 flatly. In a process in which the first housing 3 and the second housing 4 rotate from the unfolded state to the folded state, the first housing 3 and the second housing 4 may rotate toward each other to drive the flexible display 6 to bend. In a process in which the first housing 3 and the second housing 4 rotate from the folded state to the unfolded state, the first housing 3 and the second housing 4 may rotate away from each other to drive the flexible display 6 to unfold.

The foregoing describes an example design manner of the first hinge mechanism 1 of the electronic device provided in embodiments of this application. Then, an example design manner of the second hinge mechanism 2 of the electronic device provided in embodiments of this application is specifically described.

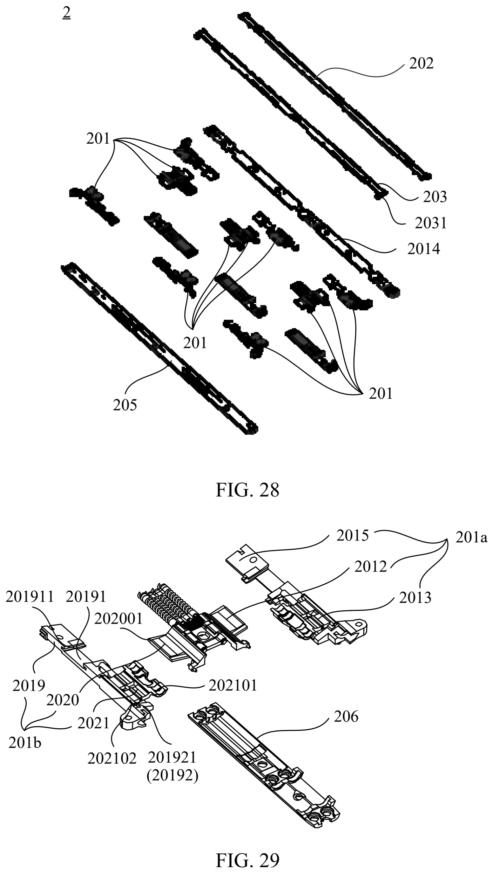

FIG. 28 is a diagram of an exploded structure of the second hinge mechanism 2 according to an embodiment of this application. In this application, the second hinge mechanism 2 may include one second rotating module 201, or may include a plurality of second rotating modules 201. For example, the second hinge mechanism 2 shown in FIG. 28 includes three second rotating modules 201. The three second rotating modules 201 may be arranged and spaced from each other in a length direction of the second hinge mechanism 2. In this application, the length direction of the second hinge mechanism 2 is an extension direction of an axis of rotation of the second housing 4 and the third housing 5 around the second hinge mechanism 2. The second housing 4 is rotatably connected to the third housing 5 through the plurality of second rotating modules 201. In this way, stability of rotation of the second housing 4 and the third housing 5 of the electronic device relative to the second hinge mechanism 2 can be effectively improved.

When the second rotating module 201 is specifically disposed, refer to FIG. 29. FIG. 29 is an exploded view of a partial structure of the second hinge mechanism 2 according to a possible embodiment of this application. Refer to FIG. 28 and FIG. 29 together. In this application, the second rotating module 201 may include a third rotating assembly 201a and a fourth rotating assembly 201b.

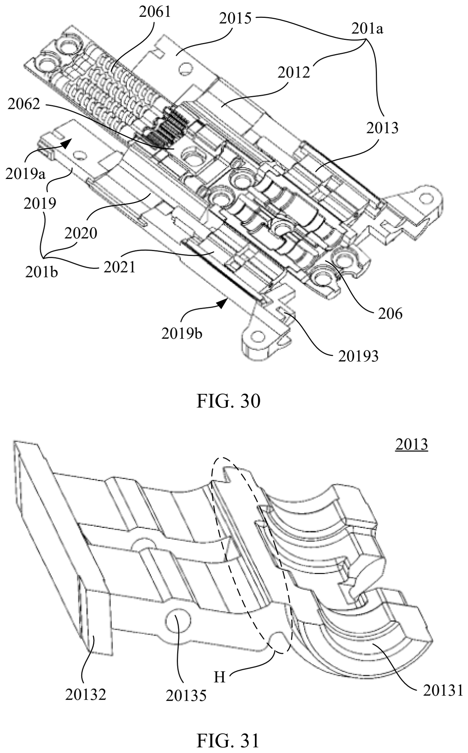

FIG. 30 is a diagram of a partial structure of the second hinge mechanism 2 according to a possible embodiment of this application. In this application, the second hinge mechanism 2 may further include a second base 206. In addition, refer to FIG. 29 and FIG. 30 together. The second base 206 may be used as a bearing component of the third rotating assembly 201a and the fourth rotating assembly 201b. The third rotating assembly 201a and the fourth rotating assembly 201b are respectively disposed on two sides of the second base 206, and the third rotating assembly 201a and the fourth rotating assembly 201b may be symmetrically disposed relative to the second base 206. For ease of description, in the following embodiments of this application, the second rotating module 201 is described mainly by using a specific disposition manner of the third rotating assembly 201a and a connection relationship between the third rotating assembly 201a and the second base 206 as an example. The fourth rotating assembly 201b side may be disposed with reference to the third rotating assembly 201a side.

It should be noted that, in a possible embodiment of this application, when there are a plurality of second rotating modules 201, third rotating assemblies 201a and fourth rotating assemblies 201b of the plurality of second rotating modules 201 may all use a same second base 206 as a bearing component, to improve integration of the second hinge mechanism 2. In some other possible embodiments of this application, the second hinge mechanism 2 may be separately disposed with one second base 206 corresponding to each second rotating module 201, so that the third rotating assembly 201a and the fourth rotating assembly 201b of each second rotating module 201 use the corresponding second base 206 as a bearing component.

Still refer to FIG. 30. In this application, the third rotating assembly 201a may include a third support arm 2012. The third support arm 2012 may be rotatably connected to the second base 206. For example, the third support arm 2012 may be rotatably connected to the second base 206 through a pin shaft 2061. During specific implementation, the second base 206 may be provided with a damping bracket 2062, and the pin shaft 2061 may penetrate both the damping bracket 2062 and the third support arm 2012, so that the third support arm 2012 is rotatably connected to the second base 206 through the rotational connection between the third support arm 2012 and the damping bracket 2062 through the pin shaft 2061.

It should be noted that, in this application, the third support arm 2012 may be rotatably connected to the damping bracket 2062 through the pin shaft 2061. In some possible embodiments, the third support arm 2012 may alternatively be rotatably connected to the damping bracket 2062 through a virtual shaft. For example, an arc-shaped groove may be provided on the damping bracket 2062, and an arc-shaped rotating block is disposed on the third support arm 2012, so that the third support arm 2012 rotates with the damping bracket 2062 by sliding the arc-shaped rotating block along a groove surface of the arc-shaped groove.

In this application, the third rotating assembly 201a may further include a third swing arm 2013, and the third swing arm 2013 is rotatably connected to the second base 206. In a possible embodiment of this application, the third swing arm 2013 may be rotatably connected to the second base 206 through a virtual shaft. For example, FIG. 31 is a diagram of a structure of the third swing arm 2013 according to a possible embodiment of this application. A third arc-shaped rotating block 20131 may be disposed at an end that is of the third swing arm 2013 and that is configured to connect to the second base 206.

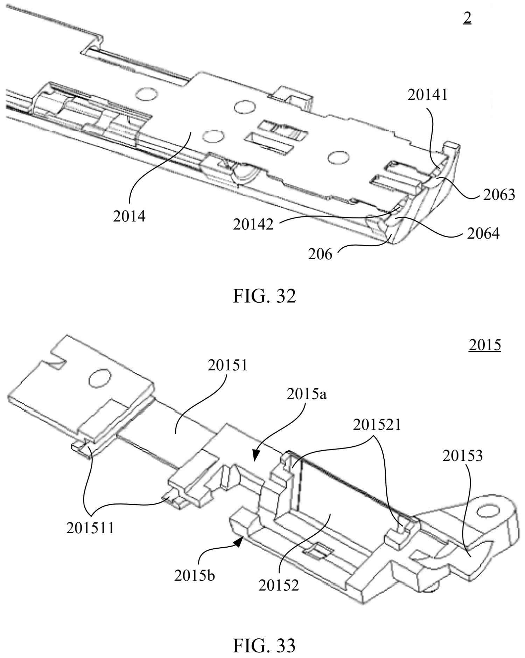

In addition, FIG. 32 is a diagram of a partial structure of the second hinge mechanism. A fifth arc-shaped groove 2063 may be provided on the second base 206. The third arc-shaped rotating block 20131 of the third swing arm 2013 shown in FIG. 31 may be accommodated in the fifth arc-shaped groove 2063, and may rotate around an arc-shaped surface of the fifth arc-shaped groove 2063, to rotate the third swing arm 2013 around the second base 206. The third swing arm 2013 is rotatably connected to the second base 206 through a virtual shaft. This can help reduce space occupied by the third swing arm 2013 on the second base 206, thereby helping reduce a volume of the second rotating module 201, and helping implement a miniaturized design of the second hinge mechanism 2. It should be noted that, in this application, the third arc-shaped rotating block 20131 may be but is not limited to a circular arc-shaped rotating block, and the fifth arc-shaped groove 2063 may be but is not limited to a circular arc-shaped groove.

Refer to FIG. 32. The second hinge mechanism 2 may further include a second cover plate 2014, and the second cover plate 2014 may cover the second base 206, to form accommodation space between the second cover plate 2014 and the second base 206. It should be noted that, in this application, a second cover plate 2014 may be separately disposed for each second rotating module 201, to make a structure of the second rotating module 201 flexible. Alternatively, a plurality of second rotating modules 201 may share one second cover plate 2014, to simplify a structure of the second hinge mechanism 2. In addition, it can be learned from FIG. 32 that a first arc-shaped protrusion 20141 may be disposed on a surface that is of the second cover plate 2014 and that faces the fifth arc-shaped groove 2063. The third arc-shaped rotating block 20131 of the third swing arm 2013 shown in FIG. 31 may be inserted between the first arc-shaped protrusion 20141 and the fifth arc-shaped groove 2063. In this way, the first arc-shaped protrusion 20141 limits the third arc-shaped rotating block 20131 of the third swing arm 2013 in the fifth arc-shaped groove 2063 of the second base 206, to reduce a risk of detaching the third swing arm 2013 from the second base 206, thereby improving movement reliability of the third swing arm 2013.

In another possible embodiment of this application, the fifth arc-shaped groove 2063 may be of an integrated channel structure directly disposed on the second base 206. In this way, an integrated design of the second base 206 can be implemented, to improve structural reliability of the hinge mechanism. In addition, a quantity of fifth arc-shaped grooves 2063 may be but is not limited to at least two. The at least two fifth arc-shaped grooves 2063 may be spaced from each other in a length direction of the second base 206, and the at least two fifth arc-shaped grooves 2063 may limit the third arc-shaped rotating block 20131, to improve reliability of a connection between the third arc-shaped rotating block 20131 and the second base 206.

In some other embodiments of this application, the third swing arm 2013 may be rotatably connected to the second base 206 through a solid shaft alternatively. For example, the third swing arm 2013 may be rotatably connected to the second base 206 through a pin shaft. In this way, when the hinge mechanism includes a plurality of second rotating modules 201, the third swing arm 2013 of at least one of the plurality of second rotating modules 201 may be rotatably connected to the second base 206 through a virtual shaft. In addition, the third swing arm 2013 of the at least one second rotating module 201 is rotatably connected to the second base 206 through a solid shaft. In this case, the third swing arm 2013 of the second rotating module 201 that is disposed opposite to the flexible display 6 of the electronic device may be rotatably connected to the second base 206 through a virtual shaft. In this way, the third swing arm 2013 of the main shaft assembly 101 located at the two end parts in the length direction of the hinge mechanism is rotatably connected to the second base 206 through a solid shaft.

Refer to FIG. 30. In this application, the third rotating assembly 201a may further include a third housing fastening bracket 2015. The third housing fastening bracket 2015 is fastened to the second housing 4, and the third housing fastening bracket 2015 may be connected to the third support arm 2012 and the third swing arm 2013.

When the third housing fastening bracket 2015 is specifically disposed, refer to FIG. 33. FIG. 33 is a diagram of a structure of the third housing fastening bracket 2015 according to a possible embodiment of this application. In this embodiment, a fifth sliding slot 20151 may be provided on the third housing fastening bracket 2015, and the fifth sliding slot 20151 extends in a first direction A. Refer to FIG. 30 and FIG. 33 together. The third support arm 2012 may be mounted in the fifth sliding slot 20151 and may slide in the fifth sliding slot 20151. The first direction A may be a direction in which the third housing fastening bracket 2015 moves in a direction toward or away from the second base 206. In addition, a first sliding rail 201511 may be disposed on a slot wall of the fifth sliding slot 20151, and a first sliding block 20121 may be disposed on the third support arm 2012, to avoid detachment of the third support arm 2012 from the fifth sliding slot 20151. In this way, the first sliding block 20121 may be clamped on the first sliding rail 201511, and the first sliding block 20121 may slide along the first sliding rail 201511, to limit the third support arm 2012 in the fifth sliding slot 20151. In addition, the first sliding rail 201511 is disposed on the slot wall of the fifth sliding slot 20151, to guide sliding of the third support arm 2012 along the fifth sliding slot 20151, so as to improve movement stability of the third support arm 2012.

Still refer to FIG. 33. The third housing fastening bracket 2015 may further be provided with a sixth sliding slot 20152. The sixth sliding slot 20152 may extend in a second direction B, and the fifth sliding slot 20151 and the sixth sliding slot 20152 are spaced from each other in a length direction of the third housing fastening bracket 2015. Refer to FIG. 31 and FIG. 33 together. An end part that is of the third swing arm 2013 and that faces the third housing fastening bracket 2015 may be mounted in the sixth sliding slot 20152, and the third swing arm 2013 may slide in the sixth sliding slot 20152. It should be noted that, in this application, the third housing fastening bracket 2015 may include a first surface 2015a and a second surface 2015b that are disposed opposite to each other. The first surface 2015a may be a surface of a side that is of the third housing fastening bracket 2015 and that faces the flexible display 6 when the second hinge mechanism 2 is used in the electronic device. In this case, the second direction B may be a direction from the first surface 2015a to the second surface 2015b or a direction from the second surface 2015b to the first surface 2015a. In addition, a projection of the second direction B in a first cross section may not be parallel to a projection of the first direction A in the first cross section. The first cross section may be a reference plane perpendicular to a rotation axis of the third support arm 2012 and a rotation axis of the third swing arm 2013.

In addition, still refer to FIG. 33. In this application, a second sliding rail 201521 may alternatively be disposed in the sixth sliding slot 20152, and a second sliding block 20132 may be disposed on the third swing arm 2013 shown in FIG. 31. In this way, the second sliding block 20132 may be clamped on the second sliding rail 201521, and the second sliding block 20132 may slide in the second sliding rail 201521 in the second direction B, to limit the third swing arm 2013 in the sixth sliding slot 20152, so as to avoid detachment of the third swing arm 2013 from the sixth sliding slot 20152. In addition, the second sliding rail 201521 is disposed on the slot wall of the sixth sliding slot 20152, to guide sliding of the third swing arm 2013 along the sixth sliding slot 20152, so as to improve movement stability of the third swing arm 2013.

It can be learned from the foregoing that, in this application, the fourth rotating assembly 201b may be symmetrically disposed relative to the third rotating assembly 201a with respect to the second base 206. During specific implementation, refer to FIG. 28 and FIG. 30. The fourth rotating assembly 201b may include a fourth housing fastening bracket 2019, a fourth support arm 2020, and a fourth swing arm 2021. The fourth housing fastening bracket 2019 is fastened to the third housing 5, and the fourth housing fastening bracket 2019 has a third surface 2019a and a fourth surface 2019b that are disposed opposite to each other. When the second hinge mechanism is used in the electronic device, the third surface 2019a is a surface that is of the fourth housing fastening bracket 2019 and that faces the flexible display 6. In addition, the fourth housing fastening bracket 2019 may include a seventh sliding slot 20191 extending in a third direction C and an eighth sliding slot 20192 extending in a fourth direction D. The fourth support arm 2020 may slide in the seventh sliding slot 20191, and the fourth swing arm 2021 may slide in the eighth sliding slot 20192. A projection of the third direction C in the second cross section is not parallel to a projection of the fourth direction D in the second cross section. The second cross section is a reference plane perpendicular to a rotation axis of the fourth support arm 2020 and a rotation axis of the fourth swing arm 2021.

In addition, still refer to FIG. 29. The seventh sliding slot 20191 may be provided with a third sliding rail 201911, the fourth support arm 2020 may be provided with a third sliding block 202001, the eighth sliding slot 20192 may be provided with a fourth sliding rail 201921, and the fourth swing arm 2021 may be provided with a fourth sliding block 202102. For how the third sliding rail 201911 is disposed, refer to the first sliding rail 201511. For how the third sliding block 202001 is disposed, refer to the first sliding block 20121. For how the fourth sliding rail 201921 is disposed, refer to the second sliding rail 201521. For how the fourth sliding block 202102 is disposed, refer to the second sliding block 20132. Details are not described herein again.

In this application, the fourth swing arm 2021 may be disposed with reference to the third swing arm 2013 shown in FIG. 31. To implement a rotational connection between the fourth swing arm 2021 and the second base 206, refer to FIG. 32. The second base 206 includes a sixth arc-shaped groove 2064, and a fourth arc-shaped rotating block 202101 is disposed on the fourth swing arm 2021 (refer to FIG. 29). In addition, still refer to FIG. 32. A second arc-shaped protrusion 20142 may be disposed on a surface that is of the second cover plate 2014 and that faces the sixth arc-shaped groove 2064. The sixth arc-shaped groove 2064 may be provided with reference to the fifth arc-shaped groove 2063, the fourth arc-shaped rotating block 202101 may be disposed with reference to the third arc-shaped rotating block 20131, and the second arc-shaped protrusion 20142 may be disposed with reference to the first arc-shaped protrusion 20141. Details are not described herein again.

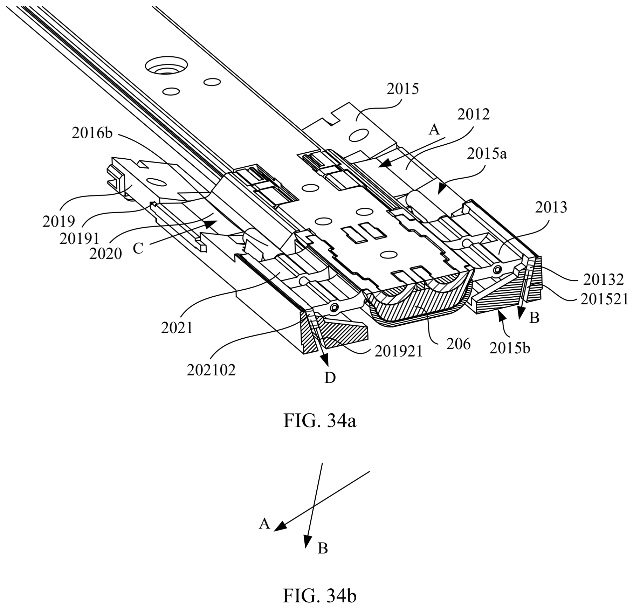

After a connection relationship among the third rotating assembly 201a, the fourth rotating assembly 201b and the second base 206 provided in the foregoing embodiments of this application is understood, the following describes movement of the hinge mechanism. First, FIG. 34a is a diagram of a structure of the second hinge mechanism in the unfolded state. In this case, a spacing between an edge that is of the third housing fastening bracket 2015 and that faces the second base 206 and the second base 206 is the shortest, and a spacing between the second sliding block 20132 of the third swing arm 2013 and the first surface 2015a of the third housing fastening bracket 2015 is the shortest.

It can be learned from the descriptions of the foregoing embodiments that when the second housing 4 and the third housing 5 rotate from the unfolded state to the folded state, the third support arm 2012 may slide in the fifth sliding slot 20151 in the first direction A, and the third swing arm 2013 may slide in the sixth sliding slot 20152 in the second direction B. Similarly, the fourth support arm 2020 may slide in the seventh sliding slot 20191 in the third direction C, and the fourth swing arm 2021 may slide in the eighth sliding slot 20192 in the fourth direction D.

In addition, FIG. 34b is a diagram of the first cross section according to a possible embodiment. In the first cross section, the first direction A and the second direction B intersect, and an angle at which the first direction A and the second direction B intersect may be an acute angle in the figure, or may be another possible angle, for example, a right angle or an obtuse angle. In addition, in the second cross section, a position relationship between the third direction C and the fourth direction D may be symmetrical with a position relationship between the first direction A and the second direction B shown in FIG. 34b. Details are not described herein again.

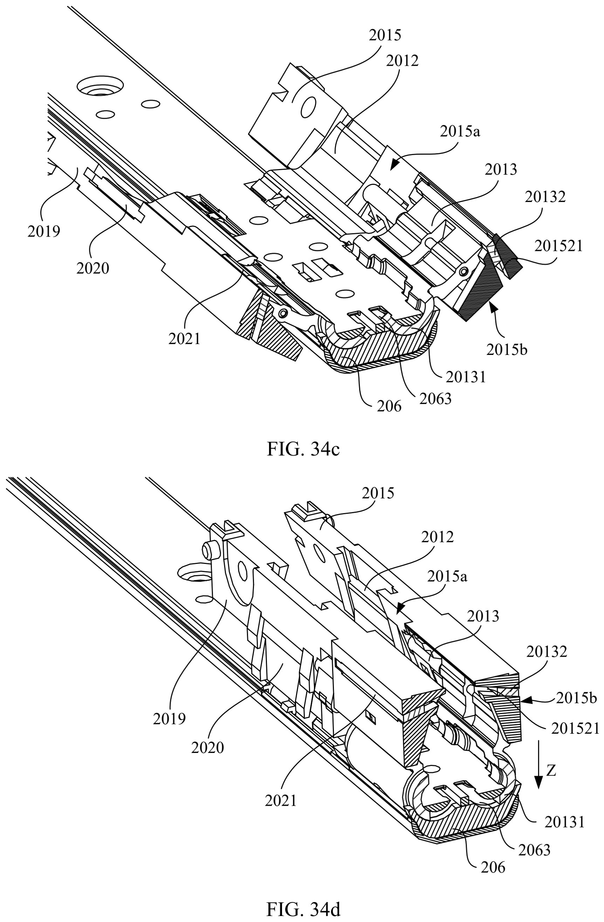

FIG. 34c is a diagram of a structure when the second housing 4 and the third housing 5 are in the intermediate state. It can be learned by comparing FIG. 34c with FIG. 34a that in this process, the third housing fastening bracket 2015 may move relative to the third support arm 2012 in a direction away from the second base 206, and drive the third support arm 2012 and the third swing arm 2013 to rotate around the second base 206. The third arc-shaped rotating block 20131 of the third swing arm 2013 moves in a direction of sliding out of the corresponding fifth arc-shaped groove 2063, so that a part that is of the third arc-shaped rotating block 20131 and that is accommodated in the corresponding fifth arc-shaped groove 2063 is reduced. In addition, the second sliding block 20132 of the third swing arm 2013 slides in the second sliding rail 201521 from the first surface 2015a in a direction toward the second surface 2015b of the third housing fastening bracket 2015. Similarly, the fourth housing fastening bracket 2019 may drive the fourth support arm 2020 and the fourth swing arm 2021 to rotate around the base. A specific movement process is similar to the movement process in which the third housing fastening bracket 2015 drives the third support arm 2012 and the third swing arm 2013 to rotate around the second base 206. Details are not described herein again.

In addition, FIG. 34d is a diagram of a structure when the second housing 4 and the third housing 5 are in the folded state. In a process from FIG. 34c to FIG. 34d, the third housing fastening bracket 2015 continues to move relative to the third support arm 2012 in a direction away from the second base 206, and drives the third support arm 2012 to rotate around the second base 206. The third arc-shaped rotating block 20131 of the third swing arm 2013 continues to move in a direction of sliding out of the corresponding fifth arc-shaped groove 2063, so that a part that is of the third arc-shaped rotating block 20131 and that is accommodated in the corresponding fifth arc-shaped groove 2063 is further reduced. In addition, the second sliding block 20132 of the third swing arm 2013 continues to slide in the sixth sliding slot 20152 in a direction toward the second surface 2015b of the third housing fastening bracket 2015. Similarly, the fourth housing fastening bracket 2019 may drive the fourth support arm 2020 and the fourth swing arm 2021 to continue to rotate around the base. A specific movement process is similar to the movement process in which the third housing fastening bracket 2015 drives the third support arm 2012 and the third swing arm 2013 to rotate around the second base 206. Details are not described herein again.

It may be understood that when the second housing 4 and the third housing 5 rotate from the folded state shown in FIG. 34d to the unfolded state shown in FIG. 34a, the third housing fastening bracket 2015, the third support arm 2012, and the third swing arm 2013, and the fourth housing fastening bracket 2019, the fourth support arm 2020, and the fourth swing arm 2021 may separately move in directions opposite to those in the rotation process from FIG. 34a to FIG. 34d. Details are not described herein again.

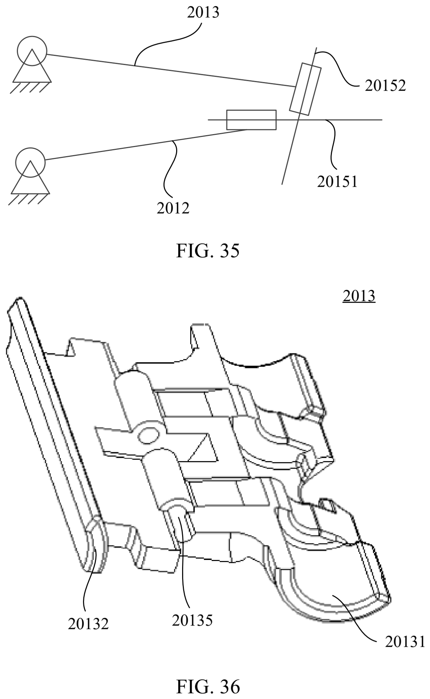

FIG. 35 is a diagram of a principle of a mechanism in which the third support arm 2012 and the third swing arm 2013 slide relative to the third housing fastening bracket 2015 according to an embodiment of this application. It can be learned from FIG. 35 that, through the second hinge mechanism 2 provided in this application, when the third support arm 2012 and the third swing arm 2013 rotate around the second base 206, a rotation axis center of the third support arm 2012 does not coincide with a rotation axis center of the third swing arm 2013. In this way, an axis center phase difference motion between the third support arm 2012 and the third swing arm 2013 can be implemented. In addition, providing directions of the fifth sliding slot 20151 and the sixth sliding slot 20152 are properly designed, so that rotation angles of the third support arm 2012 and the third swing arm 2013 relative to the second base 206 may be not greater than 90°. Compared with an existing solution, this solution can effectively reduce the rotation angle of the third swing arm 2013. In this way, a wall thickness design of a partial structure (for example, a structure at H of the third swing arm 2013 shown in FIG. 31) of the third swing arm 2013 can meet a strength requirement, so that structural reliability of the third swing arm 2013 is improved. It may be understood that FIG. 35 may also indicate a principle of a mechanism in which the fourth support arm 2020 and the fourth swing arm 2021 slide relative to the fourth housing fastening bracket 2019. It can be learned from the foregoing analysis that, in this application, providing directions of the seventh sliding slot 20191 and the eighth sliding slot 20192 are properly designed, so that rotation angles of the fourth support arm 2020 and the fourth swing arm 2021 relative to the second base 206 may be both not greater than 90°. In this way, the rotation angle of the fourth swing arm 2021 is reduced, and a wall thickness design of a partial structure of the fourth swing arm 2021 meets a strength requirement, so that structural reliability of the fourth swing arm 2021 is improved. In addition, when the second hinge mechanism 2 is used in the electronic device, a thinned design of a component in the electronic device can be effectively avoided, to avoid rotation of the third swing arm 2013 and the fourth swing arm 2021. This can improve reliability of the overall structure of the electronic device.

In addition, still refer to FIG. 34d. When the second housing 4 and the third housing 5 are in the folded state, both the third support arm 2012 and the third swing arm 2013 have support force on the third housing fastening bracket 2015 in a Z direction shown in FIG. 34d, so that a movement combination degree between both the third support arm 2012 and the third swing arm 2013, and the third housing fastening bracket 2015 can be effectively improved, and the third housing fastening bracket 2015 can be stopped in this direction. Similarly, the fourth support arm 2020 and the fourth swing arm 2021 may also have support force on the fourth housing fastening bracket 2019 in the Z direction, so that a movement combination degree between both the fourth support arm 2020 and the fourth swing arm 2021, and the fourth housing fastening bracket 2019 can be effectively improved, and the fourth housing fastening bracket 2019 can be stopped in this direction. In this way, even if the electronic device with the hinge mechanism falls off in the folded state, a risk of instantaneous large displacements of the third housing fastening bracket 2015 and the fourth housing fastening bracket 2019 relative to the hinge mechanism in this state can be also effectively reduced, so that reliability of the overall structure of the electronic device can be ensured.

In this application, the second sliding block 20132 of the third swing arm 2013 may be a straight-line sliding block shown in FIG. 31. In this case, the second sliding rail 201521 may also be adaptively disposed as a straight-line sliding rail shown in FIG. 34a. In addition, the straight-line sliding rail has an opening located on the first surface 2015a. When the hinge mechanism is in the unfolded state shown in FIG. 34a, the straight-line sliding rail extends from the opening to the second base 206, to improve smoothness of sliding the second sliding block 20132 along the second sliding rail 201521, and reduce interference of another structure of the hinge mechanism on the third swing arm 2013. This helps increase a wall thickness of the third swing arm 2013, to improve structural reliability of the third swing arm 2013. In some other possible implementations of this application, a straight-line sliding rail may alternatively extend from the opening in a direction away from the base, or a straight-line sliding rail may alternatively extend from the opening in a direction perpendicular to the second surface 2015b, so that the second sliding rail 201521 is disposed flexibly. It should be noted that, in this application, the second sliding block 20132 may alternatively be in another shape that adapts to the straight-line sliding rail, for example, may be a sliding block in an overall straight-line form with a hollow and spacing design in a middle part, or may be a specially-shaped sliding block, as long as the sliding block can fit the straight-line sliding rail in shape for sliding.

In this application, the fourth sliding rail 201921 may be symmetrically disposed with the second sliding rail 201521. For a specific disposing manner, refer to that of the second sliding rail 201521. Details are not described herein. In addition, the fourth sliding block 202102 may be a straight-line sliding block, or may be in another shape that adapts to a straight-line sliding rail, for example, may be a sliding block in an overall straight-line form with a hollow and spacing design in a middle part, or may be a specially-shaped sliding block, as long as the sliding block can fit the straight-line sliding rail in shape for sliding.

In addition to the foregoing straight-line structure, the second sliding block 20132 of the third swing arm 2013 may alternatively be designed as another possible structure. For example, FIG. 36 is a diagram of another structure of the third swing arm 2013 according to an embodiment of this application. In this embodiment, the second sliding block 20132 of the third swing arm 2013 may alternatively be designed as an arc-shaped sliding block, and the arc-shaped sliding block may be, for example, a circular arc-shaped sliding block. In addition, to make the arc-shaped sliding block of the third swing arm 2013 slidable in the second sliding rail 201521 of the sixth sliding slot 20152 of the third housing fastening bracket 2015, the second sliding rail 201521 may alternatively be adaptively designed as an arc-shaped sliding rail from the straight-line sliding rail shown in FIG. 34a, and the arc-shaped sliding rail may be, for example, a circular arc-shaped sliding rail. When the hinge mechanism is in the unfolded state, an axis center of the arc-shaped sliding rail is located on a side that is of the second base 206 and that is away from the arc-shaped sliding rail. In this way, smoothness of sliding the second sliding block 20132 along the second sliding rail 201521 can be improved, and a rotation angle of the third swing arm 2013 relative to the second base 206 may be 90°, to effectively reduce interference of another structure of the hinge mechanism on movement of the third swing arm 2013. This helps increase a wall thickness of the third swing arm 2013. In addition, FIG. 36 may also indicate a structure of the fourth swing arm 2021. For how the fourth swing arm 2021 is specifically disposed, refer to the foregoing descriptions of the third swing arm 2013. Details are not described herein again.

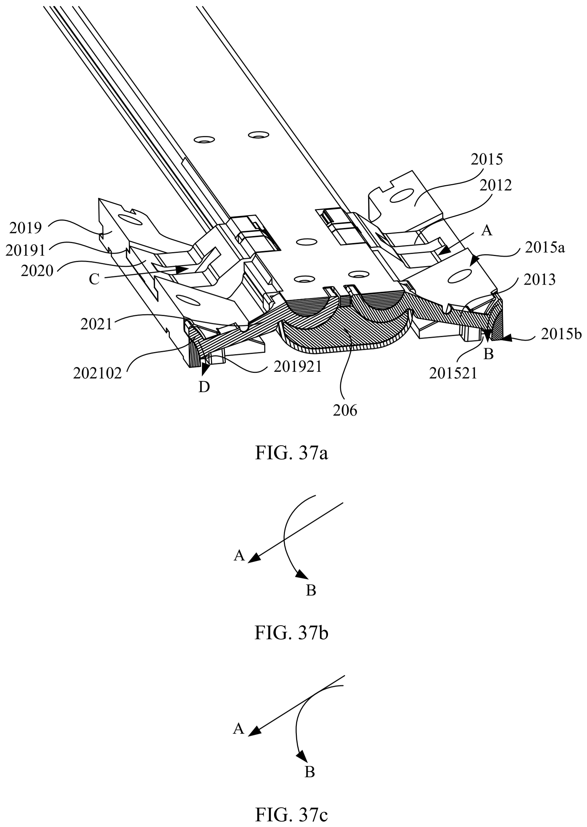

In this embodiment, sliding of the third swing arm 2013 in the sixth sliding slot 20152 and sliding of the fourth swing arm 2021 in the eighth sliding slot 20192 are sliding of the arc-shaped sliding block in the arc-shaped sliding rail. During specific implementation, refer to FIG. 37a first. FIG. 37a is a diagram of a structure when the second housing 4 and the third housing 5 are in the unfolded state. In this case, a spacing between an edge that is of the third housing fastening bracket 2015 and that faces the second base 206 and the second base 206 is the shortest, and a spacing between the second sliding block 20132 of the third swing arm 2013 and the first surface 2015a of the third housing fastening bracket 2015 is the shortest.

It can be learned from the descriptions of the foregoing embodiments that when the second housing 4 and the third housing 5 rotate from the unfolded state to the folded state, the third support arm 2012 may slide in the fifth sliding slot 20151 in the first direction, and the third support arm 2012 may slide in the sixth sliding slot 20152 in the second direction. Similarly, the fourth support arm 2020 may slide in the seventh sliding slot 20191 in the third direction, and the fourth swing arm 2021 may slide in the eighth sliding slot 20192 in the fourth direction. In FIG. 37a, solid lines with arrows respectively indicate the first direction and the third direction, and dashed lines with arrows respectively indicate the second direction and the fourth direction. In addition, FIG. 37b is another diagram of a first cross section according to an embodiment of this application. In the first cross section, the first direction intersects the second direction. In addition, in the second cross section, a position relationship between the third direction and the fourth direction may be symmetrical with a position relationship between the first direction and the second direction shown in FIG. 37b. Details are not described herein again.

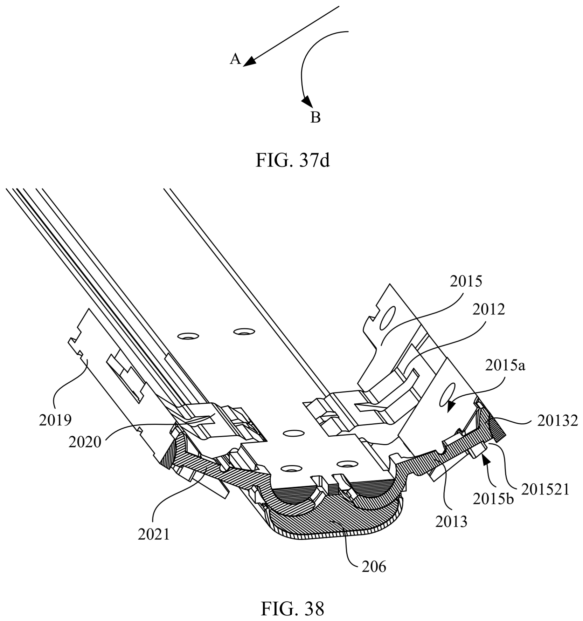

It should be noted that, in this application, a projection of the second direction in the first cross section is not parallel to a projection of the first direction in the first cross section, and a projection of the fourth direction in the second cross section is not parallel to a projection of the third direction in the second cross section. In addition to intersection between the first direction and the second direction shown in FIG. 34b and FIG. 37b, a tangent relationship between the first direction and the second direction shown in FIG. 37c or a separation relationship between the first direction and the second direction shown in FIG. 37d may exist. This is not specifically limited in this application.

In a process in which the second housing 4 and the third housing 5 rotate from the unfolded state to the folded state, the third support arm 2012 may slide in the first sliding slot in the first direction shown in FIG. 37a, and the third swing arm 2013 may slide in the second sliding slot in the second direction shown in FIG. 37a. In addition, FIG. 38 is a diagram of a structure when the second housing 4 and the third housing 5 are in the intermediate state. It can be learned by comparing FIG. 38 with FIG. 37a that in this process, the third housing fastening bracket 2015 may move relative to the third support arm 2012 in a direction away from the second base 206, and drive the third support arm 2012 and the third swing arm 2013 to rotate around the second base 206. The third arc-shaped rotating block 20131 of the third swing arm 2013 moves in a direction of sliding out of the corresponding fifth arc-shaped groove 2063, so that a part that is of the third arc-shaped rotating block 20131 and that is accommodated in the corresponding fifth arc-shaped groove 2063 is reduced. In addition, the second sliding block 20132 of the third swing arm 2013 slides in the second sliding rail 201521 from the first surface 2015a in a direction toward the second surface 2015b of the third housing fastening bracket 2015. Similarly, the fourth housing fastening bracket 2019 may drive the fourth support arm 2020 and the fourth swing arm 2021 to rotate around the base. A specific movement process is similar to the movement process in which the third housing fastening bracket 2015 drives the third support arm 2012 and the third swing arm 2013 to rotate around the second base 206. Details are not described herein again.

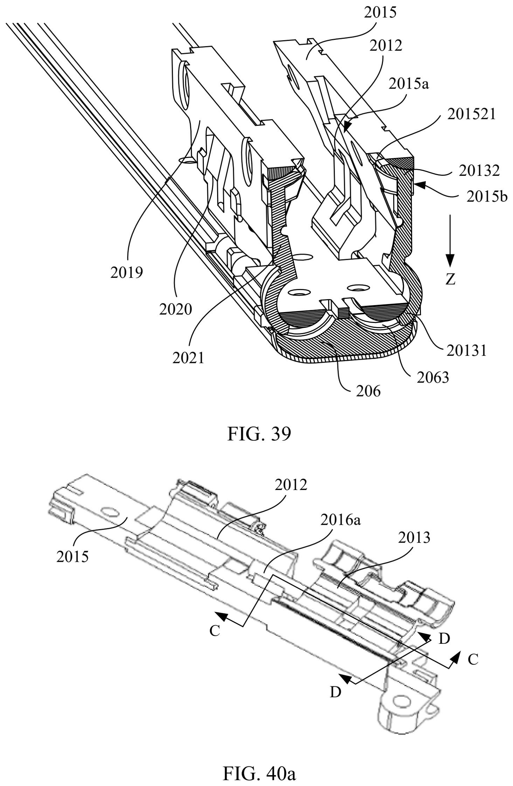

In addition, FIG. 39 is a diagram of a structure when the second housing 4 and the third housing 5 are in the folded state. In a process from FIG. 38 to FIG. 39, the third housing fastening bracket 2015 continues to move relative to the third support arm 2012 in a direction away from the second base 206, and drives the third support arm 2012 and the third swing arm 2013 to continue to rotate around the second base 206. The third arc-shaped rotating block 20131 of the third swing arm 2013 continues to move in a direction of sliding out of the corresponding fifth arc-shaped groove 2063, so that a part that is of the third arc-shaped rotating block 20131 and that is accommodated in the corresponding fifth arc-shaped groove 2063 is further reduced. In addition, the second sliding block 20132 of the third swing arm 2013 continues to slide in the second sliding rail 201521 in a direction toward the second surface 2015b of the third housing fastening bracket 2015. Similarly, the fourth housing fastening bracket 2019 may drive the fourth support arm 2020 and the fourth swing arm 2021 to continue to rotate around the base. A specific movement process is similar to the movement process in which the third housing fastening bracket 2015 drives the third support arm 2012 and the third swing arm 2013 to rotate around the second base 206. Details are not described herein again.

It may be understood that when the hinge mechanism rotates from the folded state shown in FIG. 39 to the unfolded state shown in FIG. 37a, the third housing fastening bracket 2015, the third support arm 2012, and the third swing arm 2013, and the fourth housing fastening bracket 2019, the fourth support arm 2020, and the fourth swing arm 2021 may separately move in directions opposite to those in the rotation process from FIG. 37a to FIG. 39. Details are not described herein again.

In some other possible embodiments of this application, when the hinge mechanism is in the unfolded state, an axis center of an arc-shaped sliding rail may alternatively be located on a side that is of the arc-shaped sliding rail and that faces the second base 206. In this way, in a process in which the hinge mechanism rotates from the unfolded state to the folded state, the second sliding block 20132 of the third swing arm 2013 slides in the second sliding rail 201521 from the second surface 2015b of the third housing fastening bracket 2015 in a direction toward the first surface 2015a. However, in a process in which the hinge mechanism rotates from the folded state to the unfolded state, the second sliding block 20132 of the third swing arm 2013 slides in the second sliding rail 201521 from the first surface 2015a of the third housing fastening bracket 2015 in a direction toward the second surface 2015b.

It should be noted that, in this application, when the second sliding rail 201521 is an arc-shaped sliding rail, the second sliding block 20132 may alternatively be in another shape that adapts to the arc-shaped sliding rail, for example, may be a sliding block in an overall arc-shaped form with a hollow and spacing design in a middle part, or may be a specially-shaped sliding block, as long as the sliding block can fit the arc-shaped sliding rail in shape for sliding. In addition, when the second sliding rail 201521 is a circular arc-shaped sliding rail, sliding of the second sliding block 20132 in the second sliding rail 201521 may also be understood as rotation of the second sliding block 20132 around the third housing fastening bracket 2015 through the circular arc-shaped sliding rail.

In this application, the fourth sliding rail 201921 may be symmetrically disposed with the second sliding rail 201521. For a specific disposing manner, refer to that of the second sliding rail 201521. Details are not described herein. In addition, the fourth sliding block 202102 may be an arc-shaped sliding block, or may be in another shape that adapts to the arc-shaped sliding rail, for example, may be a sliding block in an overall arc-shaped form with a hollow and spacing design in a middle part, or may be a specially-shaped sliding block, as long as the sliding block can fit the arc-shaped sliding rail in shape for sliding. In addition, when the fourth sliding rail 201921 is a circular arc-shaped sliding rail, sliding of the fourth sliding block 202102 in the fourth sliding rail 201921 may also be understood as rotation of the fourth sliding block 202102 around the fourth housing fastening bracket 2019 through the circular arc-shaped sliding rail.

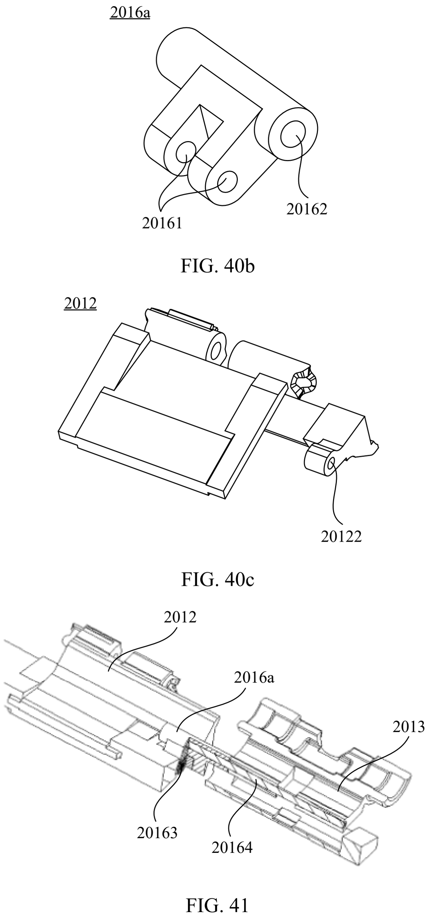

In embodiments of this application, to improve movement consistency and movement smoothness of the third support arm 2012 and the third swing arm 2013 that are located on a same side, and a degree of combining the third support arm 2012 and the third swing arm 2013 with corresponding sliding slots, FIG. 40a is a diagram of a connection structure of the third support arm 2012 and the third swing arm 2013 according to an embodiment of this application. A first drive connecting rod 2016a may be disposed between the third support arm 2012 and the third swing arm 2013. The first drive connecting rod 2016a may be rotatably connected to the third support arm 2012 and the third swing arm 2013 separately. During specific implementation, refer to FIG. 40b. FIG. 40b is a diagram of a structure of the first drive connecting rod 2016a according to a possible embodiment of this application. The first drive connecting rod 2016a may include a first connecting part 20161 and a second connecting part 20162.

FIG. 40c is a diagram of a structure of the third support arm 2012 according to a possible embodiment of this application. Refer to FIG. 40b and FIG. 40c together. In this application, the first connecting part 20161 of the first drive connecting rod 2016a may be connected to the first mounting hole 20122 of the third support arm 2012. The second connecting part 20162 of the first drive connecting rod 2016a may be connected to the second mounting hole 20135 of the third swing arm 2013 shown in FIG. 31 or FIG. 36.

In addition, FIG. 41 is a cross-sectional view of a structure shown in FIG. 40a at C-C. Refer to FIG. 40b and FIG. 40c together. The first connecting part 20161 is rotatably connected to the third support arm 2012 through the third connecting rod 20163, and the second connecting part 20162 is rotatably connected to the swing arm 1013 through the fourth connecting rod 20164. It should be noted that an axis of the third connecting rod 20163 does not coincide with an axis of the fourth connecting rod 20164, to reduce a risk of interference with respective movement of the third support arm 2012 and the third swing arm 2013.

The first drive connecting rod 2016a is disposed between the third support arm 2012 and the third swing arm 2013, so that when the hinge mechanism is in the folded state, the third support arm 2012, the third swing arm 2013, and the first drive connecting rod 2016a jointly support the third housing fastening bracket 2015, to stop the third housing fastening bracket 2015 while effectively improving a movement combination degree between both the third support arm 2012 and the third swing arm 2013, and the third housing fastening bracket 2015. In this way, even if the electronic device with the hinge mechanism falls off in the folded state, a risk of instantaneous large displacements of the third housing fastening bracket 2015 relative to the hinge mechanism in this state can be also effectively reduced, so that reliability of the overall structure of the electronic device can be ensured.

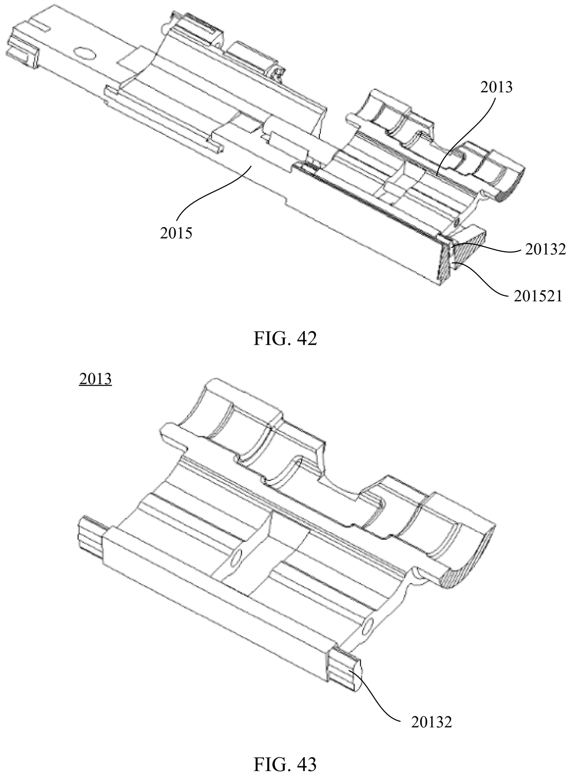

To avoid over-constraint on movement of the third support arm 2012 and the third swing arm 2013 caused by disposing the first drive connecting rod 2016a, refer to FIG. 42. FIG. 42 is a cross-sectional view of a structure shown in FIG. 40a at D-D. In this embodiment, the second sliding block 20132 of the third swing arm 2013 may alternatively be thinned, so that the second sliding block 20132 of the third swing arm 2013 may be in clearance fit to the second sliding rail 201521 of the third housing fastening bracket 2015. During specific implementation, refer to FIG. 43. FIG. 43 shows another diagram of a structure of the third swing arm 2013 according to an embodiment of this application. In this embodiment, a thickness of the second sliding block 20132 of the third swing arm 2013 is reduced, so that there is a gap between the second sliding block 20132 and a side wall of the second sliding rail 201521 shown in FIG. 42. In this case, a shape of the second sliding block 20132 may match a shape of the second sliding rail 201521. For example, when the second sliding rail 201521 is a rectangular sliding rail, the second sliding block 20132 may be disposed as a rectangular sliding block. Alternatively, the second sliding block 20132 may be disposed as a pin shaft, so that the second sliding block 20132 can rotate relative to the second sliding rail 201521 while sliding in the second sliding rail 201521. In this way, in a process in which the second sliding block 20132 slides along the second sliding rail 201521, a degree of freedom of movement of the third swing arm 2013 can be increased, and reliability of fitting between the third swing arm 2013 and the sixth sliding slot 20152 of the third housing fastening bracket 2015 can be ensured.

It should be noted that, in the foregoing embodiment, the first drive connecting rod 2016a is rotatably connected to the third support arm 2012 through the third connecting rod 20163, and is rotatably connected to the third swing arm 2013 through the fourth connecting rod 20164. In this way, the third support arm 2012, the third connecting rod 20163, the third swing arm 2013, and the fourth connecting rod 20164 can form a four-bar linkage. It may be understood that, rod lengths between structures on the four-bar linkage are adjusted, so that the formed four-bar linkage can be in a parallel quadrilateral or non-parallel quadrilateral shape.

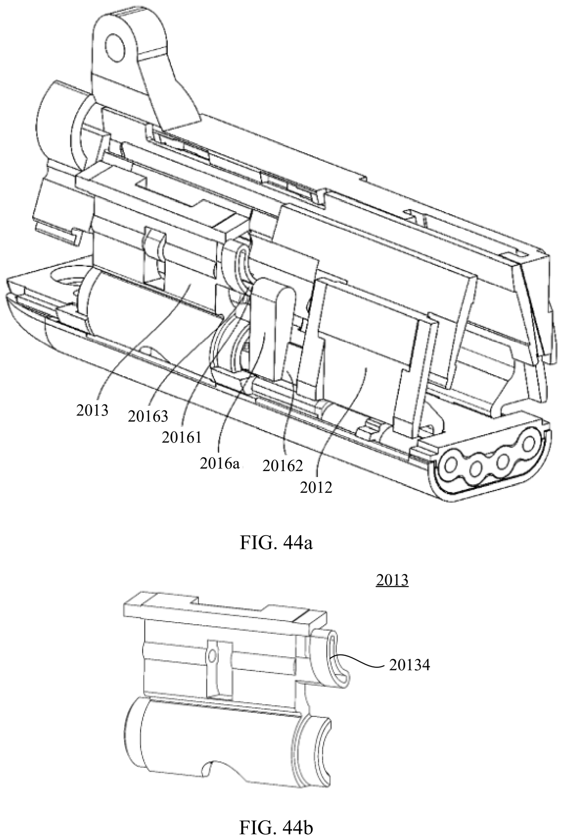

In addition, in addition to the disposing manner provided in the foregoing embodiments, for a disposing manner of the first drive connecting rod 2016a, refer to FIG. 44a. FIG. 44a is a diagram of another connection structure of the third support arm 2012 and the third swing arm 2013 according to an embodiment of this application. In this embodiment, the first drive connecting rod 2016a is alternatively located between the third support arm 2012 and the third swing arm 2013. Different from that in the foregoing embodiment, in this embodiment, the first connecting part 20161 of the first drive connecting rod 2016a is slidably connected to the third swing arm 2013 through the third connecting rod 20163, and the second connecting part 20162 is fastened to the third support arm 2012.

FIG. 44b is a diagram of another structure of the third swing arm 2013 according to an embodiment of this application. Refer to FIG. 44a and FIG. 44b together. A first guide slot 20134 may be provided on an end part that is of the third swing arm 2013 and that faces the third support arm 2012. In this case, the third connecting rod 20163 may be inserted into the first guide slot 20134, and may slide along a slot surface of the first guide slot 20134, to implement a slidable connection between the third connecting rod 20163 and the third swing arm 2013.

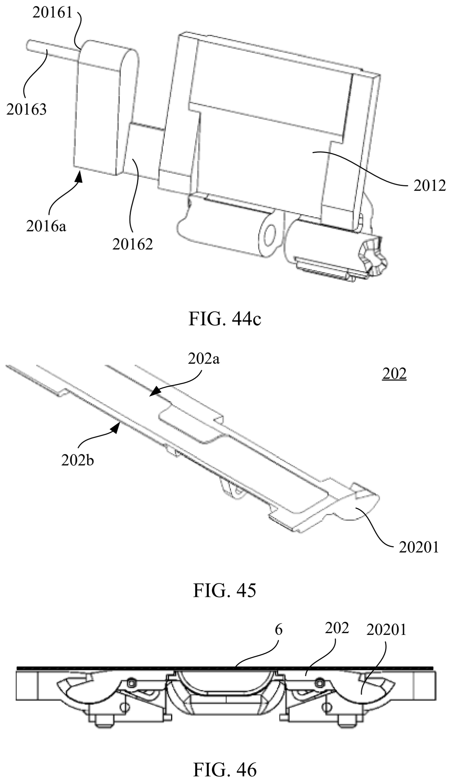

In addition, FIG. 44c is a diagram of a structure in which the first drive connecting rod 2016a is connected to the third support arm 2012. In this application, the second connecting part 20162 of the first drive connecting rod 2016a may be fastened to the third support arm 2012 through bonding, a threaded connection, or the like. In some other possible embodiments of this application, the first drive connecting rod 2016a and the third support arm 2012 may alternatively be of an integrally formed structure.

It may be understood that, in some possible embodiments of this application, the first drive connecting rod 2016a may be slidably connected to the third support arm 2012 and fastened to the third swing arm 2013 alternatively. A specific disposing manner is similar to that in the foregoing embodiment in which the first drive connecting rod 2016a is slidably connected to the third swing arm 2013 and fastened to the third support arm 2012. Details are not described herein again.

The first drive connecting rod 2016a is disposed in this manner. The first guide slot 20134 is properly designed, to improve a degree of combining the third support arm 2012 and the third swing arm 2013 with corresponding sliding slots, so that movement consistency of the third support arm 2012 and the third swing arm 2013 is improved, and movement of the third support arm 2012 and the third swing arm 2013 is smoother. In addition, when the electronic device with the hinge mechanism falls off in the folded state, the third support arm 2012, the third swing arm 2013, and the first drive connecting rod 2016a may jointly support a housing of the electronic device, so that a large instantaneous displacement of the housing relative to the hinge mechanism can be avoided. This improves reliability of the overall structure of the electronic device.

In addition, in this embodiment, to avoid over-constraint caused by disposing the first drive connecting rod 2016a on movement of the third support arm 2012 and the third swing arm 2013, the second sliding block 20132 of the third swing arm 2013 may also be thinned, so that the second sliding block 20132 of the third swing arm 2013 is in clearance fit to the second sliding rail 201521 of the third housing fastening bracket 2015. For a specific disposition manner, refer to the foregoing embodiment. Details are not described herein again.

It should be noted that, as shown in FIG. 34a, in the fourth rotating assembly 201b, a second drive connecting rod 2016b may be disposed between the fourth support arm 2020 and the fourth swing arm 2021. The second drive connecting rod 2016b may include a third connecting part (not shown in FIG. 34a) and a fourth connecting part (not shown in FIG. 34a). The third connecting part may be connected to the fourth swing arm 2021, and the fourth connecting part may be connected to the fourth support arm 2020. Specifically, for a specific disposing manner of the second drive connecting rod 2016b, a manner of connecting the third connecting part to the fourth swing arm 2021, and a manner of connecting the fourth connecting part to the fourth support arm 2020, refer to those on the side of the first rotating assembly 1011. For example, the third connecting part is rotatably connected to the fourth support arm through a fifth connecting rod, and the fourth connecting part is rotatably connected to the fourth swing arm through a sixth connecting rod. An axis of the fifth connecting rod and an axis of the sixth connecting rod are parallel to and do not coincide with each other. Details are not described herein.

Still refer to FIG. 28. In this application, in addition to the foregoing structure, the second hinge mechanism 2 may further include a first support plate 202 and a second support plate 203. The first support plate 202 and the second support plate 203 may be respectively disposed on two opposite sides of the second base 206 shown in FIG. 30. In this application, the first support plate 202 and the second support plate 203 may be symmetrically disposed relative to the second base 206. Therefore, in the following embodiments, a specific disposing manner of the first support plate 202 and a connection relationship between the first support plate 202 and the second base 206 are mainly used as an example for description, and the side of the second support plate 203 may be disposed with reference to the side of the first support plate 202.

In this application, the first support plate 202 is rotatably connected to the third housing fastening bracket 2015. It should be noted that, in this application, the first support plate 202 may be rotatably connected to a plurality of third housing fastening brackets 2015 of a plurality of second rotating modules 201. This helps simplify a structure of the second hinge mechanism 2, and can improve structural reliability of the second hinge mechanism 2.

When the first support plate 202 is rotatably connected to the third housing fastening bracket 2015 specifically, the third housing fastening bracket 2015 shown in FIG. 33 may be first referred to. The third housing fastening bracket 2015 may further be provided with a first rotating slot 20153, and the first rotating slot 20153 may be a circular arc-shaped groove. In addition, FIG. 45 is a diagram of a structure of the first support plate 202 according to an embodiment of this application. A first rotating part 20201 may be disposed on an end part that is of the first support plate 202 and that faces the third housing fastening bracket 2015. The first rotating part 20201 may be disposed in an arc shape, for example, may be disposed in a circular arc shape. In this way, the first rotating part 20201 may be mounted in the first rotating slot 20153. The first rotating part 20201 may rotate along a slot surface of the first rotating slot 20153, to implement relative rotation between the first support plate 202 and the third housing fastening bracket 2015.

Refer to FIG. 45. The first support plate 202 includes a first plate surface 202a and a second plate surface 202b that are disposed opposite to each other, where the first plate surface 202a may be configured to support the flexible display 6. During specific implementation, refer to FIG. 46. FIG. 46 is a diagram of a structure in which the first support plate 202 supports the flexible display 6 according to an embodiment of this application. In FIG. 21, the electronic device is in the unfolded state. In this case, the first plate surface 202a of the first support plate 202 and a surface that is of the cover plate (not shown in FIG. 45) and that faces the flexible display 6 may be on a same plane, so that the flexible display 6 may be supported flatly.

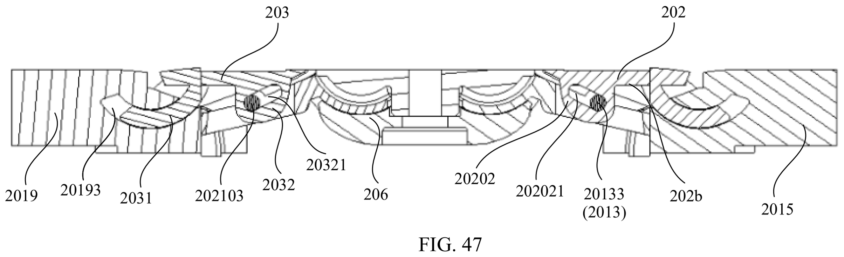

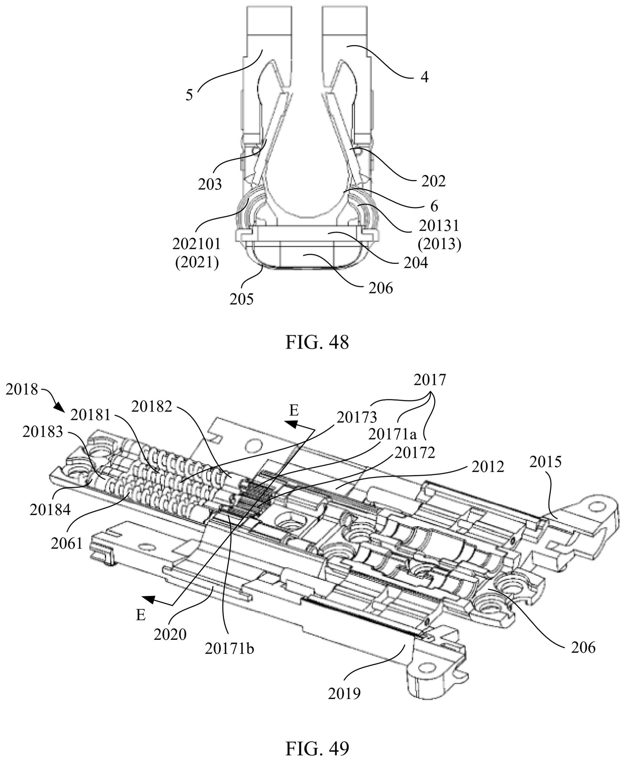

FIG. 47 is a cross-sectional view of the second hinge mechanism 2 according to an embodiment of this application. FIG. 47 may be used to show a structure of the second plate surface 202b of the first support plate 202 and a connection relationship between the first support plate 202 and another structure. A first guide part 20202 may be disposed on the second plate surface 202b of the first support plate 202, and the first guide part 20202 may be provided with a third track slot 202021. In addition, in this application, a first guide structure 20133 may be further disposed on the third swing arm 2013, and the first guide structure 20133 may be but is not limited to a columnar structure. The first guide structure 20133 may be inserted into the third track slot 202021 of the first guide part 20202 of the first support plate 202, and may slide along the third track slot 202021. In this way, in a process in which the third swing arm 2013 rotates around the second base 206, the first guide structure 20133 may slide in the third track slot 202021, to drive the first support plate 202 to rotate around the third housing fastening bracket 2015 on a corresponding side. For example, when two housing fastening brackets rotate toward each other, two swing arms rotate toward each other around the second base 206, so that ends that are of the two support plates and that are close to the second base 206 may be driven to move in a direction away from the second base 206. In this way, refer to FIG. 48. FIG. 48 shows that when the second housing 4 and the third housing 5 are in a folded state, the first support plate 202, the second support plate 203, and the second cover plate 2014 may form display accommodation space 204, and a bent part of the flexible display 6 may be accommodated in the display accommodation space 204. This can avoid squeezing the flexible display 6, to reduce a risk of damage to the flexible display 6.

In another possible embodiment of this application, the third support arm 2012 may further drive the first support plate 202 to rotate around the housing fastening bracket 1015. During specific implementation, a first guide part 20202 may be disposed on the second plate surface 202b of the first support plate 202, and the first guide part 20202 may be provided with a third track slot 202021. In addition, a first guide structure 20133 may be disposed on the third support arm 2012, and the first guide structure 20133 may be but is not limited to a columnar structure. The first guide structure 20133 may be inserted into the third track slot 202021 of the first guide part 20202 of the first support plate 202, and may slide along the third track slot 202021. In this way, in a process in which the third support arm 2012 rotates around the second base 206, the first guide structure 20133 may slide in the third track slot 202021, to drive the first support plate 202 to rotate around the third housing fastening bracket 2015. In some possible embodiments of this application, the first support plate 202 may be slidably connected to both the third support arm 2012 and the third swing arm 2013 alternatively. For a slidable connection manner, refer to the foregoing embodiments. Details are not described herein again. In this way, the third support arm 2012 and the third swing arm 2013 rotate around the second base 206 to drive the first support plate 202 to rotate around the third housing fastening bracket 2015.

Because the second support plate 203 is symmetrically disposed with the first support plate 202, when the second support plate 203 is specifically disposed, the second support plate 203 may be rotatably connected to the fourth housing fastening bracket 2019. Still refer to FIG. 47. The fourth housing fastening bracket 2019 is provided with a second rotating slot 20193. In addition, the second support plate 203 may be provided with a second rotating part 2031, so that the second rotating part 2031 rotates along a slot surface of the second rotating slot 20193. The second support plate 203 may be further provided with a second guide part 2032, and the second guide part 2032 has a fourth track slot 20321. In addition, the fourth support arm 2020 and/or the fourth swing arm 2021 may be provided with a second guide structure 202103. The second guide structure 202103 may be inserted into the fourth track slot 20321, and may slide along the fourth track slot 20321. In this way, when the fourth support arm 2020 and/or the fourth swing arm 2021 rotate, the second guide structure 202103 slides in the fourth track slot 20321, to drive the second support plate 203 to rotate around the fourth housing fastening bracket 2019.

In this application, a fifth sliding slot 20151 and a sixth sliding slot 20152 are provided on the third housing fastening bracket 2015, and during rotation of the third housing fastening bracket 2015 around the second base 206, the third support arm 2012 slides in the fifth sliding slot 20151 in a first direction, and the third swing arm 2013 slides in the sixth sliding slot 20152 in a second direction. A projection in a first cross section may intersect with a projection of the second direction in the first cross section. The first cross section may be a reference plane perpendicular to the rotation axis of the third support arm 2012 and the rotation axis of the third swing arm 2013. Therefore, when the third support arm 2012 and the third swing arm 2013 rotate around the second base 206, the rotation axis center of the third support arm 2012 does not coincide with the rotation axis center of the third swing arm 2013. In this way, an axis center phase difference motion between the third support arm 2012 and the third swing arm 2013 can be implemented. In addition, providing directions of the fifth sliding slot 20151 and the sixth sliding slot 20152 are properly designed, so that rotation angles of the third support arm 2012 and the third swing arm 2013 relative to the second base 206 may both be less than or equal to 90°. Based on the same principle, the rotation angles of the fourth support arm 2020 and the fourth swing arm 2021 relative to the second base 206 may both be less than or equal to 90°.

It may be understood that, in the second hinge mechanism 2 provided in this application, the third track slot 202021 of the first support plate 202 and the fourth track slot 20321 of the second support plate 203 may also be adjusted to adjust the rotation angles of the third swing arm 2013 and the fourth swing arm 2021. For example, a maximum rotatable angle of the third swing arm 2013 may be less than or equal to 90°. When the electronic device is in the folded state, the third swing arm 2013 may be far away from the flexible display 6, so that squeezing or pulling on the flexible display 6 by the third swing arm 2013 can be avoided, to reduce a risk of damage to the flexible display 6, and prolong a service life of the flexible display 6.

In addition to the foregoing structures, in some embodiments of this application, another possible structure may be further disposed in the second hinge mechanism 2. For example, FIG. 49 is a diagram of another partial structure of the second hinge mechanism 2 according to an embodiment of this application. In this embodiment, the second rotating module 201 may further include a second synchronization assembly 2017. The second synchronization assembly 2017 may include a first drive gear 20171a disposed on end part of the third support arm 2012 and a second drive gear 20171b disposed on an end part of the fourth support arm 2020. The first drive gear 20171a and the second drive gear 20171b are engaged with each other. In this way, in a process in which one support arm rotates around the second base 206, another support arm may be driven to synchronously rotate around the second base 206 in a direction toward or away from the one support arm, and angles by which the two support arms rotate are the same.

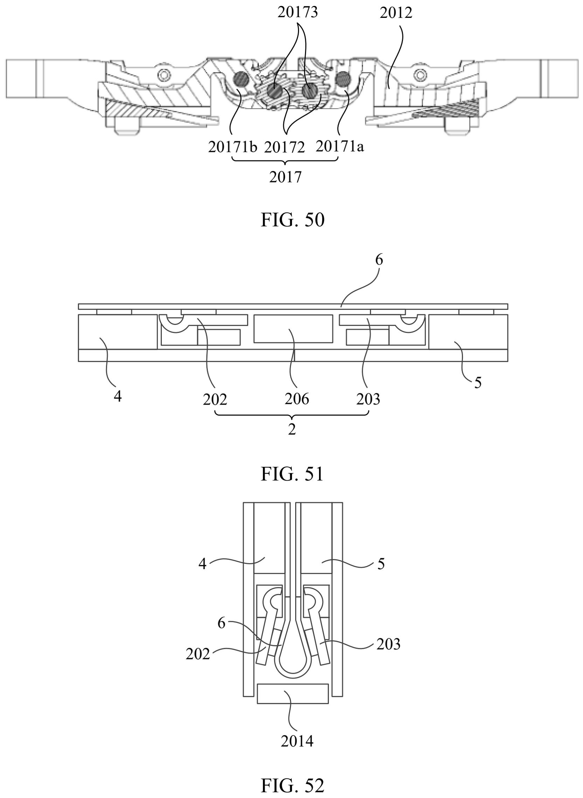

FIG. 50 is a cross-sectional view of the second hinge mechanism 2 shown in FIG. 49 at E-E. In this application, the second synchronization assembly 2017 may further include a driven gear 20172, and the driven gear 20172 may be disposed between the two drive gears. In addition, there may be an even number of driven gears 20172, and a driven gear 20172 and a drive gear that are adjacent to each other and adjacent driven gears 20172 are engaged with each other, so that the two drive gears can synchronously rotate through the even number of driven gears 20172.

To improve movement stability of the second synchronization assembly 2017, in this application, the two drive gears may be sleeved on pin shafts on corresponding sides. In addition, the second synchronization assembly 2017 may further include a middle shaft 20173, the middle shaft 20173 may be located between the two pin shafts, and each driven gear 20172 is sleeved on one middle shaft 20173.

It should be noted that, in this application, the second synchronization assembly 2017 may be disposed on the second base 206, and may be accommodated in the accommodation space formed between the second cover plate 2014 and the second base 206, so that a structure of the second hinge mechanism 2 is compact. In the second hinge mechanism 2 provided in this application, the second synchronization assembly 2017 is disposed, so that in a process in which one support arm rotates around the second base 206, another support arm may be driven to rotate synchronously around the second base 206 in a direction toward or away from the one support arm. In addition, each support arm may slide along a sliding slot of a housing fastening bracket on a corresponding side. Therefore, in a process in which a support arm rotates around the second base 206, a housing fastening bracket on the same side may rotate at a same angle, so that two housing fastening brackets can synchronously rotate in a process in which two support arms synchronously rotate. In addition, because the housing fastening bracket may be fastened to a housing of the electronic device, two housings of the electronic device may synchronously rotate through synchronous rotation of two housing fastening brackets. In this way, application of instantaneous acting force on the flexible display 6 fastened to the two housings can be avoided, to help improve reliability of the flexible display 6.

Still refer to FIG. 50. A damping assembly 2018 may be further disposed in the second rotating module 201 in this application. The damping assembly 2018 may include an elastic member 20181 and a conjoined cam 20182. In a length direction of the second rotating module 201, the conjoined cam 20182 is located between the elastic member 20181 and the third support arm 2012, and the conjoined cam 20182 abuts against the third support arm 2012 under elastic force of the elastic member 20181.

In addition, a first cam surface may be disposed on an end part that is of the third support arm 2012 and that faces the conjoined cam 20182, and a second cam surface may be disposed on an end part that is of the fourth support arm 2020 and that faces the conjoined cam 20182. When the third support arm 2012 is provided with a first drive gear 20171a, and the fourth support arm 2020 is provided with a second drive gear 20171b, the first cam surface may be disposed on an end part of the first drive gear 20171a, and the second cam surface may be disposed on an end part of the second drive gear 20171b. A third cam surface is disposed on an end part that is of the conjoined cam 20182 and that faces the third support arm 2012, and a fourth cam surface is disposed on an end part that is of the conjoined cam 20182 and that faces the second support arm. In this case, under elastic force of the elastic member 20181, the corresponding first cam surface cooperates with the third cam surface, and the second cam surface cooperates with the fourth cam surface.

It should be noted that, in this application, a cam surface includes a plurality of protrusion parts and recessed parts. When slopes of protrusion parts of two cam surfaces are in contact with each other, damping force that prevents the two cam surfaces from continuing to rotate relative to each other may be generated between the two cam surfaces. Based on this, in a process in which two support arms rotate around the second base 206, the damping assembly 2018 may provide specific damping force for the two support arms. The damping force may be transmitted to the third housing fastening bracket 2015 through the third support arm 2012, and transmitted to the fourth housing fastening bracket 2019 through the fourth support arm 2020, so that the two housing fastening brackets respectively act on the two housings of the electronic device. In this application, the damping assembly 2018 is disposed in the second rotating module 201, so that false unfolding and folding of the electronic device can be avoided, and hovering of the two housings at a specified position can be implemented. In addition, a user may have an obvious feeling in a process of unfolding or folding the electronic device. This helps improve user experience.

When being specifically disposed, the elastic member 20181 may include a plurality of springs disposed side by side. In addition, a part of springs in the elastic member 20181 may be sleeved on the pin shaft 2061, and another part of springs may be sleeved on the middle shaft 20173, which helps improve movement stability of the elastic member 20181.

Refer to FIG. 49. The damping assembly 2018 may further include a stopper 20183, and the elastic member 20181 is located between the stopper 20183 and the conjoined cam 20182. The stopper 20183 may also be sleeved on the pin shaft 2061 and the middle shaft 20173. The stopper 20183 is disposed to squeeze the elastic member 20181, so that the elastic member 20181 accumulates elastic force. In addition, the damping assembly 2018 may further include a snap ring 20184. The stopper 20183 is located between the elastic member 20181 and the snap ring 20184, and the snap ring 20184 may be clamped on the pin shaft 2061 and the middle shaft 20173, to limit the elastic member 20181 and the conjoined cam 20182. This can avoid detachment of the elastic member 20181 from the pin shaft 2061 and the middle shaft 20173.

Refer to FIG. 49. In the electronic device provided in this embodiment of this application, the third housing fastening bracket 2015 may be configured to be fastened to the second housing 4, and the fourth housing fastening bracket 2019 may be configured to be fastened to the third housing 5.

In the electronic device provided in this application, when the electronic device is in the unfolded state, the first support plate 202, the second support plate 203, and the second cover plate 2014 of the second hinge mechanism 2 can support the flexible display 6 flatly, so that integrity of a form of the electronic device in the unfolded state can be ensured, and light and shadow of the flexible display 6 can be improved. In a process in which the second housing 4 and the third housing 5 rotate from the unfolded state to the folded state, the second housing 4 and the third housing 5 of the electronic device may respectively drive housing fastening brackets on corresponding sides to rotate around the second base 206, so that the housing fastening brackets can drive the support arms and the swing arms disposed on the same sides to rotate around the second base 206.

In this way, two sliding slots of each housing fastening bracket are properly designed, so that rotation angles of a support arm and a swing arm on a corresponding side relative to the second base 206 can be adjusted. For example, refer FIG. 31 and FIG. 48 together. When the electronic device is in the folded state, a spacing between the third arc-shaped rotating block 20131 of the third swing arm 2013 and the flexible display 6 is large. Similarly, a spacing between the fourth arc-shaped rotating block 202101 of the fourth swing arm 2021 and the flexible display 6 is large. This can avoid a case in which the arc-shaped rotating blocks of the two swing arms squeeze or pull the flexible display 6, thereby reducing a risk of damage to the flexible display 6 and prolonging a service life of the flexible display 6.

It should be noted that, as shown in FIG. 48, in this application, when the second hinge mechanism 2 is provided with the first support plate 202 and the second support plate 203, the flexible display 6 of the electronic device may be fastened to the first support plate 202 and the second support plate 203. A connection manner may be, but is not limited to, bonding. During specific implementation, the flexible display 6 may be bonded to a partial area of the first support plate 202. For example, refer to FIG. 51. FIG. 51 is a simplified diagram of a structure of an electronic device according to an embodiment of this application when the second housing 4 and the third housing 5 are in the unfolded state. In FIG. 51, the flexible display 6 may be bonded to a part that is of the first support plate 202 and that is close to the second base 206. In addition, the flexible display 6 may also be bonded to a partial area of the second support plate 203, for example, may be bonded to a part that is of the second support plate 203 and that is close to the second base 206. Therefore, when the second housing 4 and the third housing 5 are in the unfolded state, the second housing 4, the third housing 5, the first support plate 202, the second support plate 203, and the second cover plate 2014 may jointly support the flexible display 6 stably.

In a process in which the second housing 4 and the third housing 5 rotate from the unfolded state to the folded state, the two support plates may drive the flexible display 6 to rotate, thereby effectively preventing deformation of the flexible display 6 and reducing a risk of damage to the flexible display 6. In addition, FIG. 52 is a diagram of a structure of the structure shown in FIG. 51 in the folded state. When the second housing 4 and the third housing 5 are in the folded state, the flexible display 6 may be attached to the two support plates, which helps improve light and shadow of the flexible display.

In addition, in this application, track slots of the two support plates can be properly designed to form accommodation space between the two support plates and the second cover plate 2014 that is sufficient to accommodate a bent part of the flexible display 6 when the second housing 4 and the third housing 5 are in the folded state. This can avoid a gap in the electronic device at the second hinge mechanism 2, thereby ensuring that the electronic device maintains a relatively complete shape in the folded state. In this way, damage to the flexible display 6 caused by a foreign matter inserted into the electronic device from the second hinge mechanism 2 can be avoided, and a thinned design of the overall thickness of the electronic device is implemented.

In addition, refer to FIG. 28 and FIG. 48. In this application, the hinge mechanism may further include an end cover 205, and the end cover 205 may be disposed on a side that is of the second base 206 and that is away from the flexible display 6. In a possible embodiment of this application, the end cover 205 and the second base 206 may be of an integrally formed structure to improve structural reliability of the hinge mechanism and simplify the structure of the hinge mechanism. In some other possible embodiments of this application, the end cover 205 may be independently disposed from the second base 206, and the end cover 205 may be fastened to the second base 206. The connection manner may be, but is not limited to, bonding, a threaded connection, or the like. In this way, the end cover 205 may be used as an appearance part of the hinge mechanism, and may protect another structure of the hinge mechanism, and help improve aesthetic appeal of the hinge mechanism, so that aesthetic appeal of the entire electronic device is improved.

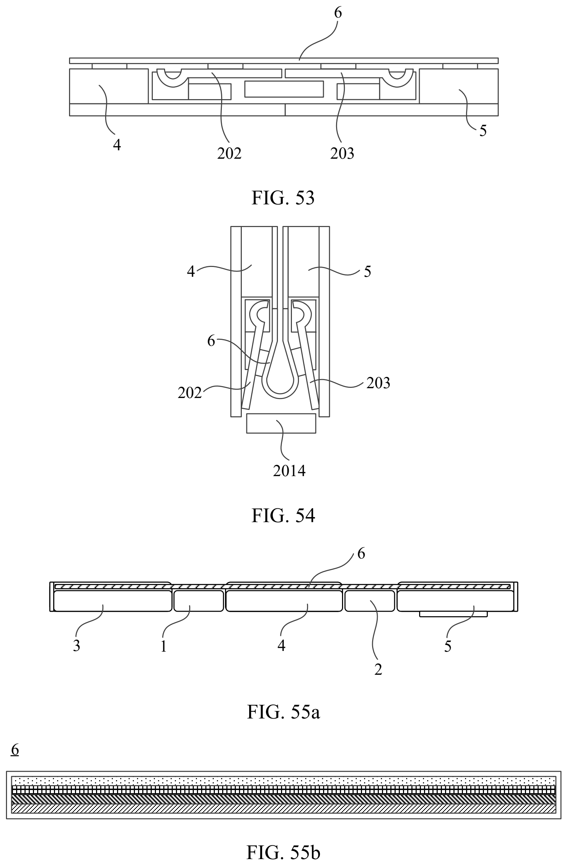

The foregoing describes in detail some possible design manners of the second hinge mechanism 2 of the electronic device provided in embodiments of this application. Based on the design principle of the second hinge mechanism 2, some adaptive deformations may be made to a specific structure of the second hinge mechanism 2 based on an actual application. For example, FIG. 53 is a diagram of another connection relationship among the second housing 4, the third housing 5, and the second hinge mechanism 2 of the electronic device in the unfolded state according to an embodiment of this application. In the unfolded state shown in FIG. 53, the first support plate 202 and the second support plate 203 of the second hinge mechanism 2 can support the flexible display 6 flatly, so that integrity of a form of the electronic device in the unfolded state can be ensured, and light and shadow of the flexible display 6 can be improved.

In addition, FIG. 54 is a diagram of a structure of the structure shown in FIG. 53 in the folded state. When the second housing 4 and the third housing 5 are in the folded state, the flexible display 6 may be attached to the two support plates, which helps improve light and shadow of the flexible display. In addition, in this application, track slots of the two support plates can be properly designed to form accommodation space between the two support plates and the second cover plate 2014 that is sufficient to accommodate a bent part of the flexible display 6 when the second housing 4 and the third housing 5 are in the folded state. This can avoid a gap in the electronic device at the second hinge mechanism 2, thereby ensuring that the electronic device maintains a relatively complete shape in the folded state. In this way, damage to the flexible display 6 caused by a foreign matter inserted into the electronic device from the second hinge mechanism 2 can be avoided, and a thinned design of the overall thickness of the electronic device is implemented.

It should be understood that, to implement the foregoing form of the electronic device, in this application, how the second hinge mechanism 2 is designed is not limited to that mentioned in the foregoing embodiment, provided that the second hinge mechanism 2 can implement the following states. Details are as follows.

When the second housing 4 and the third housing 5 are in the unfolded state, the support surface 2a of the second hinge mechanism, the support surface 4a of the second housing, and the support surface 5a of the third housing may jointly support the flexible display 6 flatly. In a process in which the second housing 4 and the third housing 5 rotate from the unfolded state to the folded state, the second housing 4 and the third housing 5 may rotate toward each other, to drive the flexible display 6 to bend. In a process in which the second housing 4 and the third housing 5 rotate from the folded state to the unfolded state, the second housing 4 and the third housing 5 may rotate away from each other, to drive the flexible display 6 to unfold.

It may be understood that, to implement functions such as display and touch control of the flexible display 6, the flexible display 6 usually includes a plurality of stacking layers, and the stacking layers are connected to each other through bonding or the like, and then encapsulated into an integer by using an encapsulation layer. Because the first housing and the third housing of the electronic device may drive corresponding parts of the flexible display to move when rotating relative to the second housing, a bending form of the flexible display is usually different when the electronic device is in different folded states. When the flexible display is in a bent state, different bending radii of the stacking layers of the flexible display lead to a specific misalignment between the stacking layers. A folding manner of the electronic device and a folded state of the electronic device have great impact on an amount of misalignment between stacking layers of the flexible display.

The following analyzes states of the stacking layers of the flexible display 6 when the electronic device is in different folded states.

FIG. 55a is another cross-sectional view of the electronic device shown in FIG. 1 at A-A. In this case, the electronic device is in the unfolded state, and the first housing 3, the first hinge mechanism 1, the second housing 4, the second hinge mechanism 2, and the third housing 5 jointly form a flat support surface, to support the flexible display 6 flatly.

In addition, FIG. 55b is a diagram of a stacking layer structure of the flexible display 6 of the electronic device shown in FIG. 55a. In the unfolded state, amount of misalignment between the stacking layers of the flexible display 6 is zero, and a risk of failure of the flexible display due to stacking layer misalignment is low.

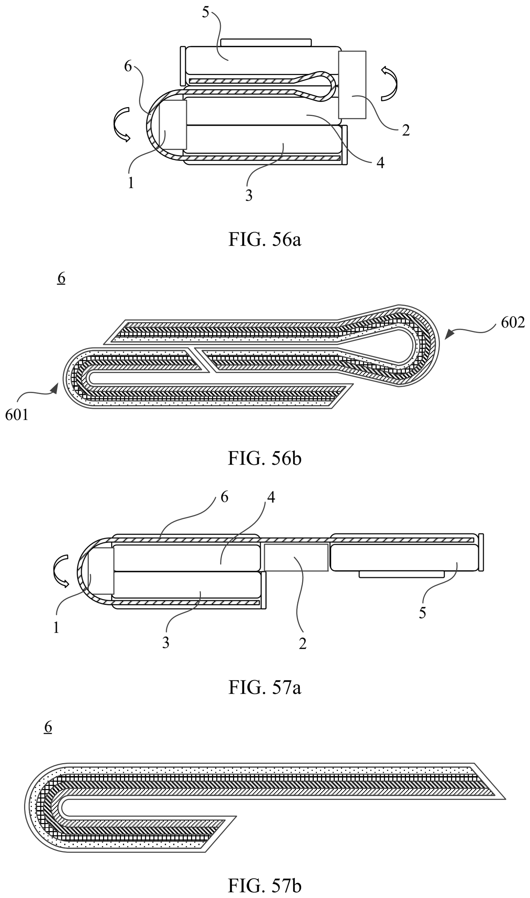

FIG. 56a is a cross-sectional view of the electronic device shown in FIG. 3 at F-F. In this case, the electronic device is in the folded state, a part that is of the flexible display 6 and that corresponds to the first housing 3 is located on a folding outer side of the electronic device, and a part that is of the flexible display 6 and that corresponds to the second housing 4 and the third housing 5 is located on a folding inner side of the electronic device. It can be learned from FIG. 56a that in the folded state, the first hinge mechanism 1 can reliably support a bent part of the flexible display 6, and the second hinge mechanism 2 can accommodate another bent part of the flexible display 6. In this case, a bending form of the flexible display 6 is similar to an "S" shape.

In addition, FIG. 56b is a diagram of a stacking layer structure of the flexible display 6 of the electronic device shown in FIG. 56a. In FIG. 56b, to facilitate description of a stacking layer state of the flexible display, the flexible display 6 is divided into two parts. A first part 601 shows misalignment between the stacking layers of the flexible display 6 under action of the first housing 3 and the second housing 4, and a second part 602 shows misalignment between the stacking layers of the flexible display 6 under action of the second housing 4 and the third housing 5.

It can be learned from FIG. 56b that, when the electronic device is in the folded state, a misalignment trend of the stacking layers of the flexible display 6 under the action of the first housing 3 and the second housing 4 is consistent with a misalignment trend of the stacking layers of the flexible display 6 under the action of the second housing 4 and the third housing 5. This helps balance an amount of misalignment between the stacking layers of the flexible display 6, thereby reducing a risk of failure of the flexible display 6 due to stacking layer misalignment.

FIG. 57a is a cross-sectional view of the electronic device shown in FIG. 4 at G-G. In this state, the flexible display 6 is completely exposed outside the electronic device, but a part that is of the flexible display 6 and that is disposed corresponding to the first housing 3 is opposite to a part that is of the flexible display 6 and that is disposed corresponding to the second housing 4 and the third housing 5. In this state, deformation of the flexible display 6 is mainly affected by the first housing 3 and the second housing 4 that are in the folded state.

FIG. 57b is a diagram of a stacking layer structure of the flexible display 6 of the electronic device shown in FIG. 57a. In this state, misalignment trends between stacking layers at all parts of the flexible display 6 are consistent, and a risk of failure of the flexible display 6 due to stacking layer misalignment is low.

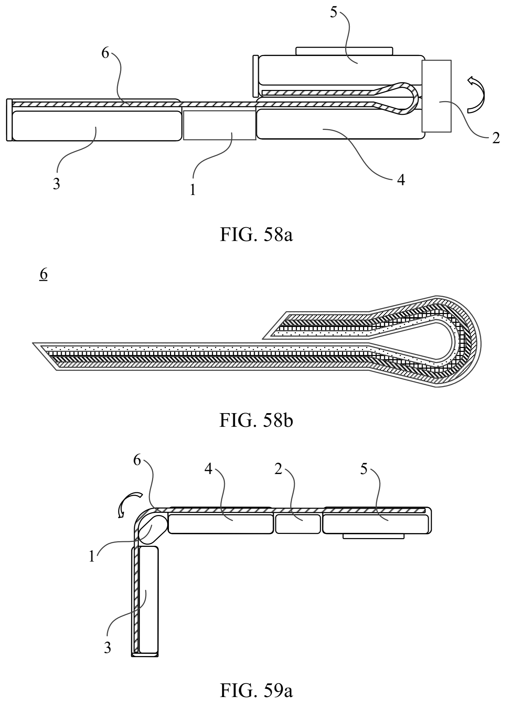

FIG. 58a is a cross-sectional view of the electronic device shown in FIG. 5 at I-I. In this state, a part that is of the flexible display 6 and that is disposed corresponding to the first housing 3 is exposed outside the electronic device, and a part that is of the flexible display 6 and that is disposed corresponding to the second housing 4 and the third housing 5 is hidden on a folding inner side of the electronic device. In this state, deformation of the flexible display 6 is mainly affected by the second housing 4 and the third housing 5 that are in the folded state.

FIG. 58b is a diagram of a stacking layer structure of the flexible display 6 of the electronic device shown in FIG. 58a. In this state, misalignment trends between stacking layers at all parts of the flexible display 6 are consistent, and a risk of failure of the flexible display 6 due to stacking layer misalignment is low.

FIG. 59a is a cross-sectional view of the electronic device shown in FIG. 6 at J-J. In the state shown in FIG. 59a, the first housing 3 and the second housing 4 are in the unfolded state, and the third housing 5 is in the intermediate state relative to the second housing 4. In this state, deformation of the flexible display 6 is also mainly affected by the second housing 4 and the third housing 5.

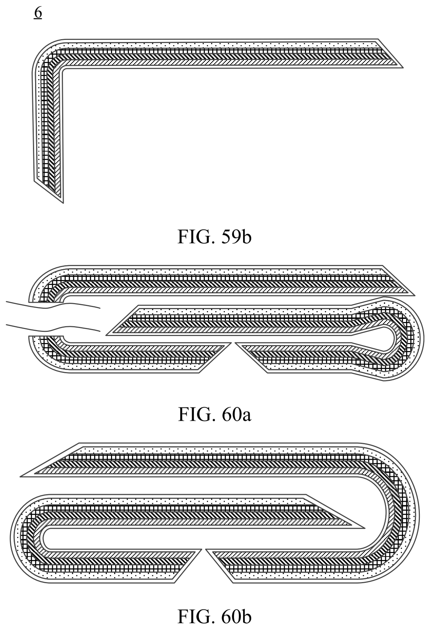

FIG. 59b is a diagram of a stacking layer structure of the flexible display 6 of the electronic device shown in FIG. 59a. In this state, misalignment trends between stacking layers at all parts of the flexible display 6 are consistent, and a risk of failure of the flexible display due to stacking layer misalignment is low.

It can be understood from the foregoing analysis of a misalignment state between the stacking layers of the flexible display 6 of the electronic device in different folded states provided in this application that when the electronic device is in a fully folded state, an amount of misalignment between the stacking layers of the flexible display 6 is the greatest. However, when the electronic device is in the folded state, the flexible display 6 is bent in an "S" shape. This helps balance an amount of misalignment between the stacking layers of the flexible display 6 at positions, thereby reducing a risk of failure of the flexible display 6 due to stacking layer misalignment.

However, in some existing electronic devices, when the electronic device is in the folded state, the first housing and the third housing are folded on a same side of the second housing, and the third housing is located between the first housing and the second housing. This folding manner may be considered as "G"-shaped folding. In this case, the flexible display is also bent in a "G" shape. For the stacking layer structure of the flexible display, refer to FIG. 60a. It can be learned from FIG. 60a that a stacking layer misalignment trend of a part that is of the flexible display and that is deformed under influence of the first housing and the second housing is opposite to a stacking layer misalignment trend of a part that is of the flexible display and that is deformed under influence of the second housing and the third housing. This causes a stacking layer that is of the flexible display and that is close to a folding outer side to be excessively stretched, and a stacking layer of that is the flexible display and that is close to a folding inner side to be wrinkled due to redundancy. This easily causes damage to the flexible display due to an excessively large amount of misalignment between stacking layers.

In addition, in some existing electronic devices, when the electronic device is in the folded state, the flexible display of the electronic device may further be in a bent state shown in FIG. 60b. In this case, the first housing 3 and the third housing 5 of the electronic device are also folded on a same side of the second housing 4. However, the first housing 3 is located between the second housing 4 and the third housing 5. The flexible display also has a same problem as the flexible display shown in FIG. 60a. Details are not described herein again.

In conclusion, in the electronic device provided in embodiments of this application, movement tracks of rotating modules that are in the first hinge mechanism and the second hinge mechanism and that are configured to implement a rotation function are properly designed, to avoid squeezing or pulling the flexible display in a folding process of the electronic device. This can improve structural reliability of the flexible display, prolong a service life of the flexible display, and further improve structural reliability of the entire electronic device.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An electronic device, comprising a first housing, a second housing, a third housing, a first hinge mechanism, and a second hinge mechanism, wherein the first housing is rotatably connected to the second housing through the first hinge mechanism, and the second housing is rotatably connected to the third housing through the second hinge mechanism, wherein
the first hinge mechanism comprises a first housing fastening bracket, a second housing fastening bracket, a main shaft, and a first rotating module, the first housing fastening bracket and the second housing fastening bracket are respectively disposed on two opposite sides of the main shaft, the first housing fastening bracket is fastened to the first housing, and the second housing fastening bracket is fastened to the second housing; and the first rotating module comprises a first rotating assembly and a second rotating assembly, the first rotating assembly is located between the first housing fastening bracket and the second housing fastening bracket, and the second rotating assembly is located between the first housing fastening bracket and the second housing fastening bracket;
the first rotating assembly comprises a first swing arm, a first support arm, and a first connector, the first swing arm is rotatably connected to the main shaft, the first swing arm is slidably connected to the first housing fastening bracket, the first support arm is rotatably connected to the second housing fastening bracket, the first connector is located between the first swing arm and the first support arm, the first connector is rotatably connected to the first swing arm, and the first connector is rotatably connected to the first support arm; and the main shaft is provided with a first track slot, and the first connector is movable along the first track slot, to limit a movement track of the first connector; and
the second rotating assembly comprises a second swing arm, a second support arm, and a second connector, the second swing arm is rotatably connected to the main shaft, the second swing arm is slidably connected to the second housing fastening bracket, the second support arm is rotatably connected to the first housing fastening bracket, the second connector is located between the second swing arm and the second support arm, the second connector is rotatably connected to the second swing arm, and the second connector is rotatably connected to the second support arm; and the main shaft is provided with a second track slot, and the second connector is movable along the second track slot, to limit a movement track of the second connector.

2. The electronic device according to claim 1, wherein the main shaft comprises a first base and a first cover plate, the first base is provided with a first arc-shaped groove and a third arc-shaped groove, the first cover plate covers the first base, and the first cover plate comprises a first protrusion facing the first arc-shaped groove and a third protrusion facing the third arc-shaped groove;
a gap between a surface of the first protrusion and a groove surface of the first arc-shaped groove serves as the first track slot, the first connector comprises a first arc-shaped surface and a second arc-shaped surface, and when the first housing and the second housing are in an unfolded state and a folded state, the first arc-shaped surface abuts against the surface of the first protrusion, and the second arc-shaped surface abuts against the groove surface of the first arc-shaped groove; and
a gap between a surface of the third protrusion and a groove surface of the third arc-shaped groove serves as the second track slot, the second connector comprises a third arc-shaped surface and a fourth arc-shaped surface, and when the first housing and the second housing are in the unfolded state and the folded state, the third arc-shaped surface abuts against the surface of the third protrusion, and the fourth arc-shaped surface abuts against the groove surface of the third arc-shaped groove.

3. The electronic device according to claim 2, wherein during transition of the first housing and the second housing from the unfolded state to the folded state, the first arc-shaped surface abuts against the surface of the first protrusion, and there is a gap between the second arc-shaped surface and the groove surface of the first arc-shaped groove; and during transition of the first housing and the second housing from the folded state to the unfolded state, the second arc-shaped surface abuts against the groove surface of the first arc-shaped groove, and there is a gap between the first arc-shaped surface and the surface of the first protrusion; and
during the transition of the first housing and the second housing from the unfolded state to the folded state, the third arc-shaped surface abuts against the surface of the third protrusion, and there is a gap between the fourth arc-shaped surface and the groove surface of the third arc-shaped groove; and during the transition of the first housing and the second housing from the folded state to the unfolded state, the fourth arc-shaped surface abuts against the groove surface of the third arc-shaped groove, and there is a gap between the third arc-shaped surface and the surface of the third protrusion.

4. The electronic device according to claim 2, wherein the surface of the first protrusion is equidistant from the groove surface of the first arc-shaped groove, and during the transition of the first housing and the second housing from the unfolded state to the folded state and during the transition of the first housing and the second housing from the folded state to the unfolded state, the first arc-shaped surface abuts against the surface of the first protrusion, and the second arc-shaped surface abuts against the groove surface of the first arc-shaped groove; and the surface of the third protrusion is equidistant from the groove surface of the third arc-shaped groove, and during the transition of the first housing and the second housing from the unfolded state to the folded state and during the transition of the first housing and the second housing from the folded state to the unfolded state, the third arc-shaped surface abuts against the surface of the third protrusion, and the fourth arc-shaped surface abuts against the groove surface of the third arc-shaped groove.

5. The electronic device according to claim 2, wherein the first arc-shaped surface is a circular arc-shaped surface, the second arc-shaped surface is a circular arc-shaped surface, and a sum of a radius of the first arc-shaped surface and a radius of the second arc-shaped surface is equal to a spacing between the surface of the first protrusion and the groove surface of the first arc-shaped groove; and
the third arc-shaped surface is a circular arc-shaped surface, the fourth arc-shaped surface is a circular arc-shaped surface, and a sum of a radius of the third arc-shaped surface and a radius of the fourth arc-shaped surface is equal to a spacing between the surface of the third protrusion and the groove surface of the third arc-shaped groove.

6. The electronic device according to any one of claims 1 to 5, wherein the main shaft comprises the first base, the first base is provided with a second arc-shaped groove and a fourth arc-shaped groove, the first swing arm comprises a first arc-shaped rotating block, the first arc-shaped rotating block is accommodated in the second arc-shaped groove, and the first arc-shaped rotating block is slidable along a groove surface of the second arc-shaped groove, to implement a rotational connection between the first swing arm and the main shaft; and
the second swing arm comprises a second arc-shaped rotating block, the second arc-shaped rotating block is accommodated in the fourth arc-shaped groove, and the second arc-shaped rotating block is slidable along a groove surface of the fourth arc-shaped groove, to implement a rotational connection between the second swing arm and the main shaft.

7. The electronic device according to claim 6, wherein the main shaft further comprises a first cover plate, the first cover plate covers the first base, the first cover plate comprises a second protrusion facing the second arc-shaped groove, and at least a part of the first arc-shaped rotating block is located between the second protrusion and the second arc-shaped groove; and
the first cover plate further comprises a fourth protrusion facing the fourth arc-shaped groove, and at least a part of the second arc-shaped rotating block is located between the fourth protrusion and the fourth arc-shaped groove.

8. The electronic device according to claim 6 or 7, wherein the first connector comprises a first rotating shaft and a second rotating shaft, the first connector is rotatably connected to the first swing arm through the first rotating shaft, the first connector is rotatably connected to the first support arm through the second rotating shaft, and an axis of the first rotating shaft is parallel to and does not coincide with an axis of the second rotating shaft; and
the second connector comprises a third rotating shaft and a fourth rotating shaft, the second connector is rotatably connected to the second swing arm through the third rotating shaft, the second connector is rotatably connected to the second support arm through the fourth rotating shaft, and an axis of the third rotating shaft is parallel to and does not coincide with an axis of the fourth rotating shaft.

9. The electronic device according to claim 8, wherein the first arc-shaped rotating block is provided with a first mounting slot, a slot opening of the first mounting slot is provided facing the second arc-shaped groove, the first rotating shaft is mounted in the first mounting slot, a part of a surface of the first rotating shaft is in contact with a slot surface of the first mounting slot, and a part of the surface of the first rotating shaft is in contact with the groove surface of the second arc-shaped groove; and
the second arc-shaped rotating block is provided with a second mounting slot, a slot opening of the second mounting slot is provided facing the fourth arc-shaped groove, the third rotating shaft is mounted in the second mounting slot, a part of a surface of the third rotating shaft is in contact with a slot surface of the second mounting slot, and a part of the surface of the third rotating shaft is in contact with the groove surface of the fourth arc-shaped groove.

10. The electronic device according to claim 9, wherein the slot surface of the first mounting slot comprises a first circular arc-shaped surface, the surface that is of the first rotating shaft and that is in contact with the slot surface of the first mounting slot is a second circular arc-shaped surface, and a circle center of the first circular arc-shaped surface coincides with a circle center of the second circular arc-shaped surface; and
the slot surface of the second mounting slot comprises a fifth circular arc-shaped surface, the surface that is of the third rotating shaft and that is in contact with the slot surface of the second mounting slot is a sixth circular arc-shaped surface, and a circle center of the fifth circular arc-shaped surface coincides with a circle center of the sixth circular arc-shaped surface.

11. The electronic device according to claim 10, wherein the groove surface of the second arc-shaped groove is a third circular arc-shaped surface, the surface that is of the first rotating shaft and that is in contact with the groove surface of the second arc-shaped groove is a fourth circular arc-shaped surface, and a circle center of the third circular arc-shaped surface coincides with a circle center of the fourth circular arc-shaped surface; and
the groove surface of the fourth arc-shaped groove is a seventh circular arc-shaped surface, the surface that is of the third rotating shaft and that is in contact with the groove surface of the fourth arc-shaped groove is an eighth circular arc-shaped surface, and a circle center of the seventh circular arc-shaped surface coincides with a circle center of the eighth circular arc-shaped surface.

12. The electronic device according to any one of claims 1 to 11, wherein the first connector comprises a plurality of first sub-connectors that are sequentially rotatably connected to each other, the plurality of first sub-connectors are located between the first swing arm and the first support arm, the first swing arm is rotatably connected to an adjacent first sub-connector, and the first support arm is rotatably connected to an adjacent first sub-connector; and
the second connector comprises a plurality of second sub-connectors that are sequentially rotatably connected to each other, the plurality of second sub-connectors are located between the second swing arm and the second support arm, the second swing arm is rotatably connected to an adjacent second sub-connector, and the second support arm is rotatably connected to an adjacent second sub-connector.

13. The electronic device according to any one of claims 1 to 12, wherein the first hinge mechanism further comprises a first synchronization assembly, the first synchronization assembly comprises a first gear connecting rod and a second gear connecting rod, the first gear connecting rod comprises a first gear and a first connecting rod, the first gear is rotatably connected to the main shaft, and the first connecting rod is slidably connected to the first housing fastening bracket; and
the second gear connecting rod comprises a second gear and a second connecting rod, the second gear is rotatably connected to the main shaft, the second connecting rod is slidably connected to the second housing fastening bracket, and the first gear is in a transmission connection to the second gear.

14. The electronic device according to claim 13, wherein the first gear is rotatably connected to the main shaft through a fifth rotating shaft, and the second gear is rotatably connected to the main shaft through a sixth rotating shaft.

15. The electronic device according to claim 13 or 14, wherein the first housing fastening bracket is provided with a third sliding slot, and the first connecting rod is mounted in the third sliding slot, and is slidable in the third sliding slot relative to the first housing fastening bracket in a direction toward or away from the main shaft; and
the second housing fastening bracket is provided with a fourth sliding slot, and the second connecting rod is mounted in the fourth sliding slot, and is slidable in the fourth sliding slot relative to the second housing fastening bracket in the direction toward or away from the main shaft.

16. The electronic device according to any one of claims 1 to 15, wherein the second hinge mechanism comprises a second base and a second rotating module, the second rotating module comprises a third rotating assembly and a fourth rotating assembly, the third rotating assembly and the fourth rotating assembly are located on two opposite sides of the second base, and the third rotating assembly comprises a third support arm, a third swing arm, and a third housing fastening bracket; and the fourth rotating assembly comprises a fourth support arm, a fourth swing arm, and a fourth housing fastening bracket;
the third support arm and the fourth support arm are rotatably connected to the second base separately, and the third swing arm and the fourth swing arm are rotatably connected to the second base separately; and a rotation axis of the third support arm is parallel to and does not coincide with a rotation axis of the third swing arm, and a rotation axis of the fourth support arm is parallel to and does not coincide with a rotation axis of the fourth swing arm;
the third housing fastening bracket is fastened to the second housing, the third housing fastening bracket is provided with a fifth sliding slot extending in a first direction and a sixth sliding slot extending in a second direction, the third support arm is slidable in the fifth sliding slot, and the third swing arm is slidable in the sixth sliding slot; and a projection of the first direction in a first cross section is not parallel to a projection of the second direction in the first cross section, wherein the first cross section is a reference plane perpendicular to the rotation axis of the third support arm and the rotation axis of the third swing arm; and
the fourth housing fastening bracket is fastened to the third housing, the fourth housing fastening bracket is provided with a seventh sliding slot extending in a third direction and an eighth sliding slot extending in a fourth direction, the fourth support arm is slidable in the seventh sliding slot, and the fourth swing arm is slidable in the eighth sliding slot; and a projection of the third direction in a second cross section is not parallel to a projection of the fourth direction in the second cross section, wherein the second cross section is a reference plane perpendicular to the rotation axis of the fourth support arm and the rotation axis of the fourth swing arm.

17. The electronic device according to claim 16, wherein angles by which the third support arm and the third swing arm rotate relative to the second base are not greater than 90°; and angles by which the fourth support arm and the fourth swing arm rotate relative to the second base are not greater than 90°.

18. The electronic device according to claim 16 or 17, wherein the second base is provided with a fifth arc-shaped groove and a sixth arc-shaped groove, a third arc-shaped rotating block is disposed at an end that is of the third swing arm and that is configured to rotatably connect to the second base, and the third arc-shaped rotating block is accommodated in the fifth arc-shaped groove, and is rotatable along an arc-shaped surface of the fifth arc-shaped groove; and
a fourth arc-shaped rotating block is disposed at an end that is of the fourth swing arm and that is configured to rotatably connect to the second base, and the fourth arc-shaped rotating block is accommodated in the sixth arc-shaped groove, and is rotatable along an arc-shaped surface of the sixth arc-shaped groove.

19. The electronic device according to any one of claims 16 to 18, wherein a second sliding rail is disposed on the sixth sliding slot, a second sliding block is disposed on the third swing arm, the second sliding block is clamped in the second sliding rail, and the second sliding block is slidable along the second sliding rail; and
a fourth sliding rail is disposed on the eighth sliding slot, a fourth sliding block is disposed on the fourth swing arm, the fourth sliding block is clamped in the fourth sliding rail, and the fourth sliding block is slidable along the fourth sliding rail.

20. The electronic device according to claim 19, wherein the third housing fastening bracket comprises a first surface, the first surface is a surface of a side that is of the third housing fastening bracket and that faces a flexible display of the electronic device; the second sliding block is a straight-line sliding block, and the second sliding rail is a straight-line sliding rail; and the second sliding rail has an opening located on the first surface, and when the second housing and the third housing are in the unfolded state, the second sliding rail extends from the opening in a direction toward the second base; and
the fourth housing fastening bracket comprises a third surface, the third surface is a surface that is of the fourth housing fastening bracket and that faces the flexible display of the electronic device; the fourth sliding block is a straight-line sliding block, and the fourth sliding rail is a straight-line sliding rail; and the fourth sliding rail has an opening located on the third surface, and when the second housing and the third housing are in the unfolded state, the fourth sliding rail extends from the opening in the direction toward the second base.

21. The electronic device according to claim 19, wherein the second sliding rail is an arc-shaped sliding rail; the fourth sliding rail is an arc-shaped sliding rail; and when the second housing and the third housing are in the unfolded state, an axis center of the arc-shaped sliding rail is located on a side that is of the arc-shaped sliding rail and that is away from the base.

22. The electronic device according to any one of claims 16 to 21, wherein the second rotating module further comprises a first drive connecting rod and a second drive connecting rod, the first drive connecting rod is located between the third support arm and the third swing arm; the first drive connecting rod comprises a first connecting part and a second connecting part, the first connecting part is rotatably connected to the third support arm through a third connecting rod, and the second connecting part is rotatably connected to the third swing arm through a fourth connecting rod; and an axis of the third connecting rod does not coincide with an axis of the fourth connecting rod; and
the second drive connecting rod is located between the fourth support arm and the fourth swing arm, the second drive connecting rod comprises a third connecting part and a fourth connecting part, the third connecting part is rotatably connected to the fourth support arm through a fifth connecting rod, and the fourth connecting part is rotatably connected to the fourth swing arm through a sixth connecting rod; and an axis of the fifth connecting rod does not coincide with an axis of the sixth connecting rod.

23. The electronic device according to any one of claims 16 to 21, wherein the second rotating module further comprises a first drive connecting rod and a second drive connecting rod, the first drive connecting rod is located between the third support arm and the third swing arm, the first drive connecting rod comprises a first connecting part and a second connecting part, the first connecting part is slidably connected to the third swing arm through a third connecting rod, and the second connecting part is fastened to the third support arm; and
the second drive connecting rod is located between the fourth support arm and the fourth swing arm, the second drive connecting rod comprises a third connecting part and a fourth connecting part, the third connecting part is slidably connected to the fourth swing arm through a fifth connecting rod, and the fourth connecting part is fastened to the fourth support arm.

24. The electronic device according to claim 23, wherein a first guide slot is provided on an end part that is of the third swing arm and that faces the third support arm, and the third connecting rod is inserted into the first guide slot and is slidable along a slot surface of the first guide slot; and
a second guide slot is provided on an end part that is of the fourth swing arm and that faces the fourth support arm, and the fifth connecting rod is inserted into the second guide slot and is slidable along a slot surface of the second guide slot.

25. The electronic device according to any one of claims 16 to 24, wherein the second hinge mechanism further comprises a first support plate and a second support plate, and the first support plate and the second support plate are respectively disposed on two sides of the second base; the first support plate is rotatably connected to the third housing fastening bracket, and the first support plate is slidably connected to the third support arm and/or the third swing arm; and the second support plate is rotatably connected to the fourth housing fastening bracket, and the second support plate is slidably connected to the fourth support arm and/or the fourth swing arm; and
when the third housing fastening bracket and the fourth housing fastening bracket rotate toward each other, an end that is of the first support plate and that is close to the second base moves in a direction away from the second base, and an end that is of the second support plate and that is close to the second base moves in the direction away from the second base.

26. The electronic device according to claim 25, wherein the third housing fastening bracket is provided with a first rotating slot, the first support plate is provided with a first rotating part, the first rotating part is mounted in the first rotating slot, and the first rotating part is rotatable along a slot surface of the first rotating slot; and
the fourth housing fastening bracket is provided with a second rotating slot, the second support plate is provided with a second rotating part, the second rotating part is mounted in the second rotating slot, and the second rotating part is rotatable along a slot surface of the second rotating slot.

27. The electronic device according to claim 25 or 26, wherein a first guide part is disposed on the first support plate, and the first guide part has a third track slot; a first guide structure is disposed on the third swing arm, the first guide structure is inserted into the third track slot and is slidable along the third track slot, and/or a first guide structure is disposed on the third support arm, and the first guide structure is inserted into the third track slot and is slidable along the third track slot; and
a second guide part is disposed on the second support plate, and the second guide part has a fourth track slot; a second guide structure is disposed on the fourth swing arm, and the second guide structure is inserted into the fourth track slot and is slidable along the fourth track slot, and/or a second guide structure is disposed on the fourth support arm, and the second guide structure is inserted into the fourth track slot and is slidable along the fourth track slot.

28. The electronic device according to any one of claims 1 to 27, wherein the electronic device further comprises the flexible display, the flexible display continuously covers the first housing, the first hinge mechanism, the second housing, the second hinge mechanism, and the third housing, and the flexible display is fastened to the first housing, the second housing, and the third housing.

29. The electronic device according to claim 28, wherein an axis center of rotation of the first swing arm around the main shaft is located on a side that is of the main shaft and that is away from the flexible display; and an axis center of rotation of the second swing arm around the main shaft is located on the side that is of the main shaft and that is away from the flexible display.
